# EUROPEAN PATENT APPLICATION

(11) **EP 4 822 438 A1**
(43) Date of publication of application: **14.10.2026**
(21) Application number: 24900663.6
(22) Date of filing: 05.12.2024
(51) Int. Cl.: G03F 7/11, C08G 59/14, G03F 7/20

(54) **COMPOSITION FOR FORMING RESIST UNDERLAYER FILM**

(30) Priority: 06.12.2023 JP 2023205881
(71) Applicant: Nissan Chemical Corporation, Tokyo 103-6119 (JP)
(72) Inventor: KATO Yuki, Toyama-shi, Toyama 939-2792 (JP); IGATA Kosuke, Toyama-shi, Toyama 939-2792 (JP); HIROHARA Tomotada, Toyama-shi, Toyama 939-2792 (JP)
(74) Representative: Hoffmann Eitle
(86) International application number: PCT/JP2024/042983
(87) International publication number: WO 2025/121370

(57) **Abstract**

A resist underlayer film-forming composition, containing a polymer (A), a compound (B) having a polymerizable multiple bond, and a solvent (C).

## Description

### Technical Field

The present invention relates to a composition for forming a resist underlayer film, a resist underlayer film, a laminate, a method for producing a semiconductor element, and a pattern forming method.

### Background Art

Conventionally, microfabrication by lithography using a resist composition has been performed in the production of a semiconductor device. The microfabrication is a processing method of forming microrelief corresponding to a photoresist pattern on a substrate surface by forming a thin film of a photoresist composition on a semiconductor substrate such as a silicon wafer, irradiating the thin film with an active ray such as an ultraviolet ray through a mask pattern on which a device pattern is drawn, developing the thin film, and etching the substrate using the obtained photoresist pattern as a protective film. In recent years, the degree of integration of a semiconductor device has been increased, and as an active ray to be used, EUV light (wavelength: 13.5 nm) or an electron beam (EB) has been studied to be put into practical use for the most advanced microfabrication, in addition to an i-line (wavelength: 365 nm), a KrF excimer laser (wavelength: 248 nm), and an ArF excimer laser (wavelength: 193 nm) which have conventionally been used. At the same time, defects in the formation of the resist pattern due to an influence of the semiconductor substrate and the like are a big problem. Therefore, in order to solve this problem, a method of providing a resist underlayer film between a resist and a semiconductor substrate has been widely studied.

As a resist underlayer film-forming composition, a resist underlayer film-forming composition containing a reaction product of a compound (A) represented by Formula (1) (in Formula (1), A represents an organic group containing an aliphatic ring, an aromatic ring or a heterocycle) dissolved in a solvent, a compound (B) having two functional groups reactive with an epoxy group, and a compound (C) having one functional group reactive with an epoxy group has been proposed (refer to Patent Literature 1).

### Citation List

### Patent Literature

Patent Literature 1: WO 2022/075339 A

### Summary of Invention

### Technical Problem

Examples of the characteristics required for a resist underlayer film include that no intermixing with a resist film formed on an upper layer occurs (the resist underlayer film is insoluble in a resist solvent), and that a resist pattern having good quality can be formed by improving sensitivity and adhesion of a resist pattern.

The present invention has been made in view of the above circumstances, and an object of the present invention is to provide a resist underlayer film-forming composition capable of forming a resist pattern having good quality by improving sensitivity and adhesion, and a resist underlayer film, a laminate, a method for producing a semiconductor element, and a pattern forming method, each using the resist underlayer film-forming composition.

### Solution to Problem

As a result of intensive studies to solve the above problem, the present inventors have found that the above problem can be solved and have completed the present invention having the following gist.

That is, the present invention includes the following aspects.
[1] A resist underlayer film-forming composition, containing a polymer (A), a compound (B) having a polymerizable multiple bond, and a solvent (C).
[2] The resist underlayer film-forming composition according to [1], in which the compound (B) is a reaction product of a reactant containing a compound (B-1) having an epoxy group and a compound (B-2) having a polymerizable multiple bond and being reactive with the epoxy group.
[3] The resist underlayer film-forming composition according to [1], in which the compound (B) is a reaction product of a reactant containing a compound (B-3) having a hydroxy group and a compound (B-4) having a polymerizable multiple bond and being reactive with the hydroxy group.
[4] The resist underlayer film-forming composition according to any one of [1] to [3], in which a content of the polymer (A) is greater than a content of the compound (B).
[5] The resist underlayer film-forming composition according to any one of [1] to [4], in which the solvent (C) contains at least one type selected from a group consisting of an alkylene glycol monoalkyl ether and a monocarboxylic acid ester of an alkylene glycol monoalkyl ether.
[6] The resist underlayer film-forming composition according to any one of [1] to [5], further containing a crosslinking agent (D).
[7] The resist underlayer film-forming composition according to [6], in which the crosslinking agent (D) is at least one type selected from a group consisting of an aminoplast crosslinking agent and a phenoplast crosslinking agent.
[8] The resist underlayer film-forming composition according to any one of [1] to [7], further containing a curing catalyst (E).
[9] The resist underlayer film-forming composition according to any one of [1] to [8], which is used in EUV lithography.
[10] The resist underlayer film-forming composition according to any one of [1] to [9], which is used for forming an underlayer film of a metal-containing resist.
[11] A resist underlayer film, which is a cured product of the resist underlayer film-forming composition according to any one of [1] to [10].
[12] A laminate, including:
   a semiconductor substrate; and
   the resist underlayer film according to [11].
[13] A method for producing a semiconductor element, the method including:
   a step of forming a resist underlayer film on a semiconductor substrate using the resist underlayer film-forming composition according to any one of [1] to [10]; and
   a step of forming a resist film on the resist underlayer film.
[14] A pattern forming method, including:
   a step of forming a resist underlayer film on a semiconductor substrate using the resist underlayer film-forming composition according to any one of [1] to [10];
   a step of forming a resist film on the resist underlayer film;
   a step of irradiating the resist film with light or an electron beam, and then developing the resist film to obtain a resist pattern; and
   a step of etching the resist underlayer film using the resist pattern as a mask.

### Advantageous Effects of Invention

According to the present invention, it is possible to provide a resist underlayer film-forming composition capable of forming a resist pattern having good quality by improving sensitivity and adhesion, and a resist underlayer film, a laminate, a method for producing a semiconductor element, and a pattern forming method, each using the resist underlayer film-forming composition.

### Description of Embodiments

### (Resist Underlayer Film-Forming Composition)

A resist underlayer film-forming composition of the present invention contains a polymer (A), a compound (B), and a solvent (C).

The resist underlayer film-forming composition may contain a crosslinking agent (D), a curing catalyst (E), and the like.

The compound (B) has a polymerizable multiple bond.

The polymer (A) is, for example, different from the compound (B).

By further adding the compound (B) having a polymerizable multiple bond to the resist underlayer film-forming composition containing the polymer (A) and the solvent (C), a good resist pattern with improved sensitivity and adhesion can be formed on the resist underlayer film formed from the resist underlayer film-forming composition.

### <Polymer (A)>

The polymer (A) is not particularly limited.

Examples of the polymer (A) include polymers used in the resist underlayer film-forming composition.

Examples of the polymer (A), which are polymers (A1) to (A12), will be described below.

### <<Polymer (A1)>>

The polymer (A1) is a polymer having a ring structure in which at least one type is a heterocyclic ring in the main chain. As such a polymer, a polymer (Y) having a repeating unit represented by the following Formula (Y) is preferable.

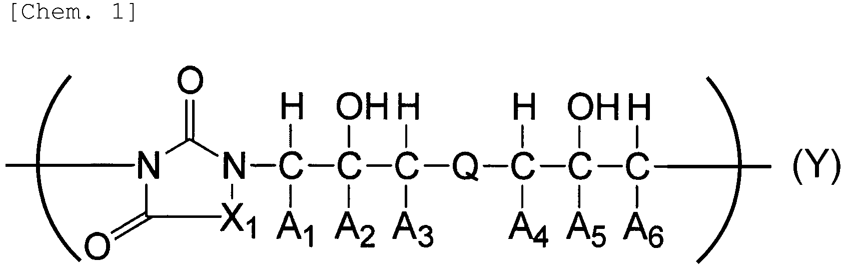

(In Formula (Y), A₁, A₂, A₃, A₄, A₅, and A₆ each represent a hydrogen atom, a methyl group, or an ethyl group.

X₁ represents the following Formula (Y2), (Y3), (Y4), or (Y0).

Q represents the following Formula (Y5) or (Y6).)

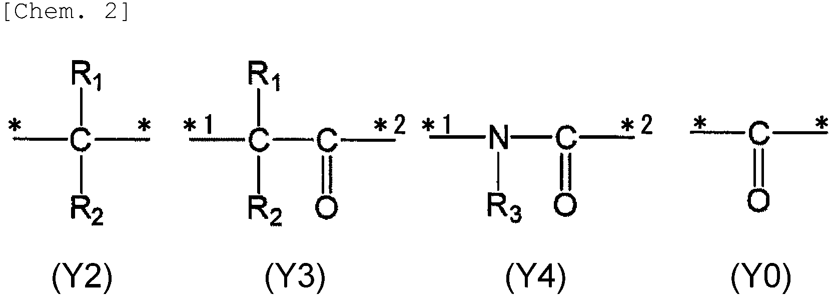

(In Formulae (Y2), (Y3), (Y4), and (Y0), R₁ and R₂ each represent a hydrogen atom, a halogen atom, an alkyl group having 1 to 6 carbon atoms, an alkenyl group having 3 to 6 carbon atoms, a benzyl group, or a phenyl group, and the alkyl group having 1 to 6 carbon atoms, the alkenyl group having 3 to 6 carbon atoms, the benzyl group, and the phenyl group are optionally substituted with a group selected from the group consisting of an alkyl group having 1 to 6 carbon atoms, a halogen atom, an alkoxy group having 1 to 6 carbon atoms, a nitro group, a cyano group, a hydroxy group, a carboxy group, and an alkylthio group having 1 to 6 carbon atoms. R₁ and R₂ may be bonded to each other to form a ring having 3 to 6 carbon atoms.

R₃ represents a halogen atom, an alkyl group having 1 to 6 carbon atoms, an alkenyl group having 3 to 6 carbon atoms, a benzyl group, or a phenyl group, and the phenyl group is optionally substituted with a group selected from the group consisting of an alkyl group having 1 to 6 carbon atoms, a halogen atom, an alkoxy group having 1 to 6 carbon atoms, a nitro group, a cyano group, a hydroxy group, and an alkylthio group having 1 to 6 carbon atoms.

* represents a bond. *1 represents a bond bonded to a carbon atom. *2 represents a bond bonded to a nitrogen atom.)

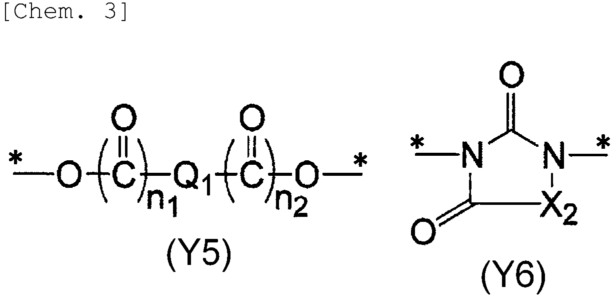

(In Formulae (Y5) and (Y6), Q₁ represents an alkylene group having 1 to 10 carbon atoms, a phenylene group, a naphthylene group, or an anthrylene group, and each of the alkylene group, the phenylene group, the naphthylene group, and the anthrylene group is optionally substituted with an alkyl group having 1 to 6 carbon atoms, a carbonyloxyalkyl group having 2 to 7 carbon atoms, a halogen atom, an alkoxy group having 1 to 6 carbon atoms, a phenyl group, a nitro group, a cyano group, a hydroxy group, an alkylthio group having 1 to 6 carbon atoms, a group having a disulfide group, a carboxy group, or groups of a combination thereof.

n₁ and n₂ each represent 0 or 1.

X₂ represents Formula (Y2), (Y3), (Y4), or (Y0) described above.

* represents a bond.)

Examples of the repeating unit represented by Formula (Y) include repeating units represented by the following Formulae (Y-1) to (Y-20).

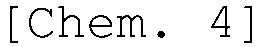

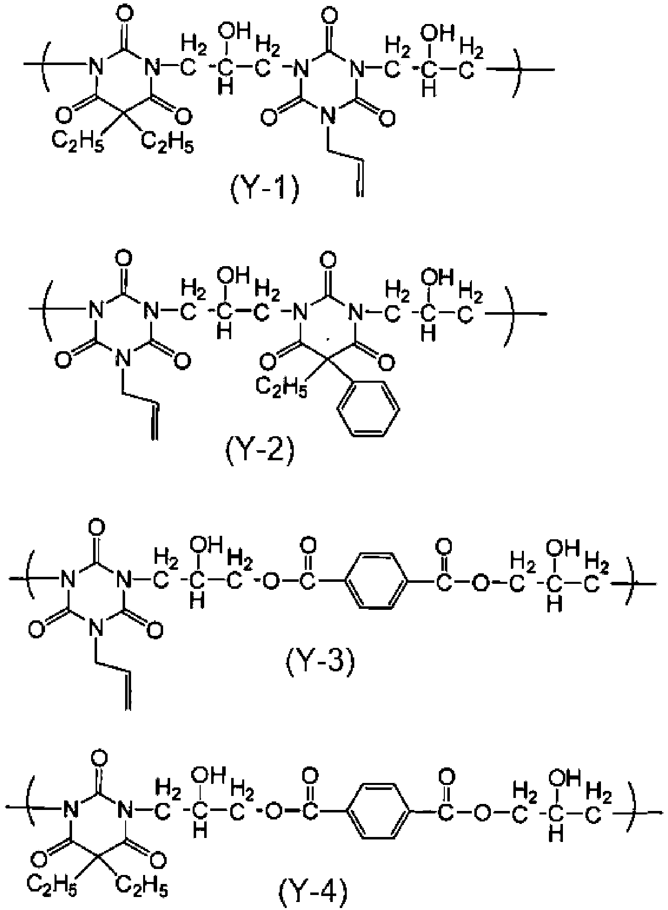

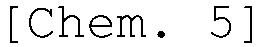

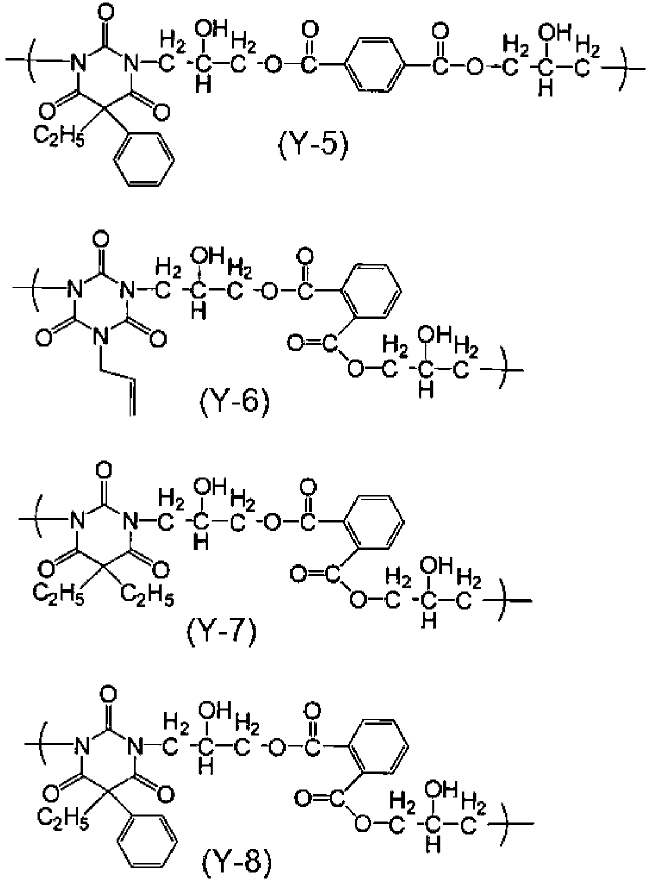

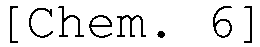

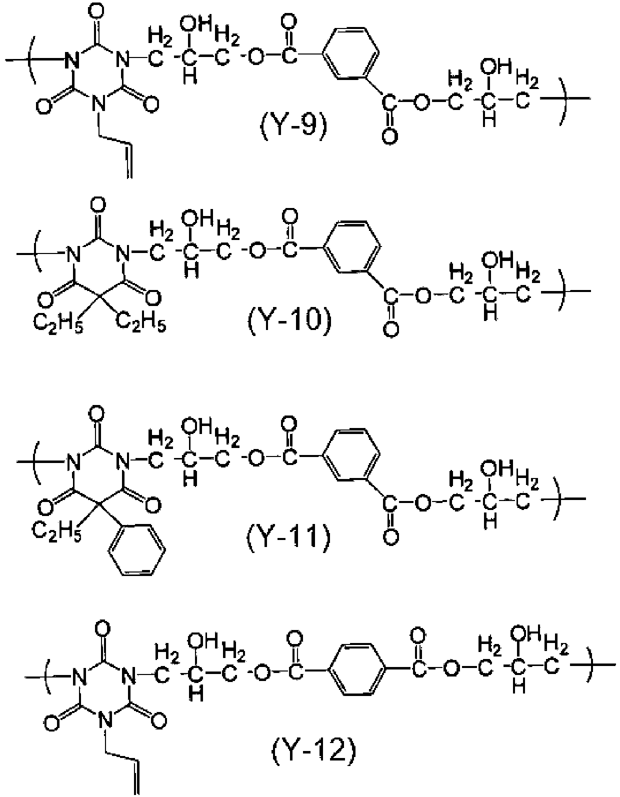

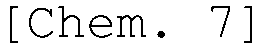

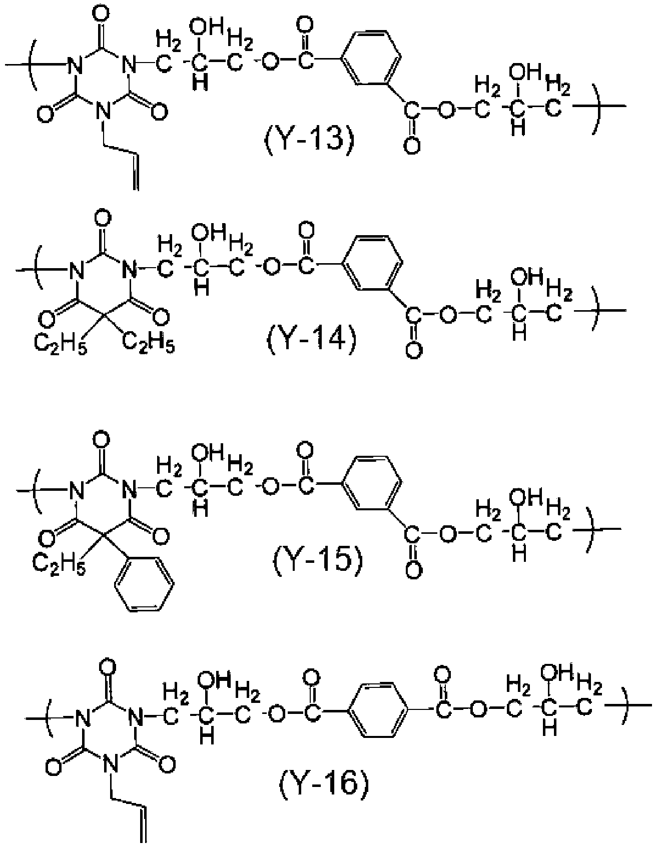

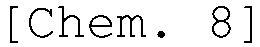

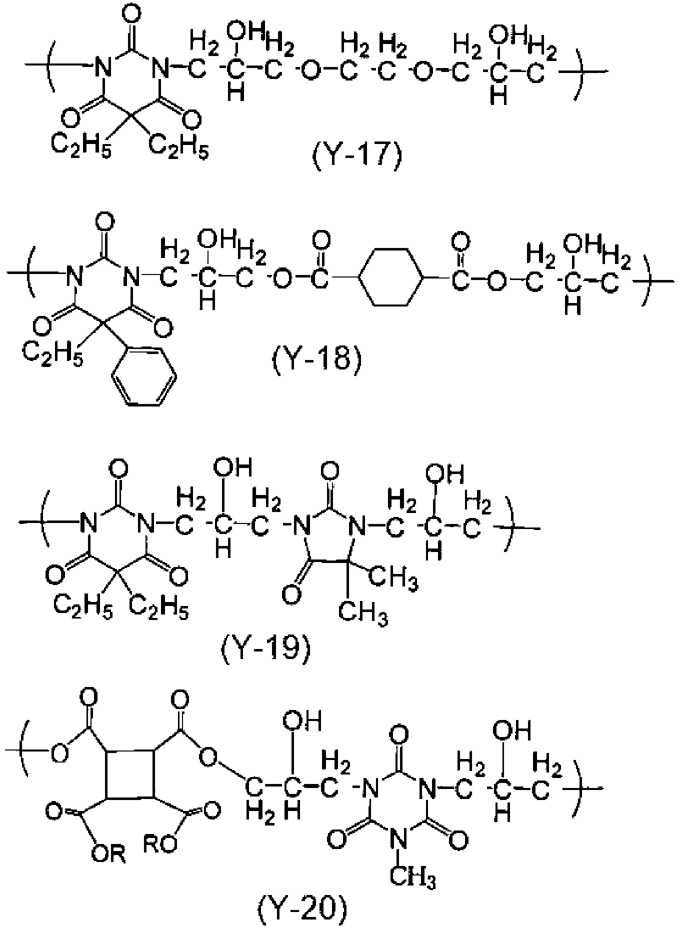

In Formula (Y-20), R is an alcohol residue (an organic group other than a hydroxy group of an alcohol), and R represents an alkyl group, an ether group, or a combination thereof. Examples of R include an alkyl group and an alkoxyalkyl group.

Examples of the polymer (Y) include polymers described in WO 2013/018802 A. The entire contents of International Publication No. WO 2013/018802 A are incorporated herein by reference to the same extent as if fully set forth herein.

The polymer (Y) is preferably produced by a reaction between a compound represented by the following Formula (Y7) and a compound represented by the following Formula (Y8).

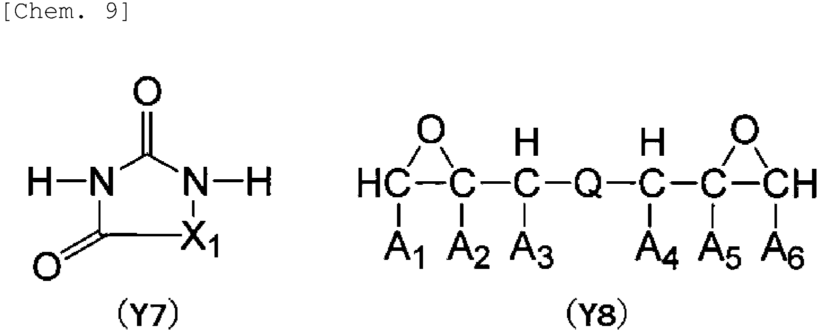

(In Formula (Y7), X¹ represents Formula (Y2), (Y3), (Y4), or (Y0) described above.

In Formula (8), Q represents Formula (Y5) or (Y6) described above.

A₁, A₂, A₃, A₄, A₅, and A₆ each represent a hydrogen atom, a methyl group, or an ethyl group.)

The reaction between the compound represented by Formula (Y7) and the compound represented by Formula (Y8) is preferably performed in a solution state where the compound is dissolved in an organic solvent such as benzene, toluene, xylene, ethyl lactate, butyl lactate, propylene glycol monomethyl ether, propylene glycol monomethyl ether acetate, or N-methylpyrrolidone. In this reaction, it is also possible to use a quaternary ammonium salt such as benzyltriethylammonium chloride, tetrabutylammonium chloride, or tetraethylammonium bromide as a catalyst. The reaction temperature and reaction time of the present reaction are not limited, and may be changed according to the compound, concentration, and the like to be used. The reaction time may be 0.1 to 100 hours, and the reaction temperature may be appropriately selected from the range of 20°C to 200°C. When the catalyst is used, it can be used in a range of 0.001 to 30 mass% relative to the total mass of the compound to be used.

The ratio of the compounds represented by Formulae (Y7) and (Y8) used in the reaction may be any ratio. The ratio of both compounds is preferably such that a molar ratio of [a compound represented by Formula (Y7):a compound represented by Formula (Y8)] is from 3:1 to 1:3, and more preferably from 3:2 to 2:3.

The weight-average molecular weight of the polymer (A1) is not particularly limited, but is preferably 1,000 to 30,000, more preferably 2,000 to 20,000, and particularly preferably 3,000 to 15,000.

### <<Polymer (A2)>>

The polymer (A2) is a polymer formed by polymerizing a polymerizable unsaturated bond of a compound having a group having a polymerizable unsaturated bond. The polymer (A2) may be a homopolymer or a copolymer.

Examples of the group having a polymerizable unsaturated bond include a (meth)acryloyl group, a vinylaryl group (for example, a styryl group), a vinyloxy group, and an allyl group.

The polymer (A2) contains, for example, at least one of a structural unit represented by the following Formula (Z2), a structural unit represented by the following Formula (Z3), and a structural unit represented by the following Formula (Z4).

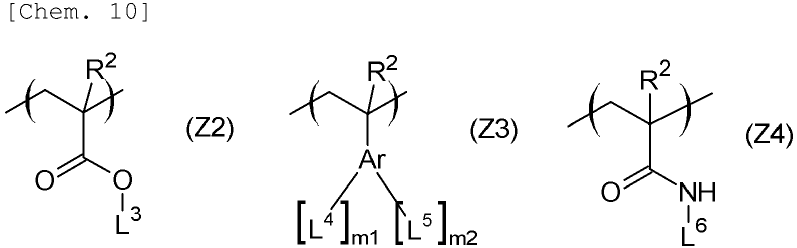

(In Formula (Z2), R² represents a hydrogen atom or an alkyl group having 1 to 10 carbon atoms, and L³ represents a monovalent group having 1 to 20 carbon atoms.

In Formula (Z3), R² represents a hydrogen atom or an alkyl group having 1 to 10 carbon atoms, Ar represents a benzene ring or a naphthalene ring, and L⁴ represents a hydroxy group, a cyano group, a nitro group, or an amino group (-NH₂). L5 represents a halogen atom, an alkyl group having 1 to 6 carbon atoms, or an alkoxy group having 1 to 6 carbon atoms. m1 represents an integer of 0 to 3. m2 represents an integer of 0 to 5. Here, the sum of m1 and m2 is 0 to 5. When m1 is 2 or 3, a plurality of L⁴'s may be identical to or different from each other. When m2 is 2 to 5, a plurality of L⁵'s may be identical to or different from each other.

In Formula (Z4), R² represents a hydrogen atom or an alkyl group having 1 to 10 carbon atoms, L⁶ represents a monovalent organic group selected from an alkyl group having 1 to 10 carbon atoms and an aryl group having 6 to 40 carbon atoms, and at least one hydrogen atom of the alkyl group and the aryl group is optionally substituted with a hydroxy group or an alkoxy group having 1 to 6 carbon atoms.

The monovalent group having 1 to 20 carbon atoms in L³ in Formula (Z2) represents, for example, a monovalent organic group selected from an alkyl group having 1 to 10 carbon atoms and an aryl group having 6 to 40 carbon atoms, and at least one hydrogen atom of the alkyl group and the aryl group is optionally substituted with a hydroxy group. In the alkyl group, an oxygen atom may be inserted between carbon atoms.

Examples of the monovalent group having 1 to 20 carbon atoms in L³ include a group represented by the following Formula (Z2-1).

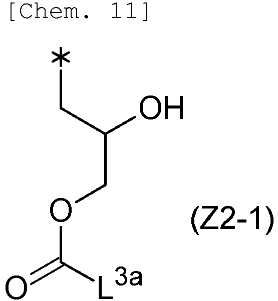

(In Formula (Z2-1), L^{3a} represents an optionally substituted alkyl group having 1 to 6 carbon atoms or an optionally substituted aromatic hydrocarbon group.)

Examples of the aromatic hydrocarbon group in L^{3a} include a phenyl group and a naphthyl group.

Examples of the substituent in the optionally substituted alkyl group having 1 to 6 carbon atoms in L^{3a} include a halogen atom and a hydroxy group. The number of substituents may be 1 or more. When a plurality of substituents are present, the plurality of substituents may be identical to or different from each other.

Examples of the substituent in the optionally substituted aromatic hydrocarbon group in L^{3a} include a halogen atom, a hydroxy group, and an alkyl group having 1 to 3 carbon atoms optionally substituted with a halogen atom. The number of substituents may be 1 or more. When a plurality of substituents are present, the plurality of substituents may be identical to or different from each other.

Specific examples of the alkyl group having 1 to 10 carbon atoms represented by R² and the alkyl group having 1 to 10 carbon atoms represented by L³ and L⁶ are as described above.

Examples of the halogen atom in L⁵ include a fluorine atom, a chlorine atom, a bromine atom, and an iodine atom.

Examples of the alkyl group having 1 to 6 carbon atoms in L⁵ include a methyl group, an ethyl group, an n-propyl group, an i-propyl group, a cyclopropyl group, an n-butyl group, and an i-butyl group.

Examples of the alkoxy group having 1 to 6 carbon atoms in L⁵ include a methoxy group, an ethoxy group, a propoxy group, and a butoxy group.

m1 represents an integer of 0 to 3, and may be 0, 1, 2, or 3.

m2 represents an integer of 0 to 5, and may be 0, 1, 2, 3, 4, or 5.

Examples of the aryl group having 6 to 40 carbon atoms represented by L³ and L⁶ include a phenyl group, an o-methylphenyl group, an m-methylphenyl group, a p-methylphenyl group, an o-chlorophenyl group, a m-chlorophenyl group, a p-chlorophenyl group, an o-fluorophenyl group, a p-fluorophenyl group, an o-methoxyphenyl group, a p-methoxyphenyl group, a p-nitrophenyl group, a p-cyanophenyl group, an α-naphthyl group, a β-naphthyl group, an o-biphenylyl group, a m-biphenylyl group, a p-biphenylyl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

Examples of the alkoxy group having 1 to 6 carbon atoms in L⁶ include a methoxy group, an ethoxy group, a propoxy group, and a butoxy group.

Examples of the monomer used to derive Formula (Z2) include the following compounds.

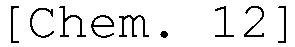

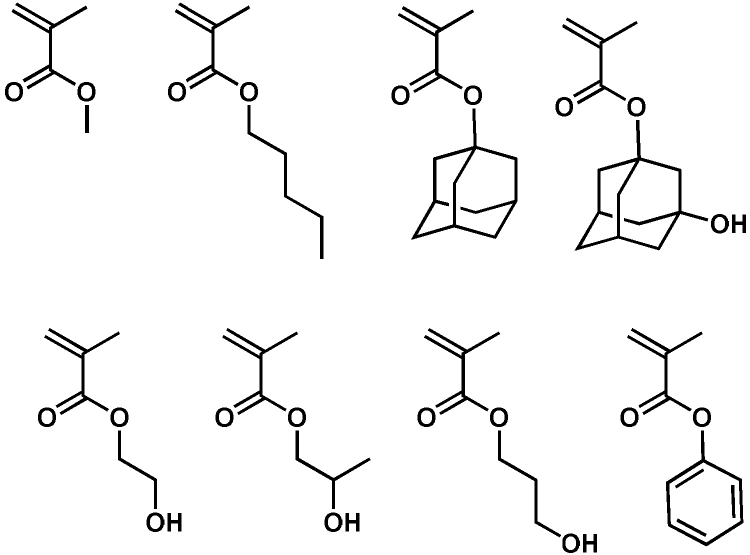

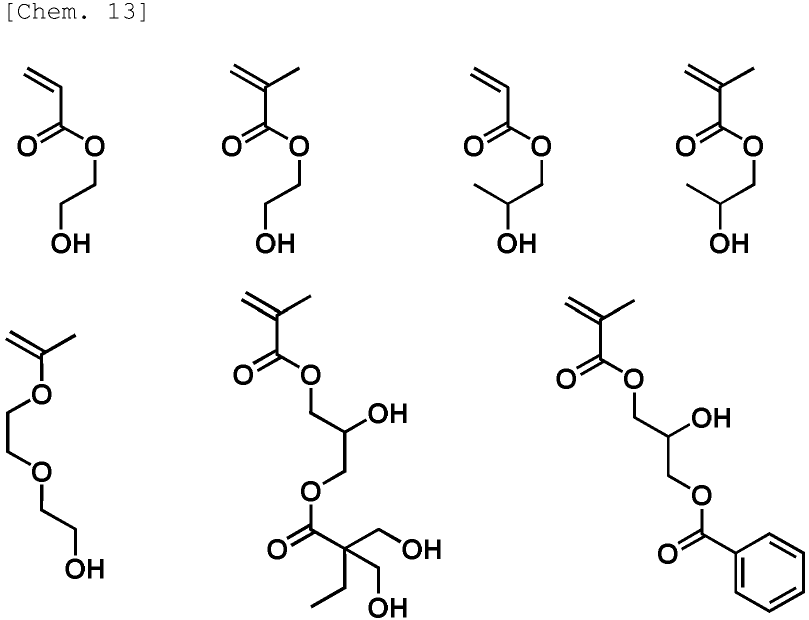

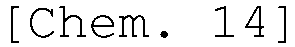

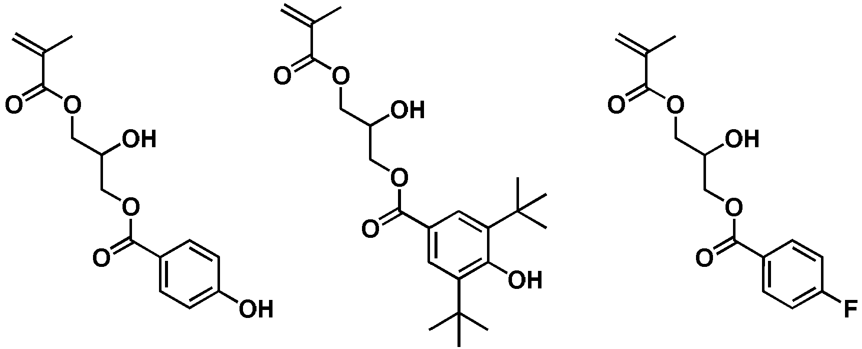

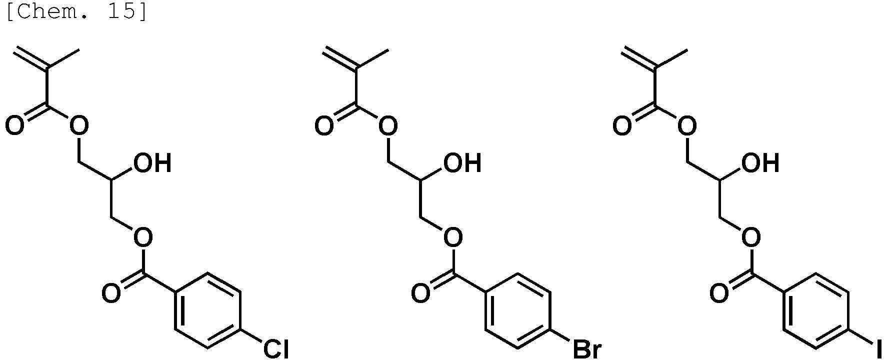

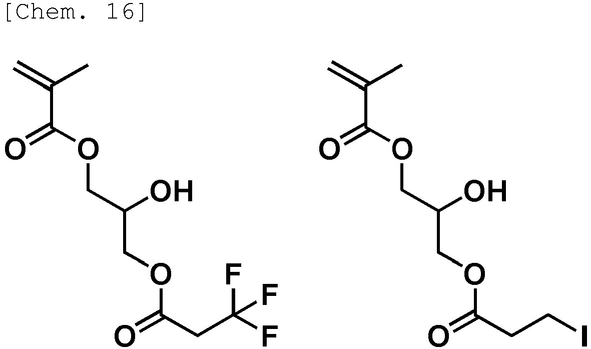

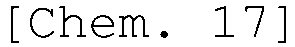

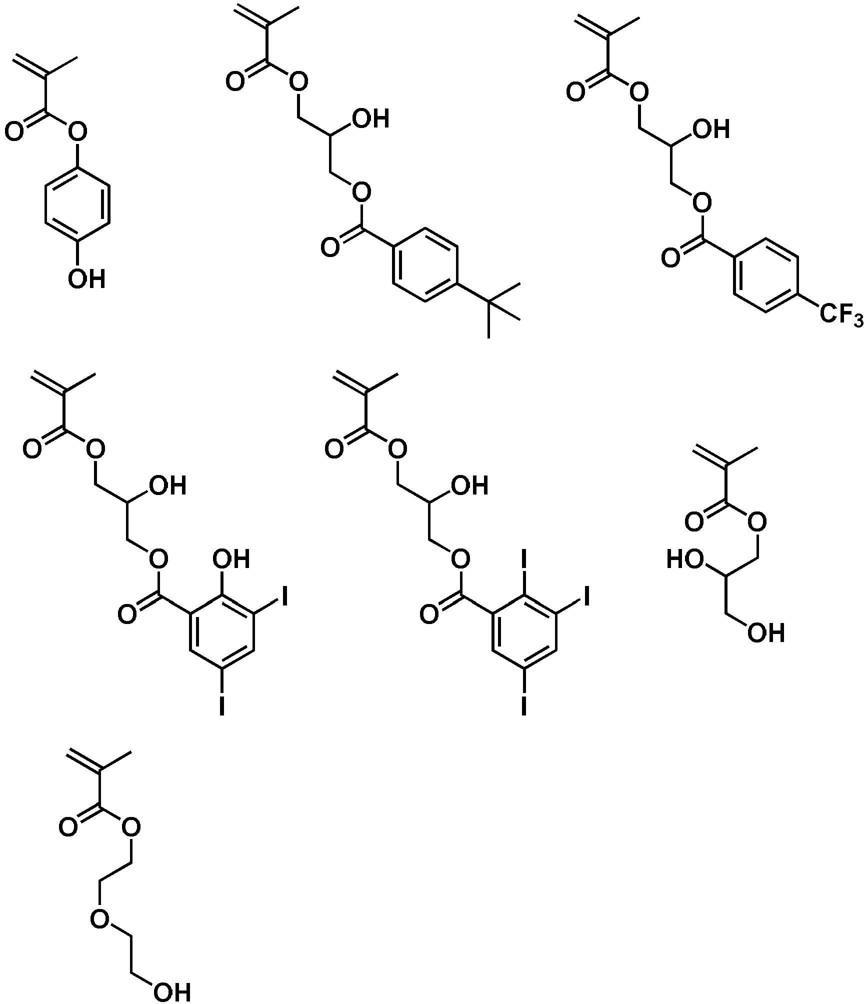

Examples of the monomer used to derive Formula (Z3) include the following compounds.

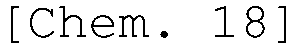

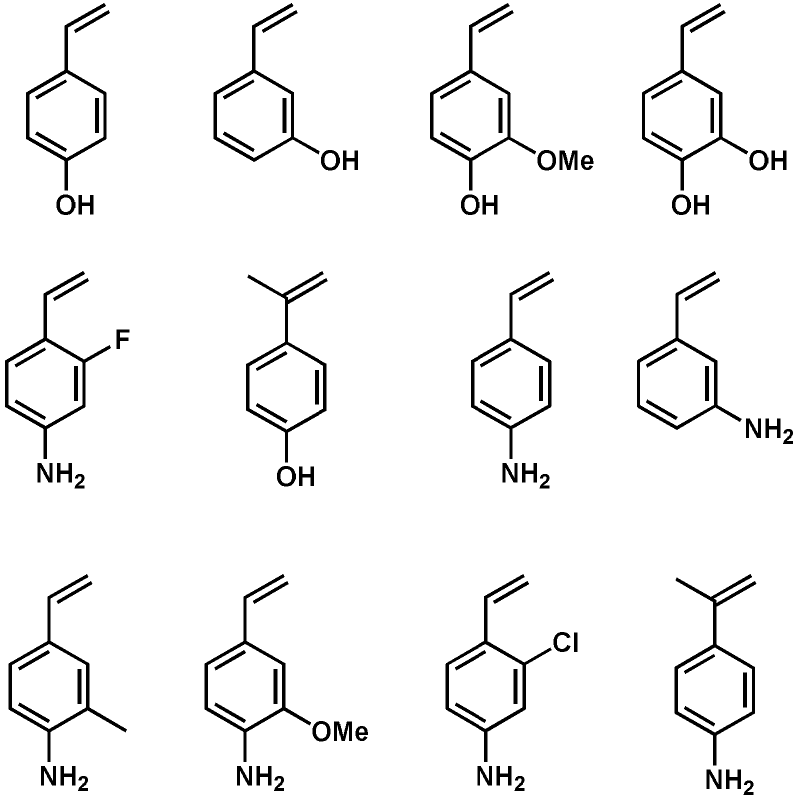

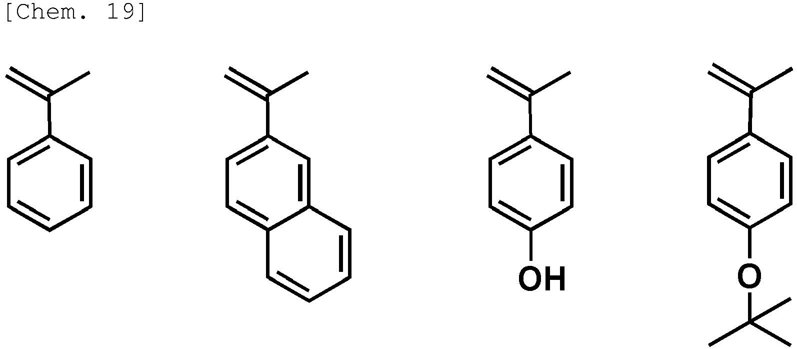

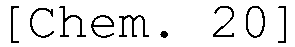

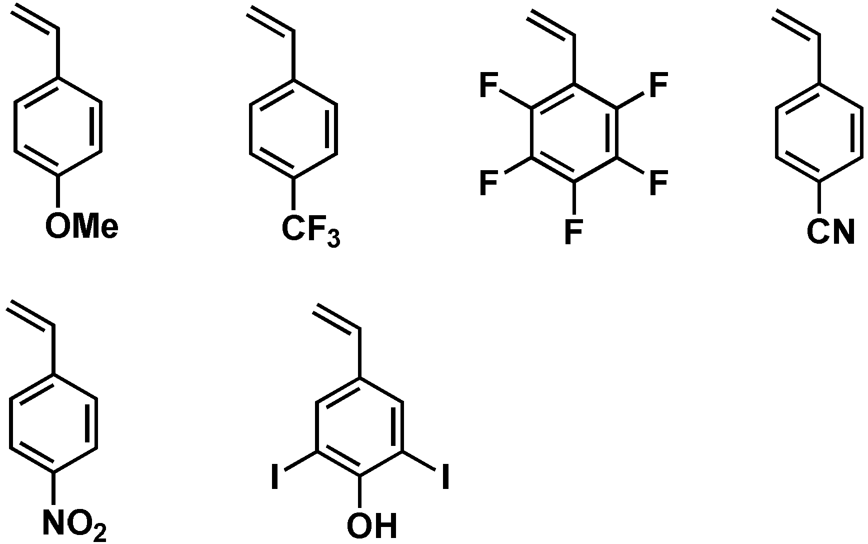

Me represents a methyl group.

Examples of the monomer used to derive Formula (Z4) include the following compounds.

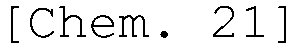

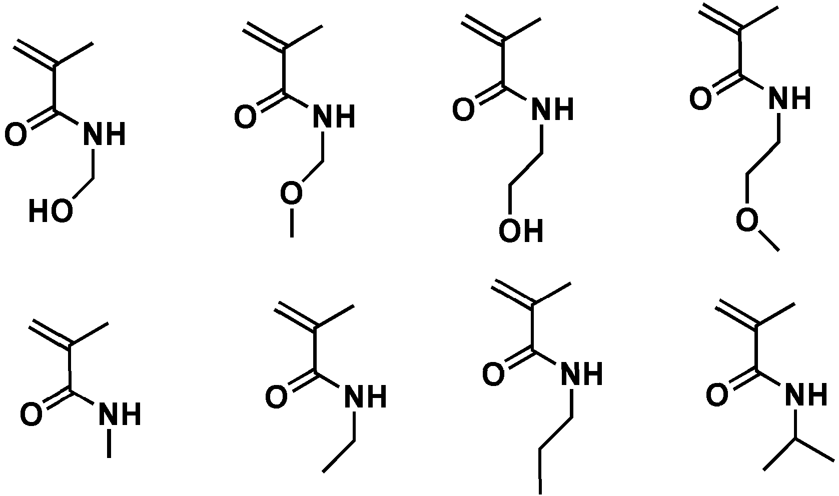

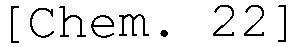

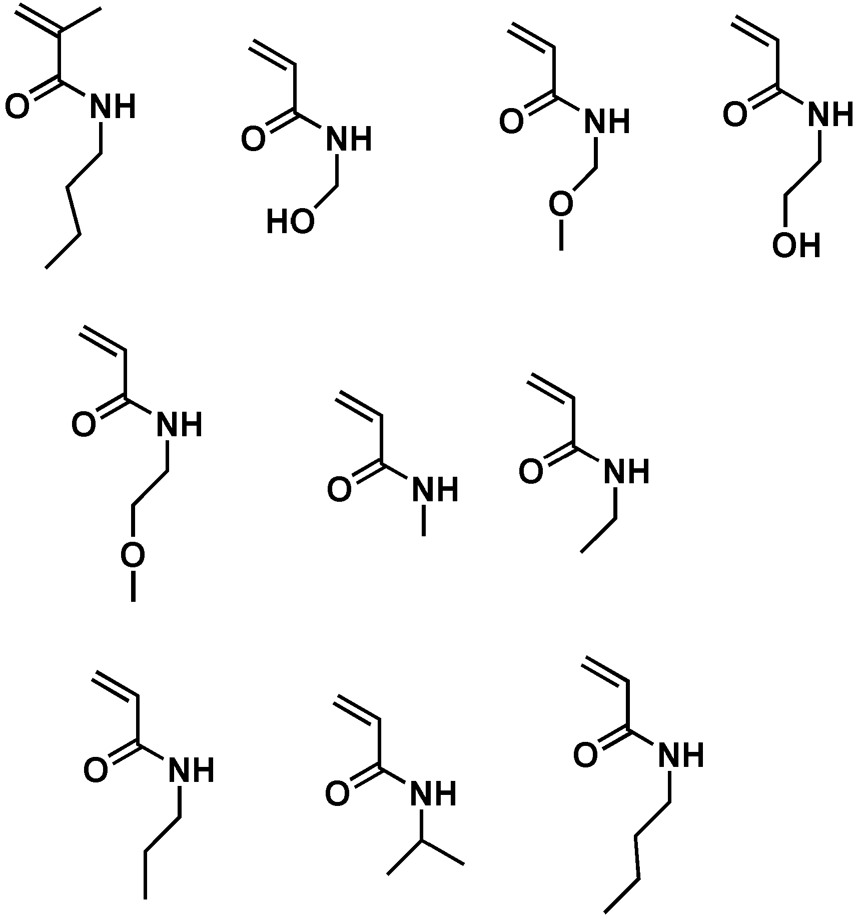

The ratio of the structural unit represented by Formula (Z2) in the polymer (A2) is not particularly limited, but the molar ratio of the structural unit represented by Formula (Z2) may be, for example, 20 mol% to 100 mol%, or 20 mol% or more and less than 100 mol%, relative to all the structural units of the polymer (A2).

The polymer (A2) may have a structural unit other than the structural unit represented by Formula (Z2). In that case, the molar ratio of the other structural unit to all the structural units of the polymer (A2) is, for example, more than 0 mol% and 20 mol% or less.

Examples of the polymer (A2) include polymers described in WO 2015/178235 A. The entire contents of International Publication No. WO 2015/178235 A are incorporated herein by reference to the same extent as if fully set forth herein.

The molecular weight of the polymer (A2) is not particularly limited.

The lower limit of the weight-average molecular weight of the polymer (A2) is, for example, 500, 1,000, 2,000, or 3,000.

The upper limit of the weight-average molecular weight of the polymer (A2) is, for example, 100,000, 50,000, 30,000, 20,000, or 10,000.

### <<Polymer (A3)>>

The polymer (A3) has a polycyclic aromatic hydrocarbon structure in a side chain.

Hereinafter the unit structure (C1) having a polycyclic aromatic hydrocarbon structure in the polymer (A3) will be described.

### <<<Unit Structure (C1)>>>

The unit structure (C1) is a unit structure having a polycyclic aromatic hydrocarbon structure as described above.

The polycyclic aromatic hydrocarbon structure in the unit structure preferably includes at least one structure selected from the group consisting of naphthalene, anthracene, phenanthrene, carbazole, pyrene, triphenylene, chrysene, naphthacene, biphenylene, and fluorene.

In the present specification, the polycyclic aromatic hydrocarbon structure is an aromatic structure having a hydrocarbon composed of two or more aromatic rings exhibiting aromaticity, and includes a fused polycyclic aromatic hydrocarbon structure having a fused ring, and a hydrocarbon ring assembly structure having a plurality of aromatic rings directly bonded via a single bond.

In the present specification, the polycyclic aromatic hydrocarbon structure also includes a heterocyclic structure in which some of carbon atoms of the aromatic ring are substituted with nitrogen.

The fused polycyclic aromatic hydrocarbon structure is not particularly limited, and examples thereof include a naphthalene structure, an anthracene structure, a phenanthrene structure, a carbazole structure, a pyrene structure, a triphenylene structure, a chrysene structure, a naphthacene structure, a biphenylene structure, and a fluorene structure.

The hydrocarbon ring assembly structure is not particularly limited, and examples thereof include a carbazole structure, a biphenyl structure, a terphenyl structure, a quaterphenyl structure, a binaphthalene structure, a phenylnaphthalene structure, a phenylfluorene structure, and a diphenylfluorene structure.

The polycyclic aromatic hydrocarbon structure is optionally substituted with a substituent. The optionally substituted substituent is not particularly limited, and examples thereof include an alkyl group, a hydroxy group, a carboxy group, and a halogen group (for example, a fluorine group, a chlorine group, a bromine group, and an iodine group). Examples of the alkyl group include a methyl group, an ethyl group, an n-propyl group, an i-propyl group, an n-butyl group, an i-butyl group, an s-butyl group, a t-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group. Furthermore, a cyclic alkyl group can also be used as the alkyl group, and examples of a cyclic alkyl group having 1 to 10 carbon atoms include a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

From the viewpoint of suitably obtaining the effect of the present invention, the polycyclic aromatic hydrocarbon structure is preferably a naphthalene structure, an anthracene structure, a phenanthrene structure, a pyrene structure, a triphenylene structure, a chrysene structure, a naphthacene structure, a biphenylene structure, a fluorene structure, or a carbazole structure, more preferably a naphthalene structure, an anthracene structure, a phenanthrene structure, a pyrene structure, or a carbazole structure, and still more preferably a naphthalene structure or a carbazole structure.

The polycyclic aromatic hydrocarbon structure may be one type or two or more types, but is preferably one type or two types.

Specifically, the unit structure (C1) is not particularly limited, but a unit structure represented by the following Formula (C1-1) can be suitably used.

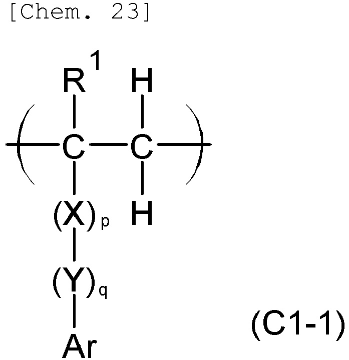

(In Formula (C1-1), R¹ represents a hydrogen atom or a methyl group. X represents an ester group or an amide group. Y represents an alkylene group having 1 to 6 carbon atoms. p and q each independently represent 0 or 1. Ar represents a monovalent group that is obtained by removing a hydrogen atom from naphthalene, anthracene, phenanthrene, pyrene, triphenylene, chrysene, naphthacene, biphenylene, fluorene, or carbazole, which are optionally substituted.)

Further, the unit structure (C1) is not particularly limited, but a unit structure represented by the following Formula (C1-2) can be suitably used.

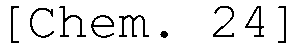

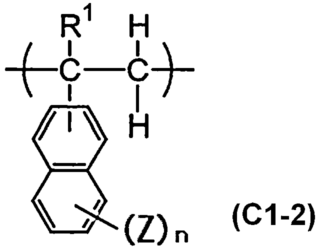

(In Formula (C1-2), R¹ represents a hydrogen atom or a methyl group, Z represents a halogen atom substituted with a naphthalene ring, a hydroxy group, an alkyl group, an alkoxy group, a thiol group, a cyano group, a carboxy group, an amino group, an amide group, an alkoxycarbonyl group, or a thioalkyl group, and n represents an integer of 0 to 7. When n is 2 or more, two or more Z's may be identical to or different from each other.)

In Z, a fluorine atom, a chlorine atom, a bromine atom, or an iodine atom can be used as the halogen atom. The alkyl group is, for example, a linear or branched alkyl group having 1 to 6 carbon atoms, and these groups are optionally substituted with a halogen atom or the like. Examples thereof include a methyl group, an ethyl group, a propyl group, an isopropyl group, a butoxy group, a t-butoxy group, an n-hexyl group, and a chloromethyl group. The alkoxy group is, for example, an alkoxy group having 1 to 6 carbon atoms, and examples thereof include a methoxy group, an ethoxy group, and an isopropoxy group. The amide group is, for example, an amide group having 1 to 12 carbon atoms, and examples thereof include a formamide group, an acetamide group, a propionamide group, an isobutylamide group, a benzamide group, a naphthylamide group, and an acrylamide group. The alkoxycarbonyl group is, for example, an alkoxycarbonyl group having 1 to 12 carbon atoms, and examples thereof include a methoxycarbonyl group, an ethoxycarbonyl group, and a benzyloxycarbonyl group. The thioalkyl group is, for example, a thioalkyl group having 1 to 6 carbon atoms, and examples thereof include a methylthio group, an ethylthio group, a butylthio group, and a hexylthio group.

Specific examples of the unit structure (C1) represented by Formula (C1-2) include the following.

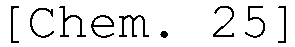

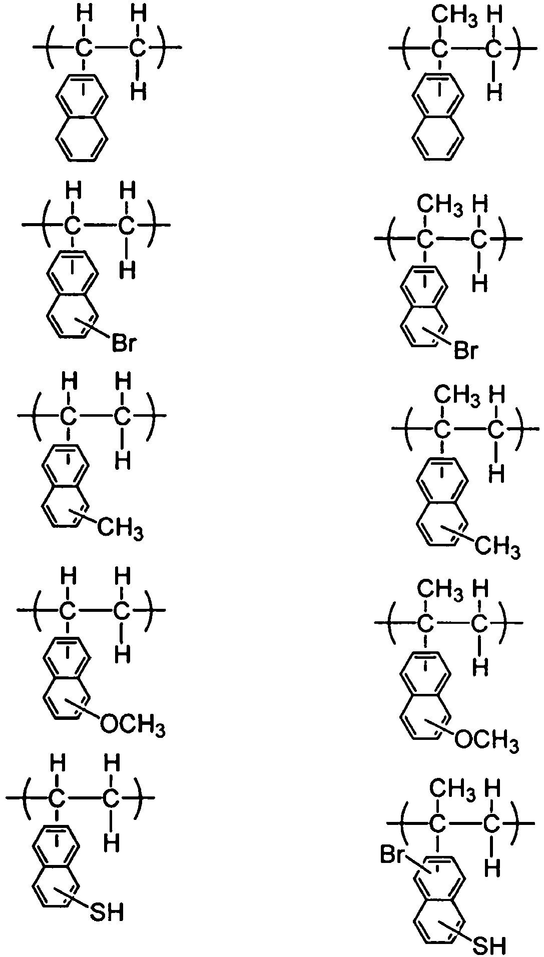

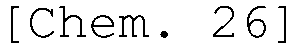

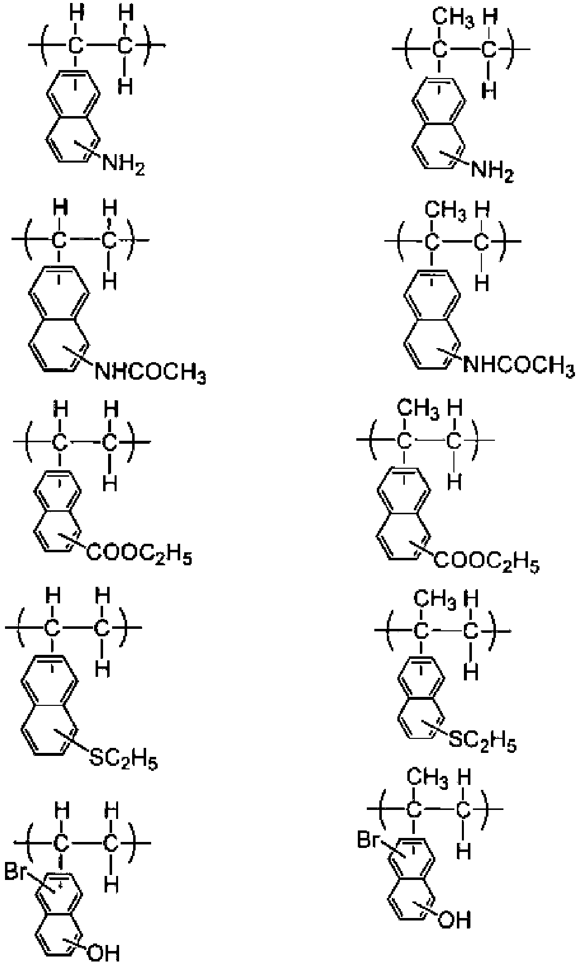

Furthermore, the unit structure (C1) is not particularly limited, but a unit structure represented by the following Formula (C1-3) can be suitably used.

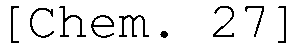

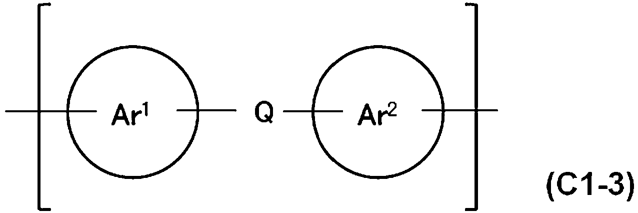

(In Formula (C1-3), Ar¹ and Ar² each independently represent an optionally substituted aromatic ring having 6 to 40 carbon atoms, at least one of Ar¹ and Ar² is naphthalene, anthracene, phenanthrene, or pyrene, and Q represents a single bond or a divalent linking group.)

Examples of the aromatic ring having 6 to 40 carbon atoms include benzene, naphthalene, anthracene, acenaphthene, fluorene, triphenylene, phenalene, phenanthrene, indene, indane, indacene, pyrene, chrysene, perylene, naphthacene, pentacene, coronene, heptacene, benzo[a]anthracene, dibenzophenanthrene, and dibenzo[a,j]anthracene.

Examples of the divalent linking group in Q include an ether group, an ester group, and an imino group, and an imino group is preferable.

The unit structure (C1) may be one type or two or more types, but is preferably one type or two types.

When the polymer contains the unit structure (C1), from the viewpoint of suitably obtaining the effect of the present invention, the molar ratio of the unit structure (C1) is preferably 10 to 90 mol%, more preferably 30 to 85 mol%, and still more preferably 40 to 80 mol% relative to the total unit structure of the polymer.

Examples of the polymer (A3) include polymers described in WO 2023/106364 A. The entire contents of International Publication No. WO 2023/106364 A are incorporated herein by reference to the same extent as if fully set forth herein.

The molecular weight of the polymer (A3) is not particularly limited. The weight-average molecular weight measured by gel permeation chromatography (hereinafter may be abbreviated as GPC) is preferably 1,500 to 100,000, and more preferably 2,000 to 50,000.

### <<Polymer (A4)>>

The polymer (A4) has an aromatic hydrocarbon structure having 6 to 40 carbon atoms in the main chain. Such a polymer preferably contains a structure represented by the following Formula (Q).

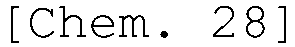

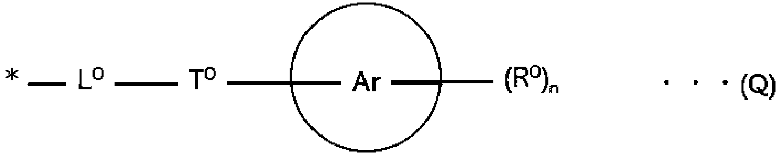

(In Formula (Q),
Ar represents an optionally substituted aromatic ring group having 6 to 40 carbon atoms,
L⁰ represents a single bond, an ester bond, an ether bond, an optionally substituted alkylene group having 1 to 10 carbon atoms, or an optionally substituted alkenylene group having 2 to 10 carbon atoms, and
T⁰ represents a single bond, an ester bond, an ether bond, an optionally substituted alkylene group having 1 to 10 carbon atoms, or an optionally substituted alkenylene group having 2 to 10 carbon atoms.

Here, L⁰ and T⁰ are different from each other,
n R⁰'s independently represent a hydroxy group, a halogen atom, a nitro group, a cyano group, an amino group, or a monovalent organic group,
n represents an integer of 0 to 5, and
* represents a linking moiety with a polymer or compound residue.).

Examples of the aromatic ring having 6 to 40 carbon atoms include benzene, naphthalene, anthracene, acenaphthene, fluorene, triphenylene, phenalene, phenanthrene, indene, indane, indacene, pyrene, chrysene, perylene, naphthacene, pentacene, coronene, heptacene, benzo[a]anthracene, dibenzophenanthrene, dibenzo[a,j]anthracene, and derivatives thereof. Among them, benzene, naphthalene or anthracene is preferable.

Examples of the alkylene group having 1 to 10 carbon atoms include a methylene group, an ethylene group, an n-propylene group, an isopropylene group, a cyclopropylene group, an n-butylene group, an isobutylene group, an s-butylene group, a t-butylene group, a cyclobutylene group, a 1-methyl-cyclopropylene group, a 2-methyl-cyclopropylene group, an n-pentylene group, a 1-methyl-n-butylene group, a 2-methyl-n-butylene group, a 3-methyl-n-butylene group, a 1,1-dimethyl-n-propylene group, a 1,2-dimethyl-n-propylene group, a 2,2-dimethyl-n-propylene group, a 1-ethyl-n-propylene group, a cyclopentylene group, a 1-methyl-cyclobutylene group, a 2-methyl-cyclobutylene group, a 3-methyl-cyclobutylene group, a 1,2-dimethyl-cyclopropylene group, a 2,3-dimethyl-cyclopropylene group, a 1-ethyl-cyclopropylene group, a 2-ethyl-cyclopropylene group, an n-hexylene group, a 1-methyl-n-pentylene group, a 2-methyl-n-pentylene group, a 3-methyl-n-pentylene group, a 4-methyl-n-pentylene group, a 1,1-dimethyl-n-butylene group, a 1,2-dimethyl-n-butylene group, a 1,3-dimethyl-n-butylene group, a 2,2-dimethyl-n-butylene group, a 2,3-dimethyl-n-butylene group, a 3,3-dimethyl-n-butylene group, a 1-ethyl-n-butylene group, a 2-ethyl-n-butylene group, a 1,1,2-trimethyl-n-propylene group, a 1,2,2-trimethyl-n-propylene group, a 1-ethyl-1-methyl-n-propylene group, a 1-ethyl-2-methyl-n-propylene group, a cyclohexylene group, a 1-methyl-cyclopentylene group, a 2-methyl-cyclopentylene group, a 3-methyl-cyclopentylene group, a 1-ethyl-cyclobutylene group, a 2-ethyl-cyclobutylene group, a 3-ethyl-cyclobutylene group, a 1,2-dimethyl-cyclobutylene group, a 1,3-dimethyl-cyclobutylene group, a 2,2-dimethyl-cyclobutylene group, a 2,3-dimethyl-cyclobutylene group, a 2,4-dimethyl-cyclobutylene group, a 3,3-dimethyl-cyclobutylene group, a 1-n-propyl-cyclopropylene group, a 2-n-propyl-cyclopropylene group, a 1-isopropyl-cyclopropylene group, a 2-isopropyl-cyclopropylene group, a 1,2,2-trimethyl-cyclopropylene group, a 1,2,3-trimethyl-cyclopropylene group, a 2,2,3-trimethyl-cyclopropylene group, a 1-ethyl-2-methyl-cyclopropylene group, a 2-ethyl-1-methyl-cyclopropylene group, a 2-ethyl-2-methyl-cyclopropylene group, a 2-ethyl-3-methyl-cyclopropylene group, an n-heptylene group, an n-octylene group, an n-nonylene group, and an n-decanylene group.

Examples of the alkenylene group having 2 to 10 carbon atoms include a group having at least one double bond in which hydrogen atoms are removed from each of adjacent carbon atoms in an alkylene group having 2 to 10 carbon atoms. Among the alkenylene groups having 2 to 10 carbon atoms, a vinylene group is preferable.

Examples of the halogen atom include a fluorine atom, a chlorine atom, a bromine atom, and an iodine atom.

The phrase "optionally substituted" means that some or all of hydrogen atoms present in the aromatic ring having 6 to 40 carbon atoms, the alkylene group having 1 to 10 carbon atoms, or the alkenylene group having 2 to 10 carbon atoms are optionally substituted with, for example, a hydroxy group, a halogen atom, a carboxy group, a nitro group, a cyano group, a methylenedioxy group, an acetoxy group, a methylthio group, an amino group, an alkyl group having 1 to 10 carbon atoms, or an alkoxy group having 1 to 10 carbon atoms.

Further, the polymer (A4) preferably contains a structure represented by the following Formula (Q-1) at a terminal thereof.

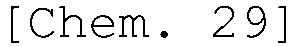

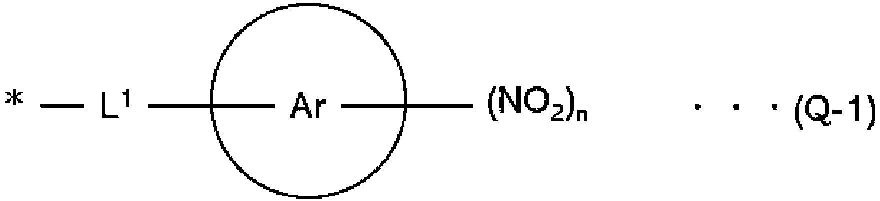

(in Formula (Q-1), Ar represents an optionally substituted aromatic ring having 6 to 40 carbon atoms, L¹ represents a single bond, an ester bond, an ether bond, an alkylene group having 1 to 10 carbon atoms, or an alkenylene group having 2 to 10 carbon atoms, n represents an integer of 1 to 3, and * represents a bond).

Examples of the structure represented by Formula (Q-1) described above include the following. (In the following examples, the bond * has a structure shown as a compound by substitution of a hydrogen atom or the like.)

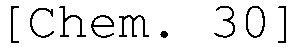

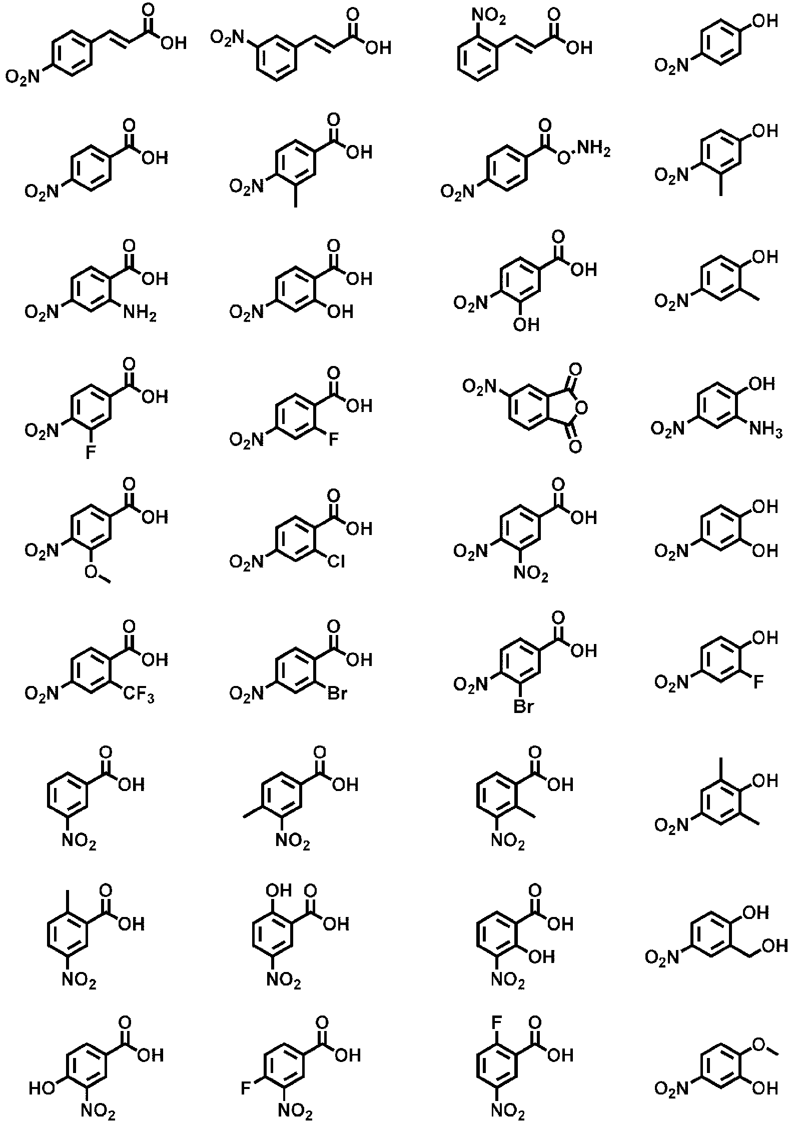

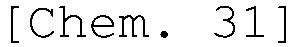

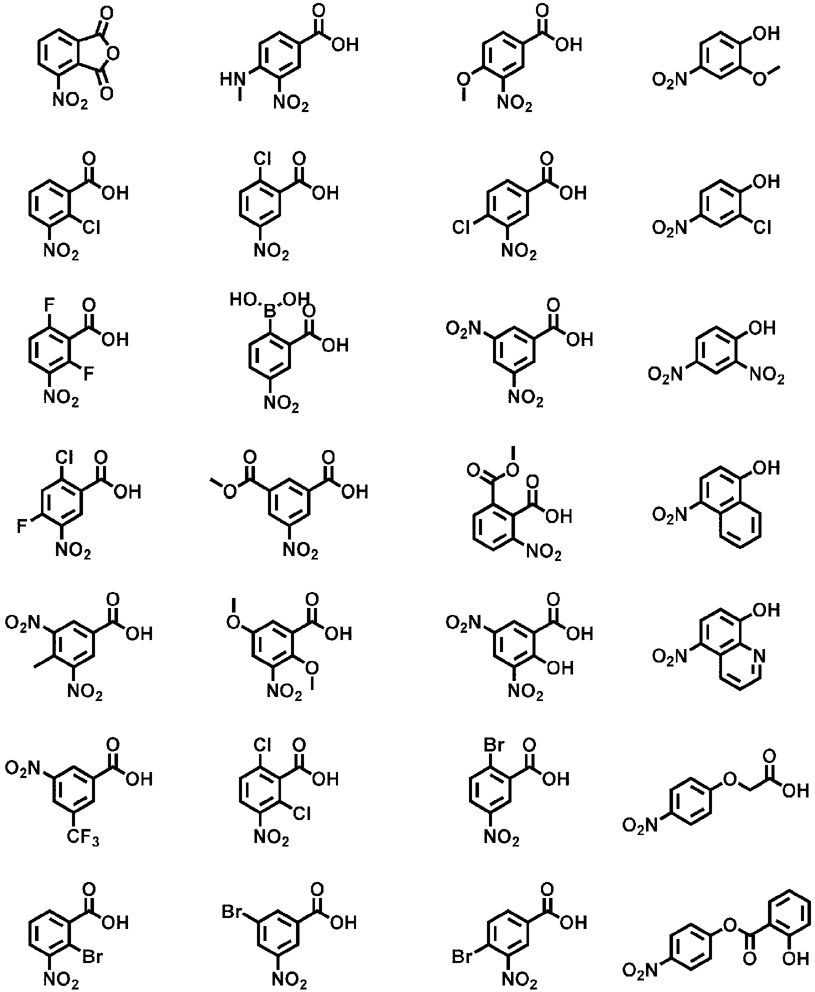

The polymer (A4) is preferably a reaction product of the exemplary compound and the epoxy group-containing compound. It is also preferable that the reactant with the epoxy group-containing compound has a repeating unit.

Examples of the epoxy group-containing compound include the following.

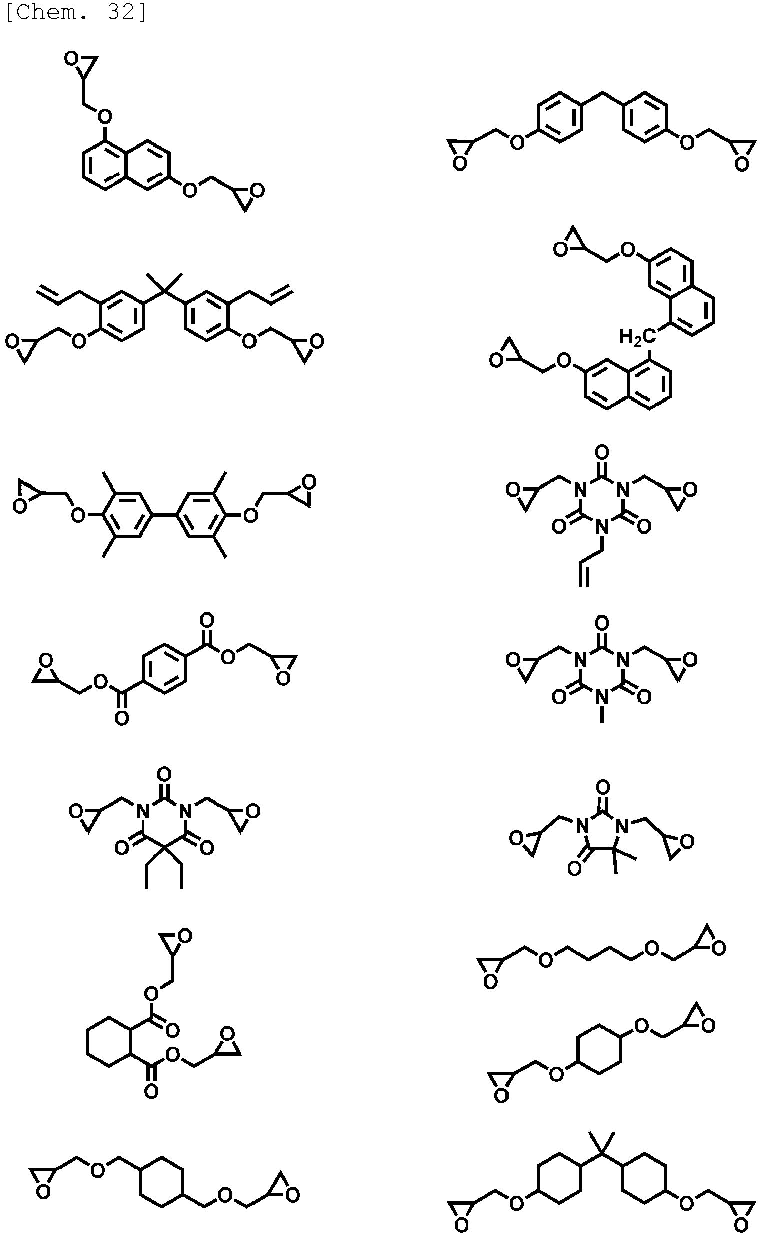

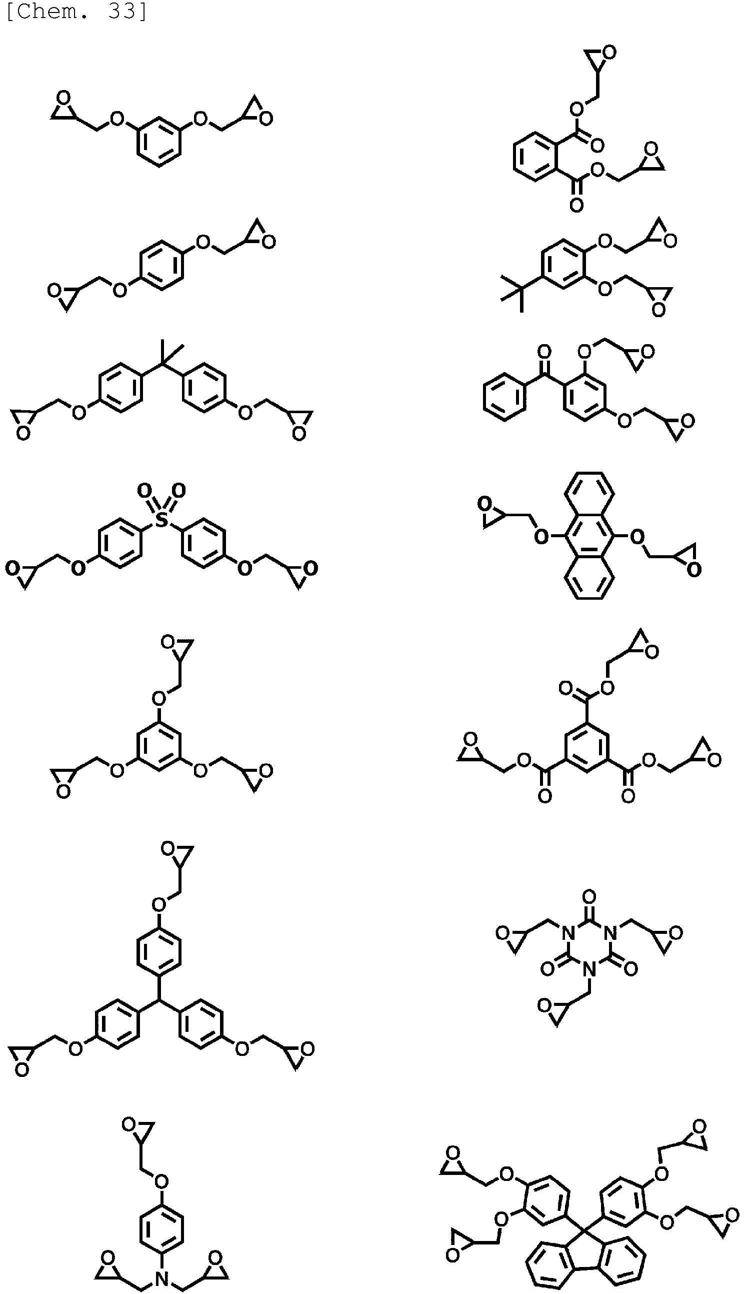

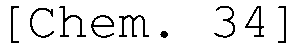

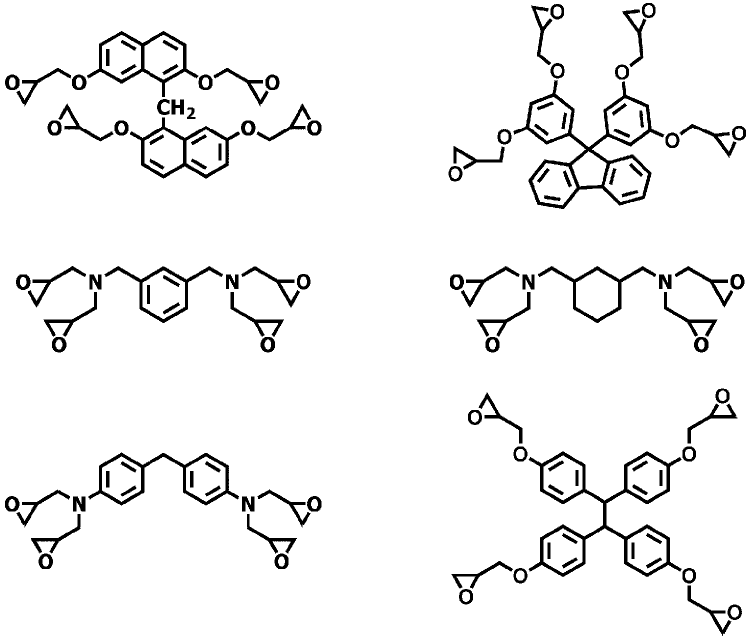

Examples of the polymer (A4) include polymers described in WO 2022/196662 A.

The polymer (A4) may be a polymer contained in at least one selected from resist underlayer film-forming compositions A, B, and C described in WO 2022/196662 A. For example, as the polymer (A4), polymers described as Examples A1 to A19 in WO 2022/196662 A may be mentioned.

The entire contents of International Publication No. WO 2022/196662 A are incorporated herein by reference to the same extent as if fully set forth herein.

The molecular weight of the polymer (A4) is not particularly limited, but the weight-average molecular weight measured by gel permeation chromatography (hereinafter may be abbreviated as GPC) is preferably 1,000 to 30,000 and more preferably 2,000 to 20,000.

### <<Polymer (A5)>>

The polymer (A5) is a reaction product of a bifunctional or higher functional compound having at least one disulfide bond and a trifunctional or higher functional compound.

The bifunctional or higher functional compound having at least one disulfide bond is, for example, a dicarboxylic acid containing a disulfide bond.

The dicarboxylic acid containing a disulfide bond is represented by, for example, the following Formula (1). [Chem. 35]

**HOOC-X₁-S-S-X₂-COOH** (1)

(In Formula (1), X₁ and X₂ each represent an optionally substituted alkylene group having 1 to 10 carbon atoms, an optionally substituted arylene group having 6 to 40 carbon atoms, or a combination thereof.)

In Formula (1) relating to the polymer (A5), X₁ and X₂ are each preferably an alkylene group having 1 to 3 carbon atoms.

The trifunctional or higher functional compound is, for example, a compound containing three or more epoxy groups.

The trifunctional or higher functional compound is preferably a compound containing three epoxy groups.

Examples of the compound containing three or more epoxy groups include a glycidyl ether compound, a glycidyl ester compound, a glycidyl amine compound, and a glycidyl group-containing isocyanurate.

Examples of the polymer (A5) include reaction products described in WO 2019/151471 A. The reaction product is a reaction product of a bifunctional or higher functional compound having at least one disulfide bond and a trifunctional or higher functional compound.

The entire contents of International Publication No. WO 2019/151471 A are incorporated herein by reference to the same extent as if fully set forth herein.

The weight-average molecular weight of the polymer (A5) is, for example, 1,000 to 100,000, or 1,100 to 50,000, or 1,200 to 30,000, or 1,300 to 20,000.

### <<Polymer (A6)>>

The polymer (A6) is a polymer containing, at the terminal, an aliphatic ring in which a carbon-carbon bond may be interrupted by a heteroatom and which is optionally substituted with a substituent. The polymer (A6) is, in other words, a polymer containing, at the terminal, an aliphatic ring which may contain an -O- or -S- bond between carbon-carbon bonds and which is optionally substituted with a substituent.

The aliphatic ring is, for example, a monocyclic or polycyclic aliphatic ring having 3 to 10 carbon atoms.

The polycyclic aliphatic ring is, for example, a bicyclo ring or a tricyclo ring.

The aliphatic ring has, for example, at least one unsaturated bond.

The substituent is selected from, for example, a hydroxy group, a linear or branched alkyl group having 1 to 10 carbon atoms, an alkoxy group having 1 to 20 carbon atoms, an acyloxy group having 1 to 10 carbon atoms, and a carboxy group.

The polymer (A6) has, for example, at least one structural unit represented by the following Formula (3) in the main chain.

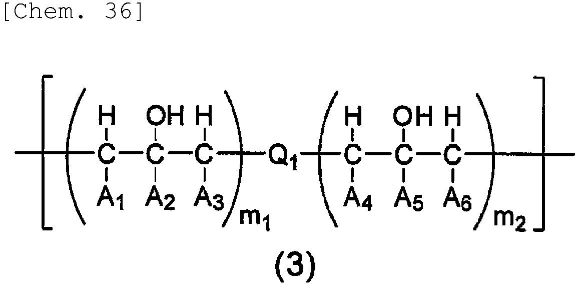

(In Formula (3), A₁, A₂, A₃, A₄, A₅, and A₆ each independently represent a hydrogen atom, a methyl group, or an ethyl group, Q₁ represents a divalent organic group, and m1 and m2 each independently represent 0 or 1.)

In Formula (3) relating to the polymer (A6), for example, Q₁ represents a divalent organic group represented by the following Formula (5).

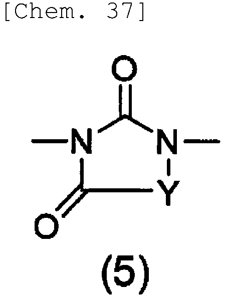

(In the formula, Y represents a divalent group represented by the following Formula (6) or (7).)

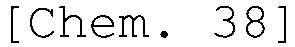

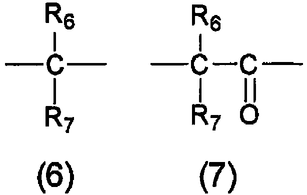

(In formula, R₆ and R₇ each independently represent a hydrogen atom, an alkyl group having 1 to 6 carbon atoms, an alkenyl group having 3 to 6 carbon atoms, a benzyl group, or a phenyl group, the phenyl group may be substituted with at least one selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms, or R₆ and R₇ may be bonded to each other to form a ring having 3 to 6 carbon atoms together with the carbon atom bonded to R₆ and R₇.)

The polymer (A6) further contains, for example, a disulfide bond in the main chain.

Examples of the polymer (A6) include polymers described in WO 2020/226141 A. The polymer is a polymer containing, at the terminal, an aliphatic ring in which a carbon-carbon bond may be interrupted by a heteroatom and which is optionally substituted with a substituent.

The entire contents of International Publication No. WO 2020/226141 A are incorporated herein by reference to the same extent as if fully set forth herein.

The weight-average molecular weight of the polymer (A6) is, for example, 2,000 to 50,000.

### <<Polymer (A7)>>

An example of the polymer (A7) is a reaction product of a compound (A) represented by the following Formula (1) dissolved in a solvent, a compound (B) having two functional groups reactive with an epoxy group, and a compound (C) having one functional group reactive with an epoxy group.

Another example of the polymer (A7) is a reaction product of a compound (A) represented by the following Formula (1) dissolved in a solvent and a compound (B) which does not contain a disulfide bond and has two functional groups reactive with an epoxy group.

Another example of the polymer (A7) is a reaction product that is obtained by reacting a mixture containing a compound (A) represented by the following Formula (1), a compound (B) having two functional groups reactive with an epoxy group, and a compound (C) having one functional group reactive with an epoxy group, and is soluble in a solvent (solvent contained in the resist underlayer film-forming composition).

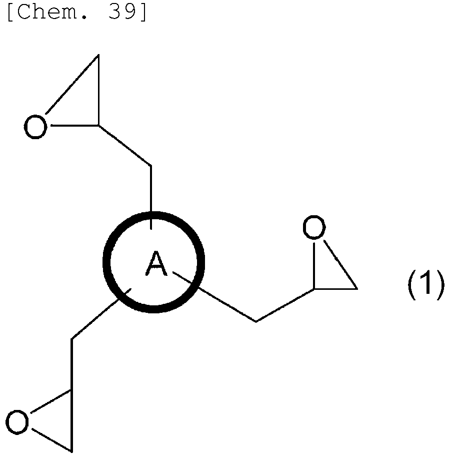

(In Formula (1), A represents an organic group containing an aliphatic ring, an aromatic ring, or a heterocyclic ring.)

The phrase "soluble in a solvent" means that a state where a reaction product is uniformly dissolved in a solvent is maintained, and for example, this means that a precipitate of the reaction product (including a gel) does not visually exist even after storage under certain conditions (for example, in the range of 5 to 40°C, for 1 month), and that 100 mL of the composition can be completely filtered within 30 minutes using a microfilter having a pore size of 0.05 µm to 0.1 µm.

A in Formula (1) relating to the polymer (A7) is, for example, a heterocyclic ring. The heterocyclic ring is, for example, a triazine ring.

The compound (B) relating to the polymer (A7) is a compound having two functional groups reactive with an epoxy group, including an aliphatic ring, an aromatic ring, a heterocyclic ring, a fluorine atom, an iodine atom, or a sulfur atom.

The compound (C) relating to the polymer (A7) is a compound having one functional group reactive with an epoxy group, including an aliphatic ring or an aromatic ring which is optionally substituted with a substituent.

Examples of the functional group having reactivity with an epoxy group include a hydroxy group, an acyl group, an acetyl group, a formyl group, a benzoyl group, a carboxy group, a carbonyl group, an amino group, an imino group, a cyano group, an azo group, an azido group, a thiol group, a sulfo group, an allyl group, and an acid anhydride group, and a carboxy group is preferable.

The polymer (A7) includes, for example, a partial structure represented by the following Formula (1-1).

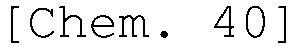

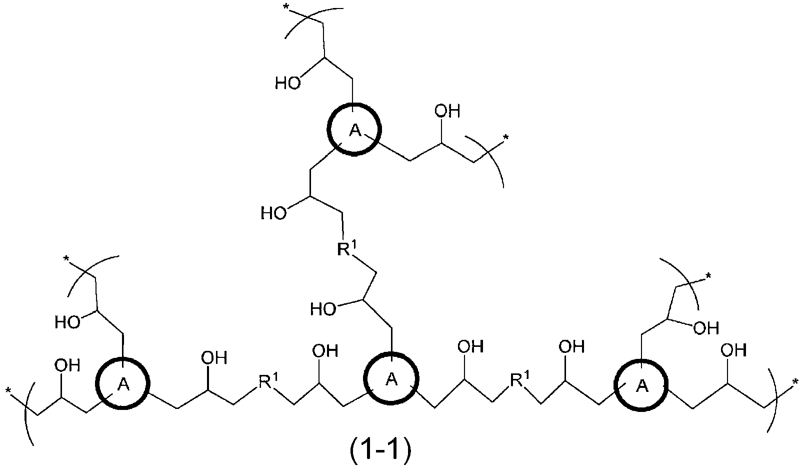

(In Formula (1-1), A represents an organic group containing an aliphatic ring, an aromatic ring or a heterocyclic ring, R¹ represents a residue derived from the compound (B), and * represents a linking moiety with the compound (B) or the compound (C).)

Examples of the polymer (A7) include reaction products described in WO 2022/075339 A.

The entire contents of International Publication No. WO 2022/075339 A are incorporated herein by reference to the same extent as if fully set forth herein.

The lower limit of the weight-average molecular weight of the polymer (A7) is, for example, 500, 1,000, 2,000, or 3,000, and the upper limit of the weight-average molecular weight of the polymer (A7) is, for example, 30,000, 20,000, or 10,000.

### <<Polymer (A8)>>

The polymer (A8) is a polymer having a unit structure represented by the following Formula (I).

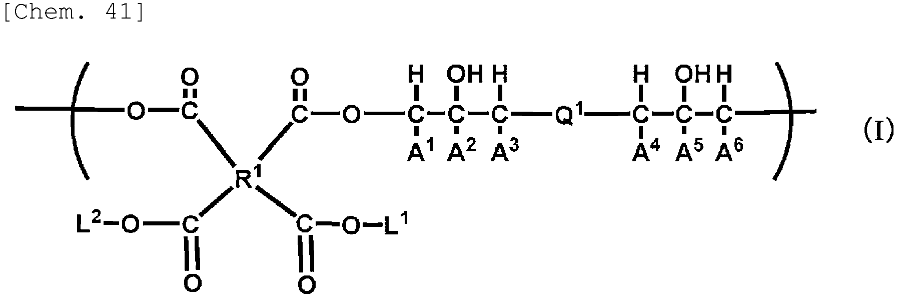

(In Formula (I), A¹, A², A³, A⁴, A⁵, and A⁶ each independently represent a hydrogen atom, a methyl group, or an ethyl group, Q¹ represents a divalent organic group, R¹ represents a tetravalent organic group containing an aromatic ring structure having 6 to 40 carbon atoms, L¹ and L² each independently represent a hydrogen atom or an alkyl group having 1 to 10 carbon atoms which may be substituted with a hydroxy group and may be interrupted by an oxygen atom.)

R₁ in Formula (I) relating to the polymer (A8) includes, for example, a biphenylene structure.

The polymer (A8) includes a repeating unit represented by the following Formula (a-2).

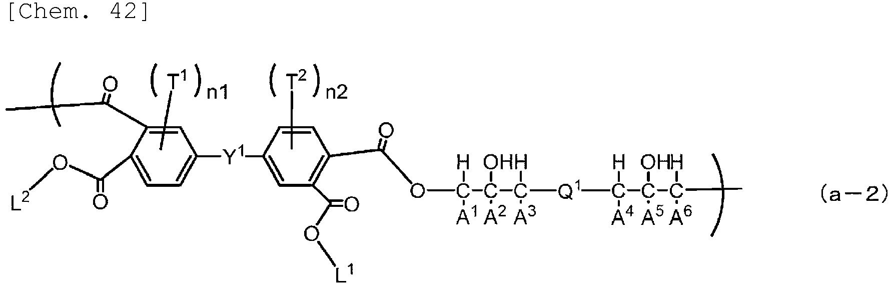

(In Formula (a-2), Y¹ represents a single bond, an oxygen atom, a sulfur atom, an alkylene group having 1 to 10 carbon atoms or a sulfonyl group, each of which may be substituted with a halogen atom or an aryl group having 6 to 40 carbon atoms, n1 T¹ and n2 T² each independently represent a hydrogen atom or an alkyl group having 1 to 10 carbon atoms, and two benzene rings may be bridged by being bonded to each other,

n1 and n2 each independently represent an integer of 0 to 4, and Q¹, A¹, A², A³, A⁴, A⁵, A⁶, L¹, and L² each have the same meanings as Q¹, A¹, A², A³, A⁴, A⁵, A⁶, L¹, and L² in Formula (I).)

The polymer (A8) further has a heterocyclic structure.

Y¹ in Formulae (I) and (a-1) relating to the polymer (A8) is, for example, a sulfonyl group.

The terminal of the polymer (A8) is, for example, sealed with a compound. The compound includes, for example, an aliphatic ring which is optionally substituted with a substituent. The compound is represented by, for example, the following Formulae (1) and (2).

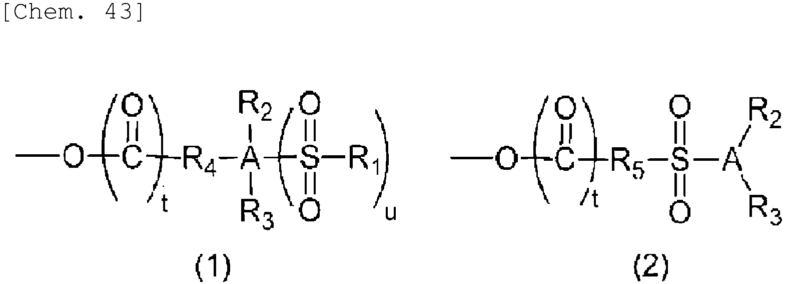

(In Formulae (1) and (2), R₁ represents an alkyl group having 1 to 6 carbon atoms which may have a substituent, a phenyl group, a pyridyl group, a halogeno group, or a hydroxy group, R₂ represents a hydrogen atom, an alkyl group having 1 to 6 carbon atoms, a hydroxy group, a halogeno group, or an ester group represented by -C(=O)O-X, X represents an alkyl group having 1 to 6 carbon atoms which may have a substituent, R₃ represents a hydrogen atom, an alkyl group having 1 to 6 carbon atoms, a hydroxy group, or a halogeno group, R₄ represents a single bond or a divalent organic group having 1 to 8 carbon atoms, R₅ represents a divalent organic group having 1 to 8 carbon atoms, A represents an aromatic ring or an aromatic heterocyclic ring, t represents 0 or 1, and u represents 1 or 2.)

The weight-average molecular weight of the polymer (A8) is preferably 500 to 50,000, and more preferably 1,000 to 30,000.

Examples of the polymer (A8) include polymers described in WO 2022/163673 A.

The entire contents of International Publication No. WO 2022/163673 A are incorporated herein by reference to the same extent as if fully set forth herein.

### <<Polymer (A9)>>

The polymer (A9) is a polymer including a repeating unit represented by the following Formula (1).

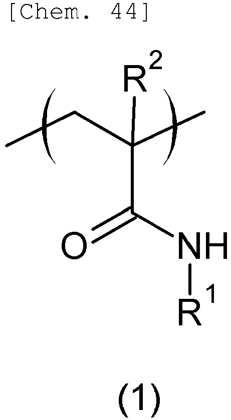

(In Formula (1), R¹ represents a monovalent organic group having 1 to 20 carbon atoms. R² represents a hydrogen atom or an alkyl group having 1 to 6 carbon atoms.)

R¹ in Formula (1) relating to the polymer (A9) preferably represents the following Formula (1X).

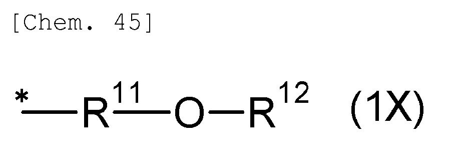

(In Formula (1X), R¹¹ represents an alkylene group having 1 to 4 carbon atoms, and R¹² represents a hydrogen atom, an alkyl group having 1 to 6 carbon atoms, or an alkoxyalkyl group having 2 to 10 total carbon atoms. * represents a bond.)

In Formula (1X) relating to the polymer (A9), R¹¹ preferably represents a methylene group or a 1,2-ethylene group.

In Formula (1X) relating to the polymer (A9), R¹² preferably represents a hydrogen atom or an alkoxyalkyl group having 2 to 6 total carbon atoms.

The polymer (A9) preferably further includes a repeating unit represented by the following Formula (2).

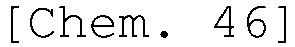

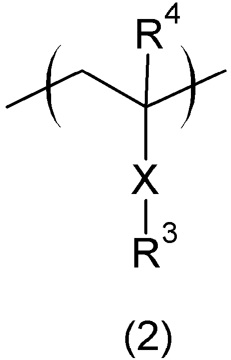

(In Formula (2), X represents a single bond or -COO-, R³ represents a monovalent organic group having 1 to 20 carbon atoms, and R⁴ represents a hydrogen atom or an alkyl group having 1 to 6 carbon atoms. * represents a bond.)

Preferably, X in Formula (2) relating to the polymer (A9) represents -COO-, and R³ represents a linear or branched alkyl group having 1 to 20 carbon atoms, a monovalent group having 2 to 20 total carbon atoms and having a cyclic structure optionally having a hetero atom, or the following Formula (2X).
[Chem. 47]

*-R²¹-O-R²² (2X)

(In Formula (2X), R²¹ represents an alkylene group having 1 to 4 carbon atoms, and R²² represents a hydrogen atom, an alkyl group having 1 to 6 carbon atoms, or an alkoxyalkyl group having 2 to 10 total carbon atoms.)

The linear or branched alkyl group having 1 to 20 carbon atoms is preferably a linear or branched alkyl group having 1 to 6 carbon atoms.

The monovalent group having 2 to 20 total carbon atoms and having a cyclic structure optionally having a hetero atom is preferably a monovalent group obtained by removing one hydrogen atom from a monocyclic or polycyclic aliphatic ring having 3 to 10 carbon atoms.

In Formula (2X) relating to the polymer (A9), R²¹ preferably represents a methylene group, a 1,2-ethylene group or a propylene group.

In Formula (2X) relating to the polymer (A9), R²² preferably represents a hydrogen atom or an alkoxyalkyl group having 2 to 6 total carbon atoms.

The molar ratio between the repeating unit represented by Formula (1) and the repeating unit represented by Formula (2) relating to the polymer (A9) (Formula (1):Formula (2)) is preferably 30:70 to 90:10.

The molecular weight of the polymer (A9) is not particularly limited, but the weight-average molecular weight by gel permeation chromatography is preferably 5,000 to 100,000, and more preferably 10,000 to 50,000.

Examples of the polymer (A9) include polymers described in WO 2023/085293 A.

The entire contents of International Publication No. WO 2023/085293 A are incorporated herein by reference to the same extent as if fully set forth herein.

### <<Polymer (A10)>>

The polymer (A10) is a polymer including at least one of the first structure and the second structure.

The first structure includes a group represented by the following Formula (1) directly connected to an aromatic ring.

The second structure includes a group represented by the following Formula (1) directly connected to a nitrogen atom.
[Chem. 48]

*-R¹-O-R² (1)

(In Formula (1), R¹ represents an alkylene group having 1 to 6 carbon atoms, and R² represents a hydrogen atom, an alkyl group having 1 to 6 carbon atoms, or an alkoxyalkyl group having 2 to 10 total carbon atoms. * represents a bond.)

The polymer (10) preferably includes, as the first structure, at least one of a structure represented by the following Formula (11), a structure represented by the following Formula (12), and a structure represented by the following Formula (13).

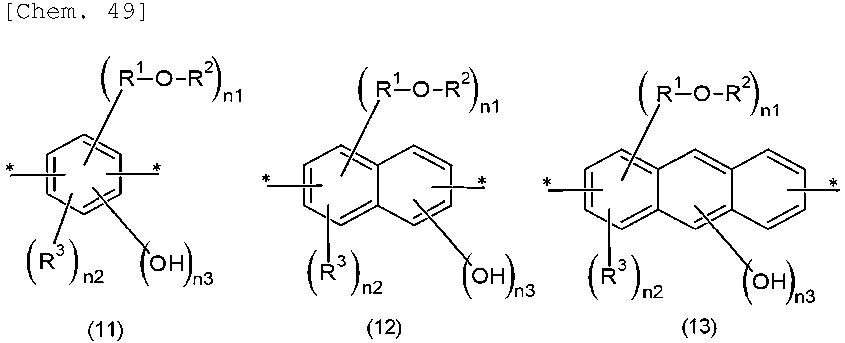

(In Formulae (11) to (13), R¹'s each independently represent an alkylene group having 1 to 6 carbon atoms, R²'s each independently represent a hydrogen atom, an alkyl group having 1 to 6 carbon atoms, or an alkoxyalkyl group having 2 to 10 total carbon atoms, and R³'s each independently represent an alkyl group having 1 to 6 carbon atoms. * represents a bond.

In Formula (11) relating to the polymer (A10), n1 represents an integer of 1 to 4, n2 represents an integer of 0 to 3, n3 represents an integer of 0 to 3, and n1, n2 and n3 satisfy 1 ≤ (n1 + n2 + n3) ≤ 4.

In Formula (12) relating to the polymer (A10), n1 represents an integer of 1 to 6, n2 represents an integer of 0 to 5, n3 represents an integer of 0 to 5, and n1, n2 and n3 satisfy 1 ≤ (n1 + n2 + n3) ≤ 6.

In Formula (13) relating to the polymer (A10), n1 represents an integer of 1 to 8, n2 represents an integer of 0 to 7, n3 represents an integer of 0 to 7, and n1, n2 and n3 satisfy 1 ≤ (n1 + n2 + n3) ≤ 8.

In Formulae (11) to (13) relating to the polymer (A10), when there are two or more R¹'s, the two or more R¹'s may be respectively identical to or different from each other. When there are two or more R²'s, the two or more R²'s may be identical to or different from each other. When there are two or more R³'s, the two or more R³'s may be identical to or different from each other.)

The polymer (10) preferably contains at least one of a repeating unit represented by the following Formula (11-1) and a repeating unit represented by the following Formula (11-2) as a repeating unit containing a structure represented by Formula (11).

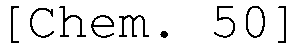

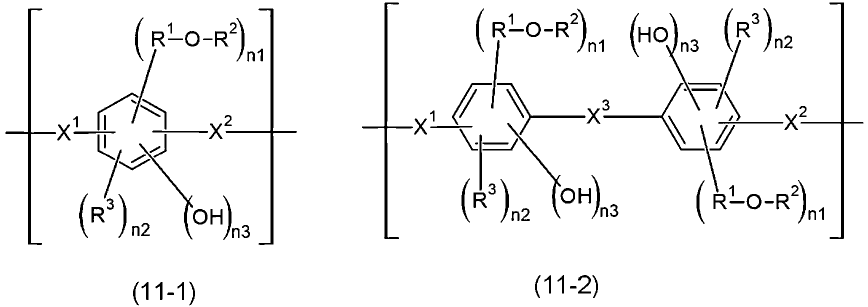

(In Formulae (11-1) to (11-2), R¹'s each independently represent an alkylene group having 1 to 6 carbon atoms, R²'s each independently represent a hydrogen atom, an alkyl group having 1 to 6 carbon atoms, or an alkoxyalkyl group having 2 to 10 total carbon atoms, and R³'s each independently represent an alkyl group having 1 to 6 carbon atoms. n1's each independently represent an integer of 1 to 4, n2's each independently represent an integer of 0 to 3, and n3's each independently represent an integer of 0 to 3.

In Formula (11-1) relating to the polymer (A10), X¹ and X² each independently represent a single bond, an oxygen atom, or a methylene group.

In Formula (11-2) relating to the polymer (A10), X¹ and X² each independently represent a single bond, an oxygen atom, or a methylene group. X3 represents a single bond or a divalent organic group having 1 to 15 carbon atoms.

In Formula (11-1) relating to the polymer (A10), n1, n2, and n3 satisfy 1 ≤ (n1 + n2 + n3) ≤ 4.

In Formula (11-2) relating to the polymer (A10), n1, n2 and n3 in the left benzene ring satisfy 1 ≤ (n1 + n2 + n3) ≤ 4. n1, n2, and n3 in the right benzene ring satisfy 1 ≤ (n1 + n2 + n3) ≤ 4.

In the Formulae (11-1) and (11-2) relating to the polymer (A10), when R¹ is two or more, the two or more R¹'s may be identical to or different from each other. When there are two or more R²'s, the two or more R²'s may be identical to or different from each other. When there are two or more R³'s, the two or more R³'s may be identical to or different from each other.)

The polymer (A10) preferably further includes a repeating unit represented by the following Formula (14).

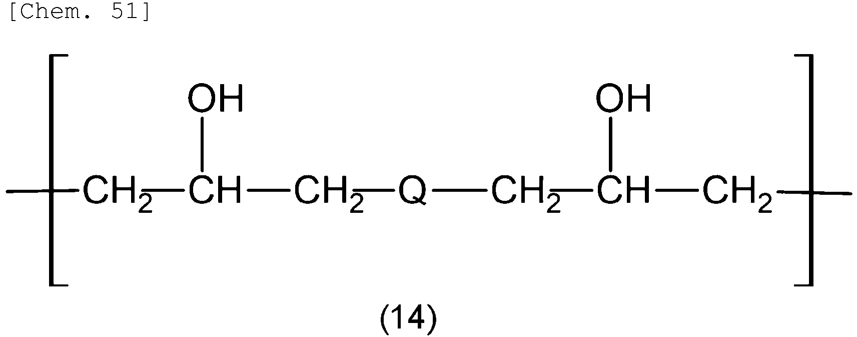

(In Formula (14), Q represents a divalent group.)

In Formula (14) relating to the polymer (A10), Q preferably represents a divalent group represented by the following Formula (14-1) or an arylene group having 6 to 40 carbon atoms.

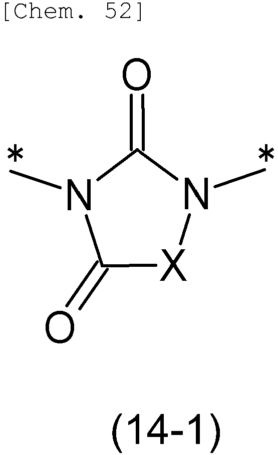

(In Formula (14-1), X represents a group represented by any one of the following Formulae (14-1a) to (14-1c).)

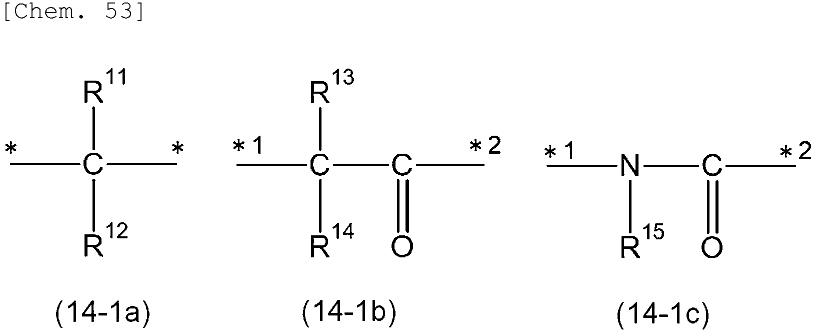

(In Formulae (14-1a) to (14-1c), R¹¹, R¹², R¹³, R¹⁴, and R¹⁵ each independently represents a hydrogen atom, an alkyl group having 1 to 6 carbon atoms, an alkenyl group having 3 to 6 carbon atoms, a benzyl group, or a phenyl group, and the benzyl group and the phenyl group are optionally substituted with a group selected from the group consisting of an alkyl group having 1 to 6 carbon atoms, a halogen atom, an alkoxy group having 1 to 6 carbon atoms, a nitro group, a cyano group, a hydroxy group, and an alkylthio group having 1 to 6 carbon atoms. Further, R¹¹ and R¹² may be bonded to each other to form a ring having 3 to 6 carbon atoms. R1³ and R¹⁴ may be bonded to each other to form a ring having 3 to 6 carbon atoms. * represents a bond. *1 represents a bond bonded to a carbon atom. *2 represents a bond to a nitrogen atom.)

Examples of the polymer (A10) include polymers described in WO 2023/085295 A.

The entire contents of International Publication No. WO 2023/085295 A are incorporated herein by reference to the same extent as if fully set forth herein.

The molecular weight of the polymer (A10) is not particularly limited, but the weight-average molecular weight by gel permeation chromatography is preferably 1,500 to 100,000, and more preferably 2,000 to 50,000.

### <<Polymer (A11)>>

The polymer (A11) is a polymer containing a fluorene structure.

The polymer (A11) preferably includes a partial structure represented by the following Formula (1).

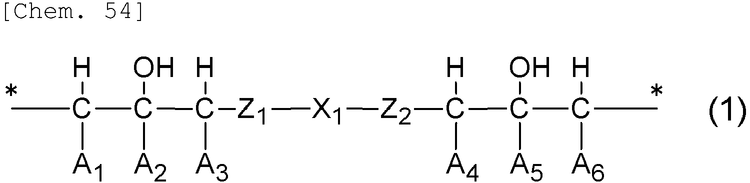

(In Formula (1), X₁ represents a divalent organic group having a fluorene structure.

Z₁ and Z₂ each independently represent a single bond, - O-, -C(=O)O-, or -O-CₘH₂ₘ-O- (m represents an integer of 1 to 6).

A₁, A₂, A₃, A₄, A₅, and A₆ each independently represent a hydrogen atom, a methyl group, or an ethyl group.

* represents a bond.)

X₁ in Formula (1) relating to the polymer (A11) preferably represents a divalent organic group represented by the following Formula (1-A) or (1-B).

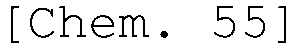

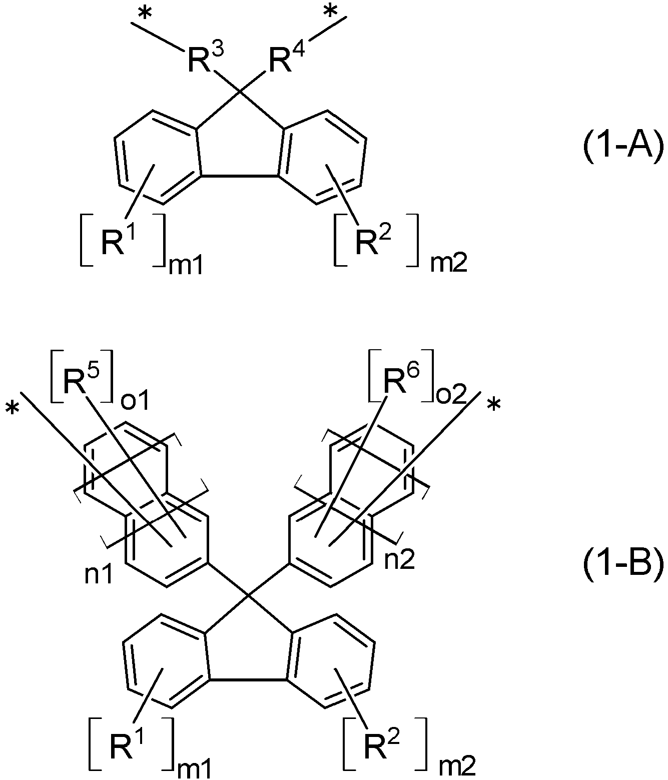

(In Formulae (1-A) and (1-B), R¹, R², R⁵, and R⁶ each independently represent a hydroxy group, an acyl group having 1 to 6 carbon atoms, an alkoxy group having 1 to 6 carbon atoms, an alkoxycarbonyl group having 1 to 6 carbon atoms, an alkyl group having 1 to 10 carbon atoms, an aryl group having 6 to 20 carbon atoms, an alkenyl group having 2 to 20 carbon atoms, or an alkynyl group having 2 to 10 carbon atoms, and the acyl group, the alkoxy group, the alkoxycarbonyl group, the alkyl group, the aryl group, the alkenyl group, and the alkynyl group may have one or more groups selected from the group consisting of an amino group, a nitro group, a cyano group, a hydroxy group, a glycidyl group, and a carboxy group.

R³ and R⁴ each independently represent a single bond or an alkylene group having 1 to 10 carbon atoms.

m1 and m2 each independently represent an integer of 0 to 4.

n1 and n2 each independently represent 0 or 1.

When n1 is 0, o1 represents an integer of 0 to 4. When n1 is 1, o1 represents an integer of 0 to 6.

When n2 is 0, o2 represents an integer of 0 to 4. When n2 is 1, o2 represents an integer of 0 to 6.

When each of R¹'s to R⁶'s is present in plurality, the plural R¹'s to R⁶'s may be the same as or different from each other.

One R⁵ and one R⁶ may be combined to form an -O- bond.

* represents a bond.)

The polymer (A11) preferably further contains at least one of a partial structure represented by the following Formula (2-1) and a partial structure represented by the following Formula (2-2).

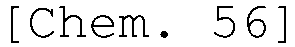

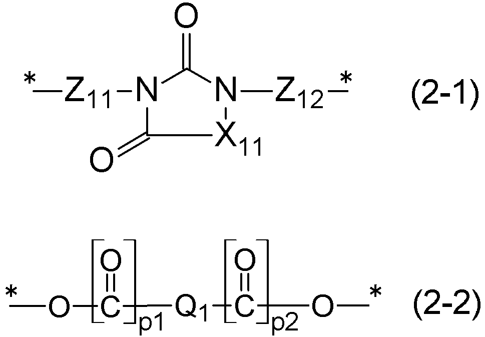

(In Formula (2-1), X₁₁ represents a group represented by any one of the following Formulae (2-1-1) to (2-1-3).

Z₁₁ and Z₁₂ each independently represent a single bond or a divalent group represented by Formula (2-1-4).

In Formula (2-2), Q₁ represents a single bond or a divalent organic group. p1 and p2 each independently represent 0 or 1.)

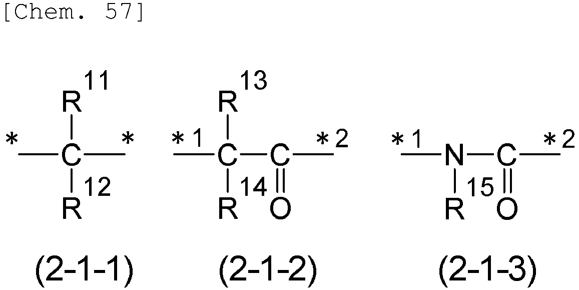

(In Formulae (2-1-1) to (2-1-3), R¹¹ to R¹⁵ each independently represent a hydrogen atom, an alkyl group having 1 to 10 carbon atoms, which may be interrupted by an oxygen atom or a sulfur atom, an alkenyl group having 2 to 10 carbon atoms, which may be interrupted by an oxygen atom or a sulfur atom, an alkynyl group having 2 to 10 carbon atoms, which may be interrupted by an oxygen atom or a sulfur atom, a benzyl group, or a phenyl group, and the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms. R1¹ and R¹² may be bonded to each other to form a ring having 3 to 6 carbon atoms. R1³ and R¹⁴ may be bonded to each other to form a ring having 3 to 6 carbon atoms. * represents a bond. *1 represents a bond bonded to a carbon atom. *2 represents a bond bonded to a nitrogen atom.)

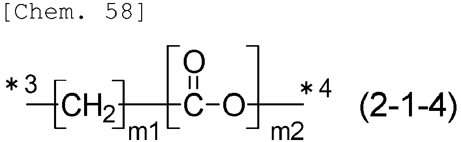

(In Formula (2-1-4), m1 represents an integer of 1 to 4, and m2 represents 0 or 1. *3 represents a bond bonded to a nitrogen atom. *4 represents a bond.)

Examples of the polymer (A11) include polymers described in WO 2023/182408 A.

The entire contents of International Publication No. WO 2023/182408 A are incorporated herein by reference to the same extent as if fully set forth herein.

The molecular weight of the polymer (A11) is not particularly limited, but the weight-average molecular weight measured by gel permeation chromatography (hereinafter may be abbreviated as GPC) is preferably 1,500 to 100,000 and more preferably 2,000 to 50,000.

### <<Polymer (A12)>>

The polymer (A12) is a polymer having a structure represented by the following Formula (1) or (2) at a terminal of a polymer chain.

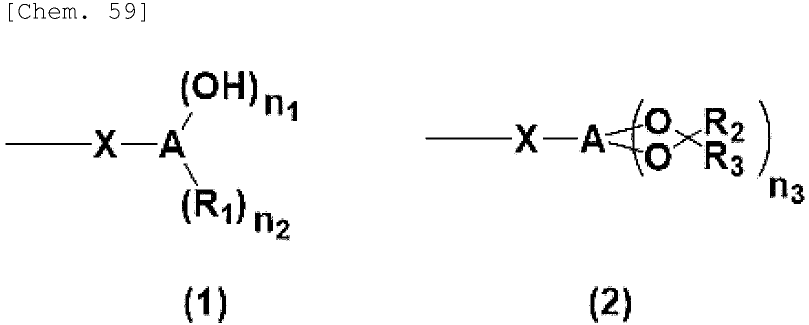

(In the above Formulae (1) and (2), X represents a divalent organic group, A represents an aryl group having 6 to 40 carbon atoms, R₁ represents a halogen atom, an alkyl group having 1 to 10 carbon atoms, or an alkoxy group having 1 to 10 carbon atoms, R₂ and R₃ each independently represent a hydrogen atom, a halogen atom, an optionally substituted alkyl group having 1 to 10 carbon atoms, or an optionally substituted aryl group having 6 to 40 carbon atoms, n1 and n3 each independently represent an integer of 1 to 12, and n2 represents an integer of 0 to 11.)

In Formulae (1) and (2) relating to the polymer (A12), preferably, X represents an ester bond or an ether bond.

In Formulae (1) and (2) relating to the polymer (A12), preferably, A represents a group derived from benzene, naphthalene, or anthracene.

In Formula (2) relating to the polymer (A12), preferably, R₂ and R₃ represent hydrogen atoms.

In Formula (1) relating to the polymer (A12), preferably, n2 represents 0.

The polymer (A12) preferably has a structural unit represented by the following Formula (3).

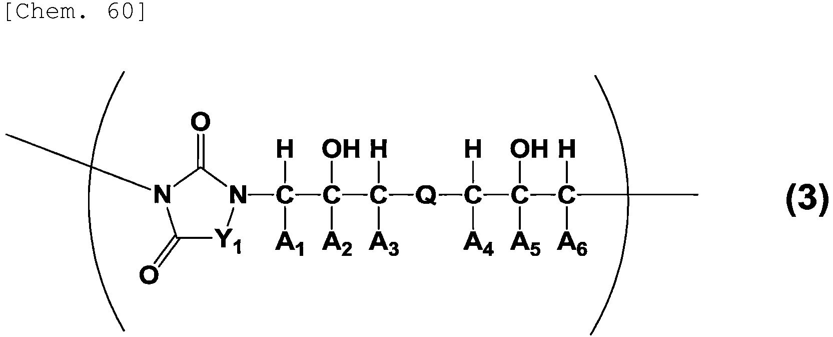

(In Formula (3), A₁, A₂, A₃, A₄, A₅, and A₆ each independently represent a hydrogen atom, a methyl group, or an ethyl group, and Y₁ represents Formula (4), (5), (6), or (7).

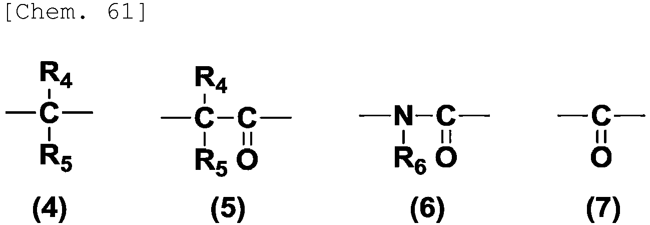

((In the Formulae (4) to (7), R₄ and R₅ each independently represent a hydrogen atom, an alkyl group having 1 to 6 carbon atoms, an alkenyl group having 3 to 6 carbon atoms, a benzyl group, or a phenyl group, the phenyl group may be substituted with at least one group selected from the group consisting of an alkyl group having 1 to 6 carbon atoms, a halogen atom, an alkoxy group having 1 to 6 carbon atoms, a nitro group, a cyano group, a hydroxy group, and an alkylthio group having 1 to 6 carbon atoms, R₄ and R₅ may be bonded to each other to form a ring having 3 to 6 carbon atoms, R₆ represents an alkyl group having 1 to 6 carbon atoms, an alkenyl group having 3 to 6 carbon atoms, a benzyl group, or a phenyl group, and the phenyl group may be substituted with at least one group selected from the group consisting of an alkyl group having 1 to 6 carbon atoms, a halogen atom, an alkoxy group having 1 to 6 carbon atoms, a nitro group, a cyano group, a hydroxy group, and an alkylthio group having 1 to 6 carbon atoms.), and Q represents Formula (8) or (9).

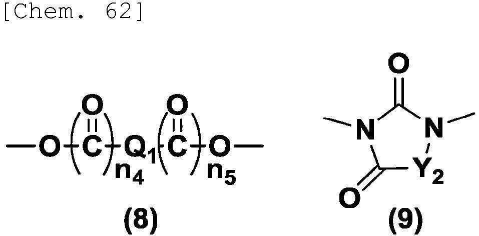

(In the Formulae (8) and (9), Q₁ represents an alkylene group having 1 to 10 carbon atoms, a phenylene group, a naphthylene group, or an anthrylene group, each of the phenylene group, the naphthylene group, and the anthrylene group may be substituted with at least one group selected from the group consisting of an alkyl group having 1 to 6 carbon atoms, a halogen atom, an alkoxy group having 1 to 6 carbon atoms, a nitro group, a cyano group, a hydroxy group, and an alkylthio group having 1 to 6 carbon atoms, n4 and n5 each independently represent an integer of 0 or 1, and Y₂ represents Formula (4), Formula (5), or Formula (7).))

The polymer having a structural unit represented by Formula (3) relating to the polymer (A12) is preferably a polymer having a compound represented by the following Formula (10) and a compound represented by the following Formula (11) as comonomers.

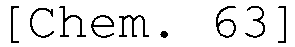

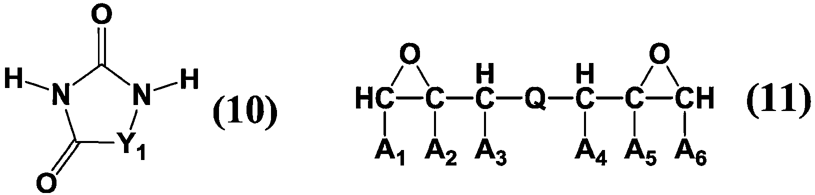

(In Formulae (10) and (11), A₁, A₂, A₃, A₄, A₅, A₆, Y₁, and Q represent the same meaning as defined in Formula (3).)

The polymer having a structural unit represented by Formula (3) relating to the polymer (A12) is preferably a polymer having a compound represented by the following Formula (12) and a compound represented by the following Formula (13) as comonomers.

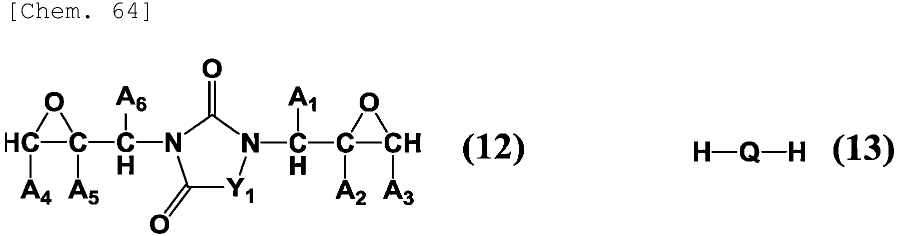

(In the formula, A₁, A₂, A₃, A₄, A₅, A₆, Y₁, and Q represent the same meaning as defined in Formula (3).)

The molecular weight of the polymer (A12) is, as a weight-average molecular weight, for example, 1,000 to 200,000, 1,200 to 100,000, 1,500 to 30,000, 2,000 to 20,000, or 2,000 to 4,000.

The lower limit of the weight-average molecular weight of the polymer (A) is, for example, 500, 1,000, 2,000, or 3,000.

The upper limit of the weight-average molecular weight of the polymer (A) is, for example, 30,000, 20,000, or 10,000.

The content of the polymer (A) in the resist underlayer film-forming composition is not particularly limited, but from the viewpoint of suitably obtaining the effect of the present invention, the content is preferably 40 mass% to 90 mass%, more preferably 45 mass% to 85 mass%, and particularly preferably 50 mass% to 80 mass% relative to the film constituent components.

In the present invention, the film constituent component means a component other than the solvent contained in the composition.

### <Compound (B)>

The compound (B) has a polymerizable multiple bond.

Examples of the polymerizable multiple bond include a carbon-carbon double bond, a carbon-carbon triple bond, a carbon-nitrogen double bond, and a carbon-nitrogen triple bond. Among them, a carbon-carbon double bond and a carbon-carbon triple bond are preferable from the viewpoint of suitably obtaining the effect of the present invention.

Examples of the group having a polymerizable multiple bond in the compound (B) include a (meth)acryloyl group, a vinylaryl group (for example, a styryl group), a vinyloxy group, and an allyl group.

The number of polymerizable multiple bonds in the compound (B) may be one or two or more.

Examples of the group having a polymerizable multiple bond in the compound (B) include a group represented by the following Formula (B-I) and a group represented by the following Formula (B-II).

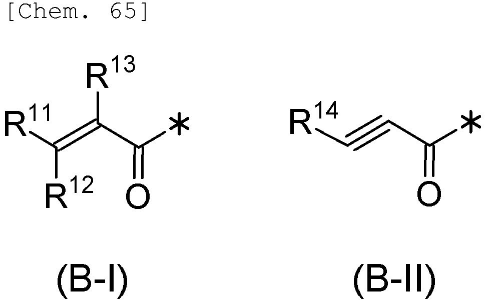

(In Formulae (B-I) and (B-II), R¹¹ to R¹⁴ each independently represent a hydrogen atom, a halogen atom, or an organic group having 1 to 6 carbon atoms.

* represents a bond.)

Examples of the halogen atom in R¹¹ to R¹⁴ in Formulae (B-I) and (B-II) include a fluorine atom, a chlorine atom, a bromine atom, and an iodine atom.

Examples of the organic group having 1 to 6 carbon atoms in R¹¹ to R¹⁴ in Formulae (B-I) and (B-II) include an alkyl group having 1 to 6 carbon atoms, an alkenyl group having 2 to 6 carbon atoms, an alkoxycarbonylalkyl group having 3 to 6 carbon atoms (R^{a}-C(=O)-R^{b}- group: R^{a} represents an alkyl group having 1 to 4 carbon atoms, and R^{b} represents an alkylene group having 1 to 4 carbon atoms), and an acylamino group having 2 to 6 carbon atoms (R^{a}-C(=O)-N(H)- group: R^{a} represents an alkyl group having 1 to 5 carbon atoms).

As R¹¹ and R¹² in Formula (B-I), a hydrogen atom is preferable.

As R¹³ in Formula (B-I), a hydrogen atom or a methyl group is preferable.

As R¹⁴ in Formula (B-I), a hydrogen atom is preferable.

The compound (B) may be a low molecular compound or a high-molecular-weight compound. Therefore, the compound (B) may be a polymer.

The weight-average molecular weight of the compound (B) is not particularly limited, but the lower limit is, for example, 500, 600, or 1,000.

The upper limit of the weight-average molecular weight of the compound (B) is, for example, 10,000, 7,000, or 4,000.

The weight-average molecular weight of the compound (B) is preferably smaller than the weight-average molecular weight of the polymer (A).

The compound (B) is, for example, a reaction product of a reactant containing a compound (B-1) having an epoxy group and a compound (B-2) having a polymerizable multiple bond and being reactive with the epoxy group.

The compound (B) is, for example, a reaction product of a reactant containing a compound (B-3) having a hydroxy group and a compound (B-4) having a polymerizable multiple bond and being reactive with the hydroxy group.

### <<Compound (B-1)>>

The compound (B-1) having an epoxy group is not particularly limited as long as the compound has an epoxy group.

The number of epoxy groups in the compound (B-1) is not particularly limited, and may be 1 or 2 or more, but is preferably 2 or more, and more preferably 2 to 4.

The molecular weight of the compound (B-1) is not particularly limited, but is preferably 500 or less.

Examples of the compound (B-1) include compounds represented by the following Formulae (B1) to (B15).

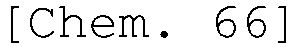

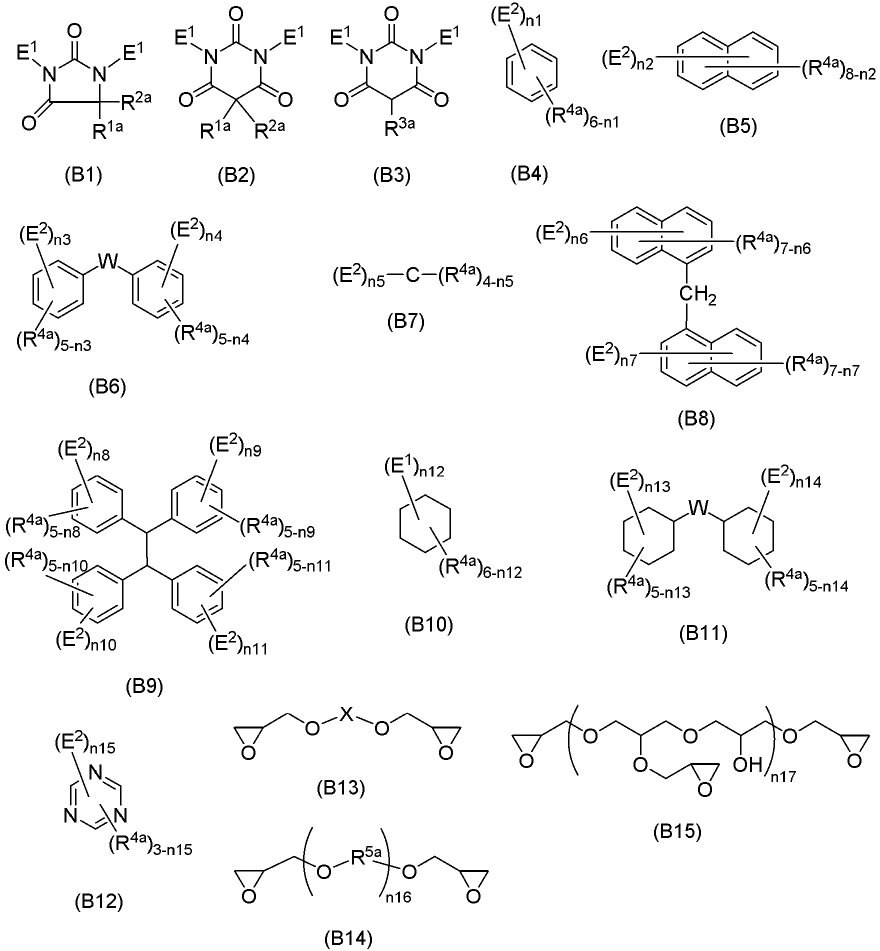

In Formulae (B1) to (B3), E¹ represents a group represented by the following Formula (b1).

In the Formulae (B4) to (B12), E² represents a group represented by the following Formula (b2) or a group represented by the following Formula (b3).

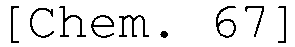

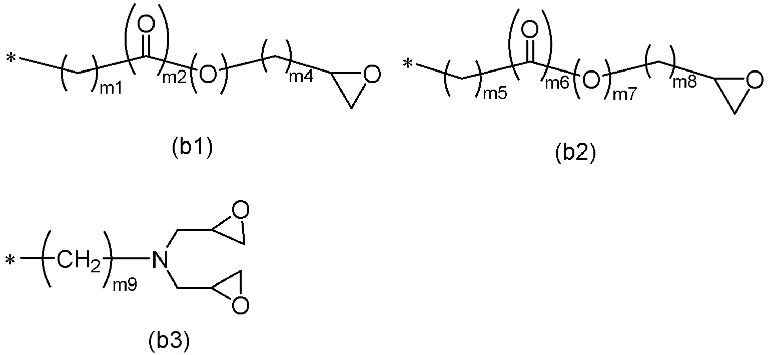

(In Formula (b1), m1 represents an integer of 0 to 4, m2 represents 0 or 1, m3 represents 0 or 1, m4 represents 1 or 2, and when m3 is 1, m1 and m2 are not 0 at the same time.

In Formula (b2), m5 represents an integer of 0 to 4, m6 represents 0 or 1, m7 represents 0 or 1, and m8 represents 1 or 2.

In Formula (b3), m9 represents an integer of 0 to 4.

* represents a bond.)

In Formulae (B1) and (B2), R^{1a} and R^{2a} each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, and the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms.

In Formula (B3), R^{3a} represents a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, a phenyl group, or E¹, and the phenyl group may be substituted with at least one monovalent group selected from the group consisting of an alkyl group having 1 to 10 carbon atoms, a halogen atom, an alkoxy group having 1 to 6 carbon atoms, a nitro group, a cyano group, and an alkylthio group having 1 to 6 carbon atoms.

Examples of the alkyl group having 1 to 10 carbon atoms include a methyl group, an ethyl group, an n-propyl group, an i-propyl group, a cyclopropyl group, an n-butyl group, an i-butyl group, an s-butyl group, a t-butyl group, a cyclobutyl group, a 1-methyl-cyclopropyl group, a 2-methyl-cyclopropyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

Examples of the alkenyl group having 2 to 10 carbon atoms include ethenyl group, 1-propenyl group, 2-propenyl group, 1-methyl-1-ethenyl group, 1-butenyl group, 2-butenyl group, 3-butenyl group, 2-methyl-1-propenyl group, 2-methyl-2-propenyl group, 1-ethylethenyl group, 1-methyl-1-propenyl group, 1-methyl-2-propenyl group, 1-pentenyl group, 2-pentenyl group, 3-pentenyl group, 4-pentenyl group, 1-n-propylethenyl group, 1-methyl-1-butenyl group, 1-methyl-2-butenyl group, 1-methyl-3-butenyl group, 2-ethyl-2-propenyl group, 2-methyl-1-butenyl group, 2-methyl-2-butenyl group, 2-methyl-3-butenyl group, 3-methyl-1-butenyl group, 3-methyl-2-butenyl group, 3-methyl-3-butenyl group, 1,1-dimethyl-2-propenyl group, 1-i-propylethenyl group, 1,2-dimethyl-1-propenyl group, 1,2-dimethyl-2-propenyl group, 1-cyclopentenyl group, 2-cyclopentenyl group, 3-cyclopentenyl group, 1-hexenyl group, 2-hexenyl group, 3-hexenyl group, 4-hexenyl group, 5-hexenyl group, 1-methyl-1-pentenyl group, 1-methyl-2-pentenyl group, 1-methyl-3-pentenyl group, 1-methyl-4-pentenyl group, 1-n-butylethenyl group, 2-methyl-1-pentenyl group, 2-methyl-2-pentenyl group, 2-methyl-3-pentenyl group, 2-methyl-4-pentenyl group, 2-n-propyl-2-propenyl group, 3-methyl-1-pentenyl group, 3-methyl-2-pentenyl group, 3-methyl-3-pentenyl group, 3-methyl-4-pentenyl group, 3-ethyl-3-butenyl group, 4-methyl-1-pentenyl group, 4-methyl-2-pentenyl group, 4-methyl-3-pentenyl group, 4-methyl-4-pentenyl group, 1,1-dimethyl-2-butenyl group, 1,1-dimethyl-3-butenyl group, 1,2-dimethyl-1-butenyl group, 1,2-dimethyl-2-butenyl group, 1,2-dimethyl-3-butenyl group, 1-methyl-2-ethyl-2-propenyl group, 1-s-butylethenyl group, 1,3-dimethyl-1-butenyl group, 1,3-dimethyl-2-butenyl group, 1,3-dimethyl-3-butenyl group, 1-i-butylethenyl group, 2,2-dimethyl-3-butenyl group, 2,3-dimethyl-1-butenyl group, 2,3-dimethyl-2-butenyl group, 2,3-dimethyl-3-butenyl group, 2-i-propyl-2-propenyl group, 3,3-dimethyl-1-butenyl group, 1-ethyl-1-butenyl group, 1-ethyl-2-butenyl group, 1-ethyl-3-butenyl group, 1-n-propyl-1-propenyl group, 1-n-propyl-2-propenyl group, 2-ethyl-1-butenyl group, 2-ethyl-2-butenyl group, 2-ethyl-3-butenyl group, 1,1,2-trimethyl-2-propenyl group, 1-t-butylethenyl group, 1-methyl-1-ethyl-2-propenyl group, 1-ethyl-2-methyl-1-propenyl group, 1-ethyl-2-methyl-2-propenyl group, 1-i-propyl-1-propenyl group, 1-i-propyl-2-propenyl group, 1-methyl-2-cyclopentenyl group, 1-methyl-3-cyclopentenyl group, 2-methyl-1-cyclopentenyl group, 2-methyl-2-cyclopentenyl group, 2-methyl-3-cyclopentenyl group, 2-methyl-4-cyclopentenyl group, 2-methyl-5-cyclopentenyl group, 2-methylene-cyclopentyl group, 3-methyl-1-cyclopentenyl group, 3-methyl-2-cyclopentenyl group, 3-methyl-3-cyclopentenyl group, 3-methyl-4-cyclopentenyl group, 3-methyl-5-cyclopentenyl group, 3-methylene-cyclopentyl group, 1-cyclohexenyl group, 2-cyclohexenyl group, and 3-cyclohexenyl group.

Examples of the alkynyl group having 2 to 10 carbon atoms include an ethynyl group, a 1-propynyl group, a 2-propynyl group, a 1-butynyl group, a 2-butynyl group, a 3-butynyl group, a 4-methyl-1-pentynyl group, and a 3-methyl-1-pentynyl group.

The phrase "may be interrupted by an oxygen atom or a sulfur atom" refers to the fact that, for example, a carbon atom in the middle of a saturated carbon chain of the alkyl group, alkenyl group, or alkynyl group is replaced by an oxygen atom or a sulfur atom. For example, in an alkyl group, an alkenyl group, and an alkynyl group, when any carbon atom is replaced by an oxygen atom, an ether bond is contained, and when any carbon atom is replaced by a sulfur atom, a thioether bond is contained.

Examples of the halogen atom include fluorine, chlorine, bromine, and iodine atoms.

Examples of the alkoxy group having 1 to 6 carbon atoms include a methoxy group, an ethoxy group, an n-propoxy group, an i-propoxy group, an n-butoxy group, an i-butoxy group, a s-butoxy group, a t-butoxy group, an n-pentoxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, an n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, and a 1-ethyl-2-methyl-n-propoxy group.

Examples of the alkylthio group having 1 to 6 carbon atoms include an ethylthio group, a butylthio group, and a hexylthio group.

In Formulae (B4) to (B12), R^{4a}'s each independently represent a hydrogen atom, an alkyl group having 1 to 10 carbon atoms, or an alkenyl group having 2 to 10 carbon atoms.

In the Formulae (B6) and (B11), -W- represents a single bond, -CH₂-, -C(CH₃)₂-, -C(CF₃)₂-, -CO-, -O-, -S-, or SO₂-.

In Formula (B13), X represents an alkylene group having 1 to 6 carbon atoms.

In Formula (B14), R^{5a} represents an alkylene group having 1 to 3 carbon atoms.

In Formula (B4), n1 represents an integer of 2 to 4.

In Formula (B5), n2 represents an integer of 2 to 4.

In Formula (B6), n3 and n4 each independently represent an integer of 0 to 4, and n3 + n4 is 2 to 4.

In Formula (B7), n5 represents an integer of 2 to 4.

In Formula (B8), n6 and n7 each independently represent an integer of 0 to 4, and n6 + n7 is 2 to 4.

In Formula (B9), n8 to n11 each independently represent an integer of 0 to 4, and n8 + n9 + n10 + n11 is 2 to 4.

In Formula (B10), n12 represents an integer of 2 to 4.

In Formula (B11), n13 and n14 each independently represent an integer of 0 to 4, and n13 + n14 is 2 to 4. In Formula (B12), n15 represents an integer of 2 to 3. In Formula (B14), n16 represents an integer of 2 to 6. In Formula (B15), n17 represents an integer of 1 to 4.

Examples of the alkyl group having 1 to 10 carbon atoms and the alkenyl group having 2 to 10 carbon atoms include the same groups as those described above.

Specific examples of the compound represented by Formula (B1) include the following compounds.

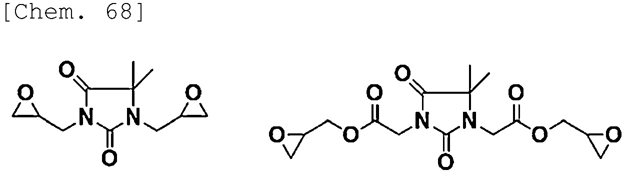

Specific examples of the compound represented by Formula (B2) include the following compounds.

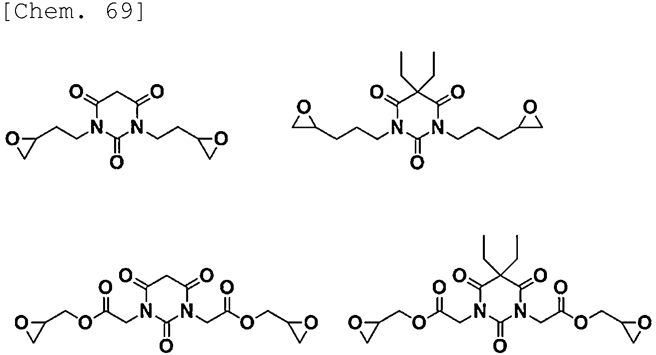

Specific examples of the compound represented by Formula (B3) include the following compounds.

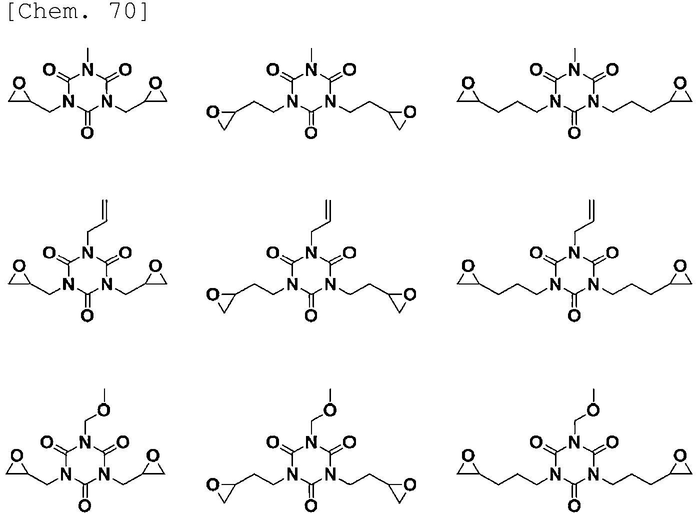

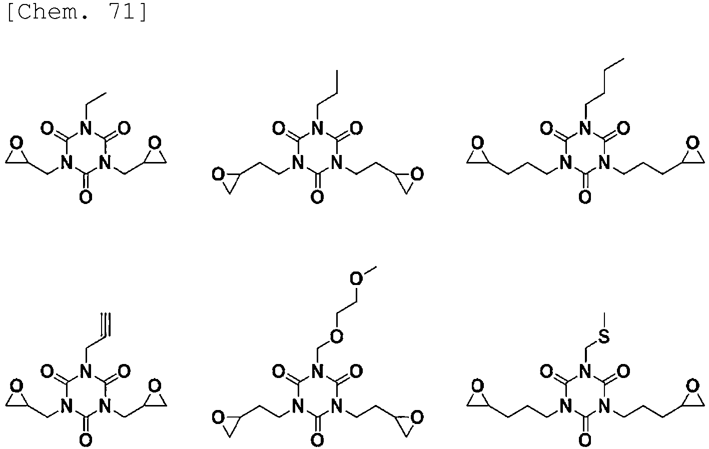

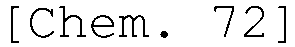

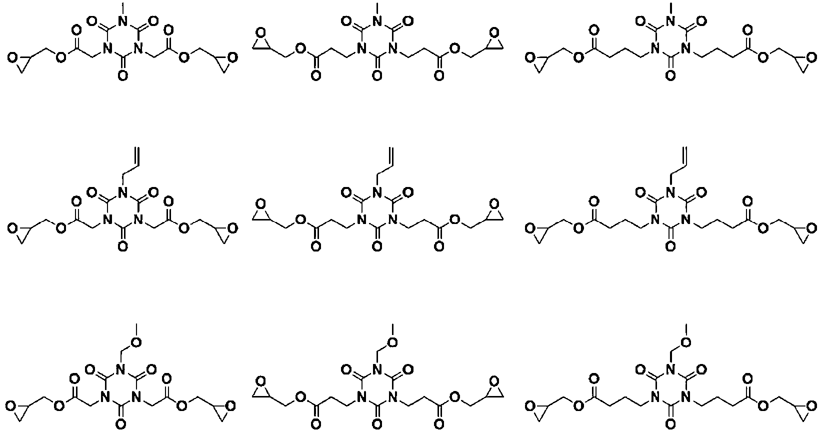

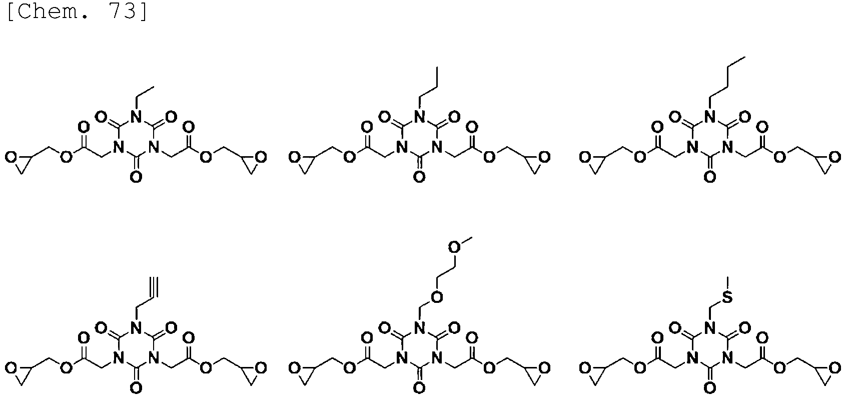

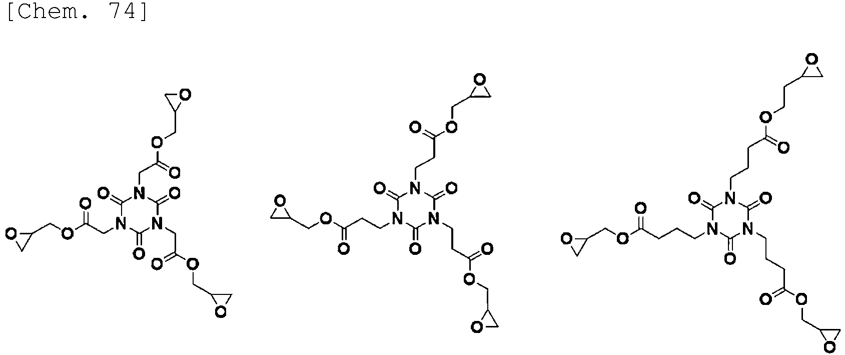

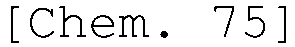

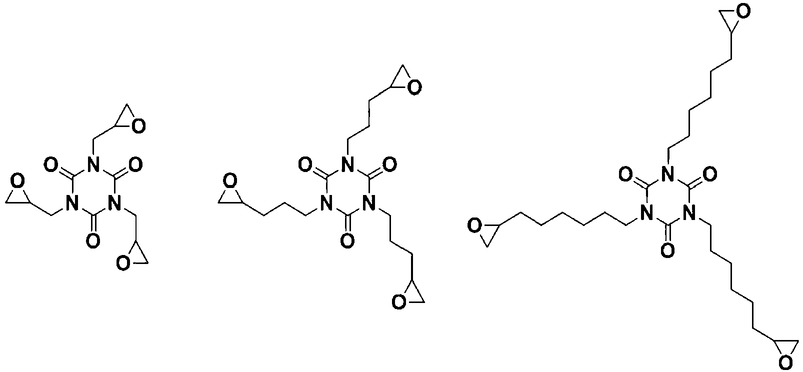

Specific examples of the compound represented by Formula (B4) include the following compounds.

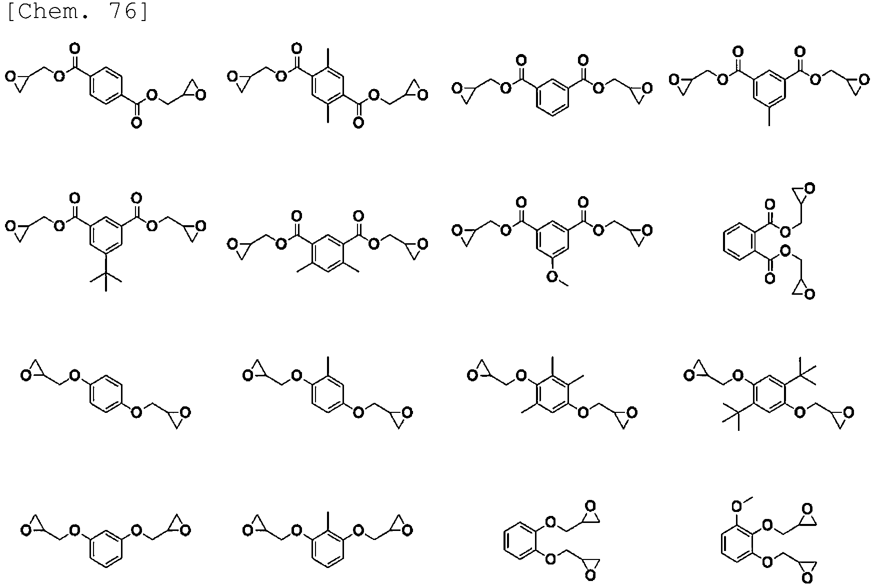

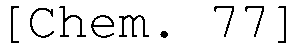

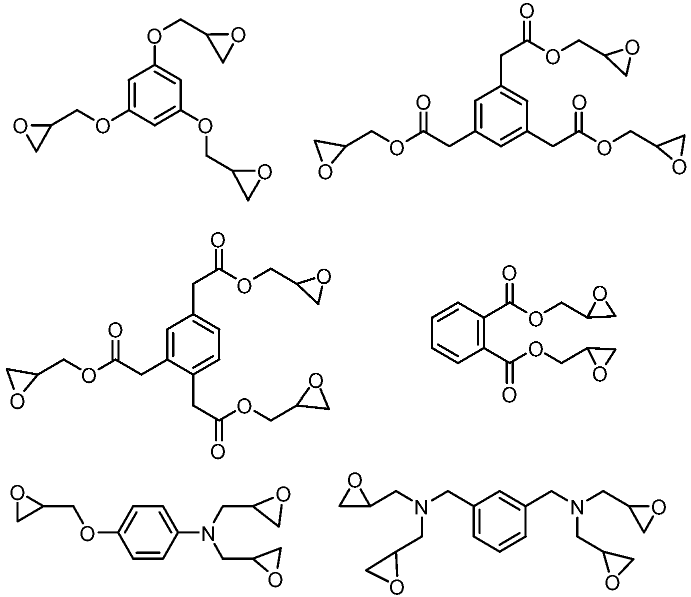

Specific examples of the compound represented by Formula (B5) include the following compounds.

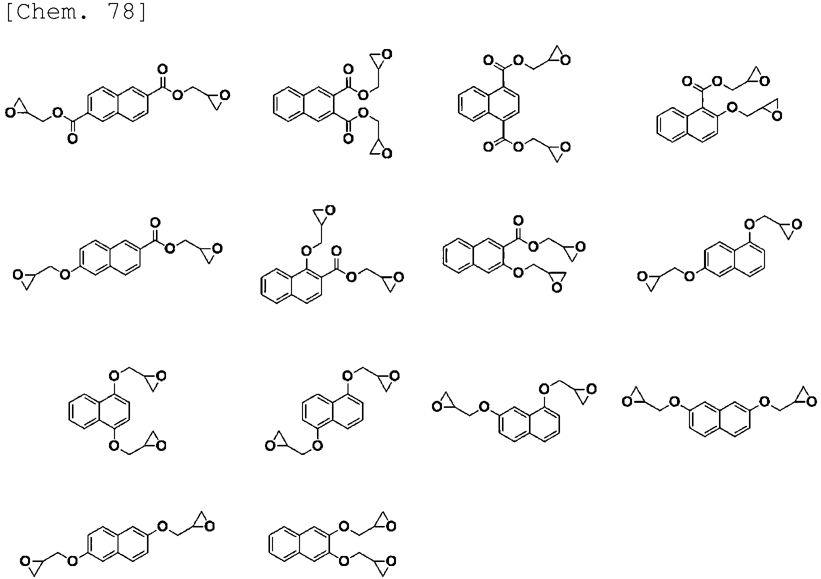

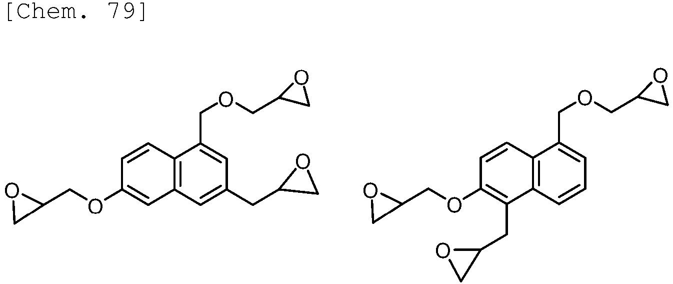

Specific examples of the compound represented by Formula (B6) include the following compounds.

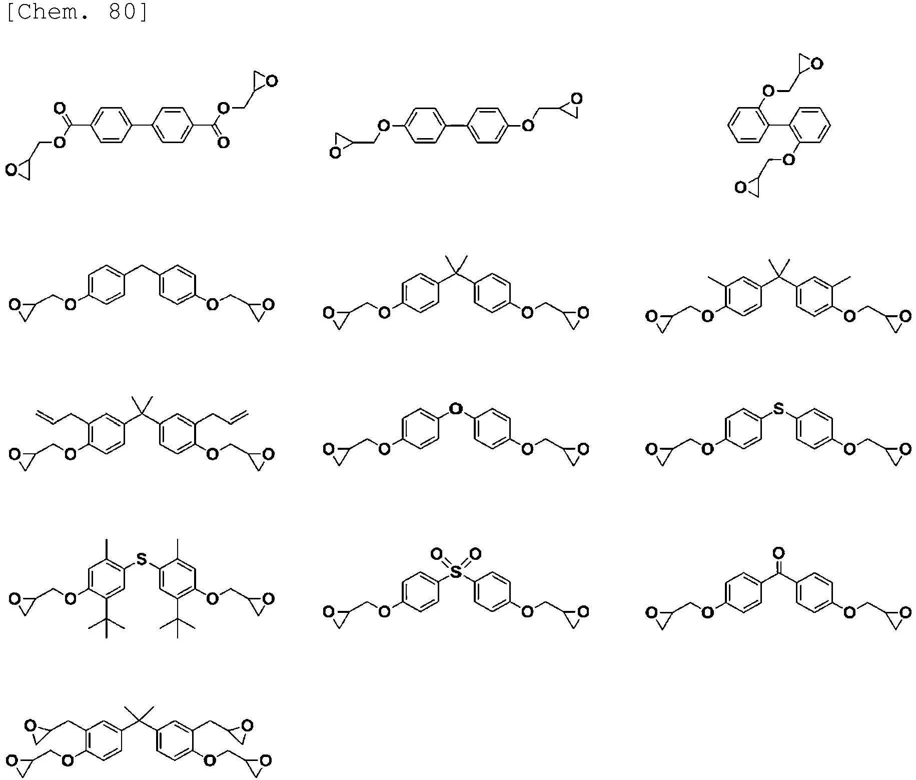

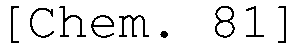

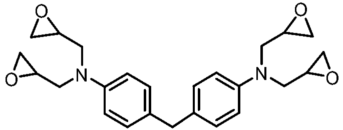

Specific examples of the compound represented by Formula (B7) include the following compounds.

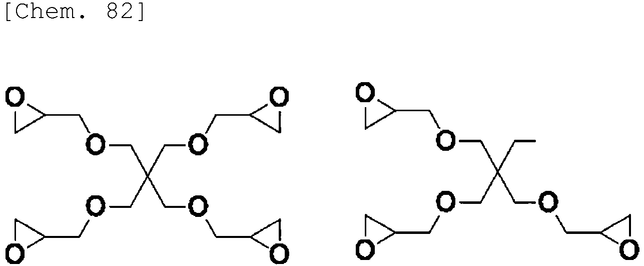

Specific examples of the compound represented by Formula (B8) or (B9) include the following compounds.

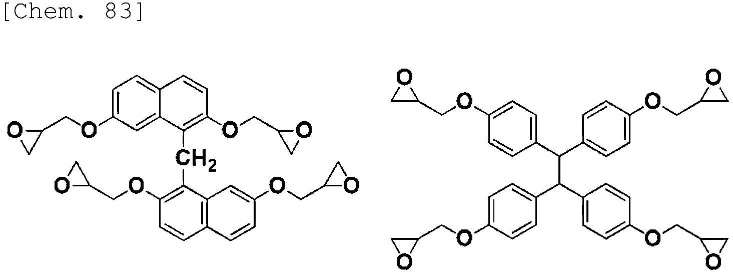

Specific examples of the compound represented by Formula (B10) include the following compounds.

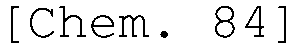

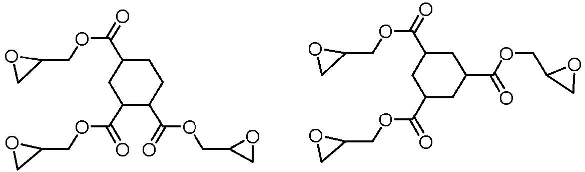

Specific examples of the compound represented by Formula (B11) include the following compounds.

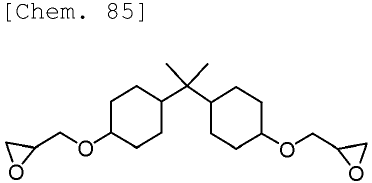

Specific examples of the compound represented by Formula (B12) include the following compounds.

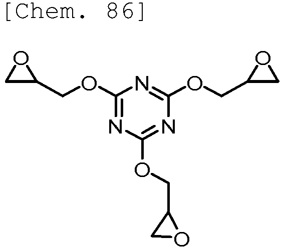

Specific examples of the compound represented by Formula (B13) include the following compounds.

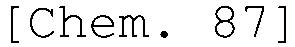

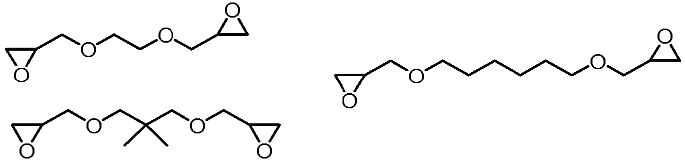

Specific examples of the compound represented by Formula (B14) include the following compounds.

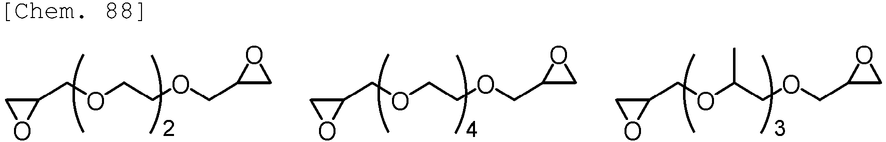

Specific examples of the compound represented by Formula (B15) include the following compounds.

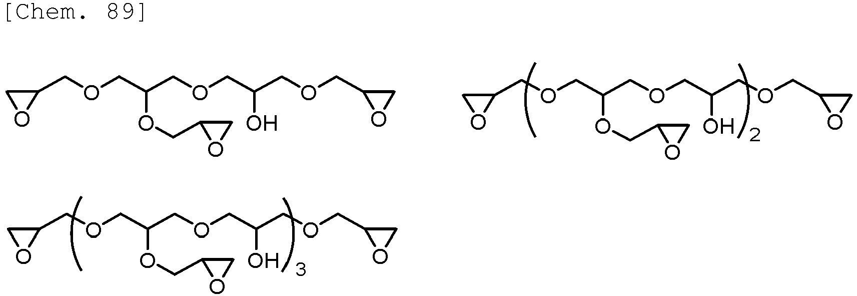

Other examples of the compound (B-1) include the following compounds.

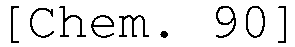

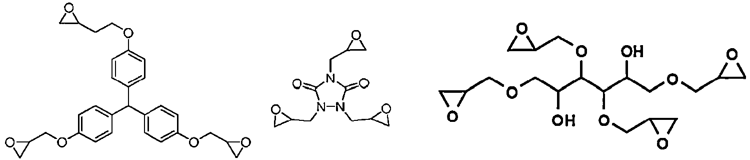

### <<Compound (B-2)>>

The compound (B-2) has a polymerizable multiple bond.

The compound (B-2) is a compound that is reactive with an epoxy group. In other words, the compound (B-2) has a group that is reactive with an epoxy group.

The number of polymerizable multiple bonds in the compound (B-2) may be 1 or 2 or more, but is preferably 1.

As the group having a polymerizable multiple bond in the compound (B-2), from the viewpoint of more suitably obtaining the effects of the present invention, a group represented by the above-described Formula (B-I) and a group represented by the above-described Formula (B-II) are preferable.

The number of "groups reactive with an epoxy group" in the compound (B-2) may be 1 or 2 or more, but is preferably 1.

Examples of the group reactive with an epoxy group include a carboxy group, an amino group, a phenolic hydroxy group, and an acid dianhydride group.

The compound (B-2) may or may not have a ring structure, but preferably does not have a ring structure. Examples of the ring structure include an aliphatic ring and an aromatic ring.

Examples of the compound (B-2) include a compound represented by the following Formulae (B-2-1) to (B-2-6).

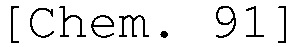

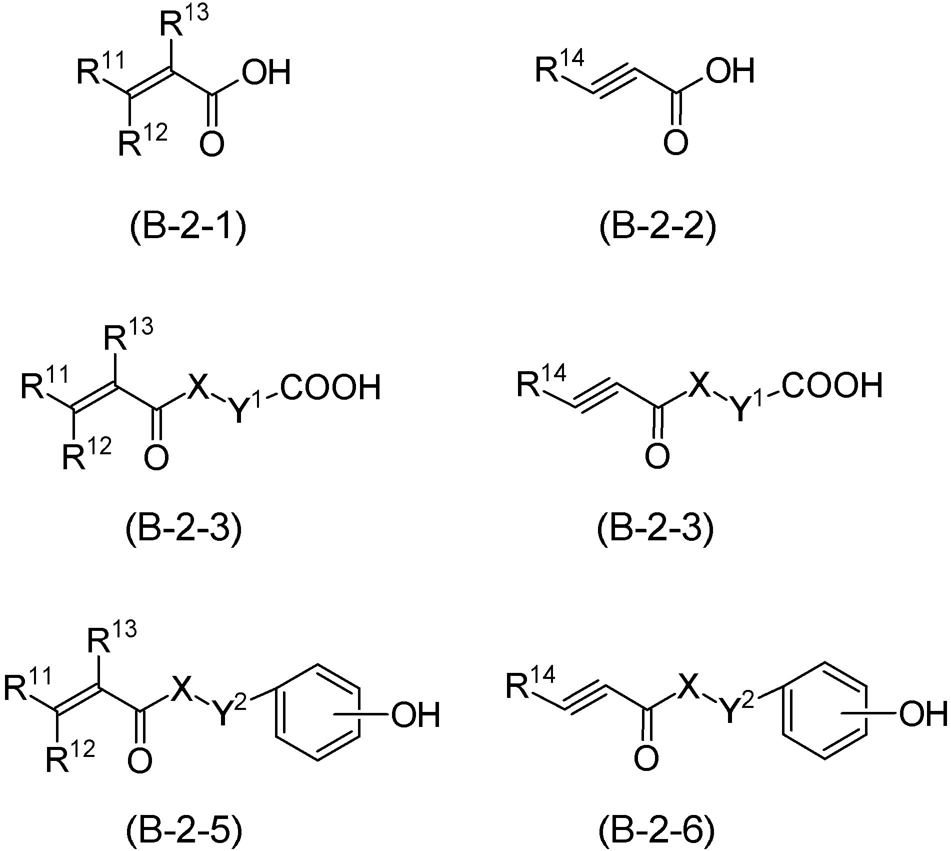

(In Formulae (B-2-1) to (B-2-6), R¹¹ to R¹⁴ have the same meanings as R¹¹ to R¹⁴ in Formulae (B-I) and (B-II), respectively.

X represents -O- or -N(R)- (R represents a hydrogen atom or an alkyl group having 1 to 6 carbon atoms).

Y¹'s each independently represent an organic group having 1 to 10 carbon atoms.

Y²'s each independently represent a single bond or an organic group having 1 to 6 carbon atoms.)

The organic group having 1 to 10 carbon atoms in Y¹ may or may not have a heteroatom.

The organic group having 1 to 10 carbon atoms in Y¹ may or may not have an ester bond.

Examples of the organic group having 1 to 10 carbon atoms in Y¹ include an alkylene group having 1 to 10 carbon atoms. The alkylene group may be linear, branched, or cyclic, or may be a combination of two or more of these.

The organic group having 1 to 6 carbon atoms in Y² may or may not have a heteroatom.

Examples of the organic group having 1 to 6 carbon atoms in Y² include an alkylene group having 1 to 6 carbon atoms. The alkylene group may be linear, branched, or cyclic, or may be a combination of two or more of these.

Specific examples of the compound (B-2) include the following compounds.

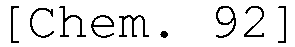

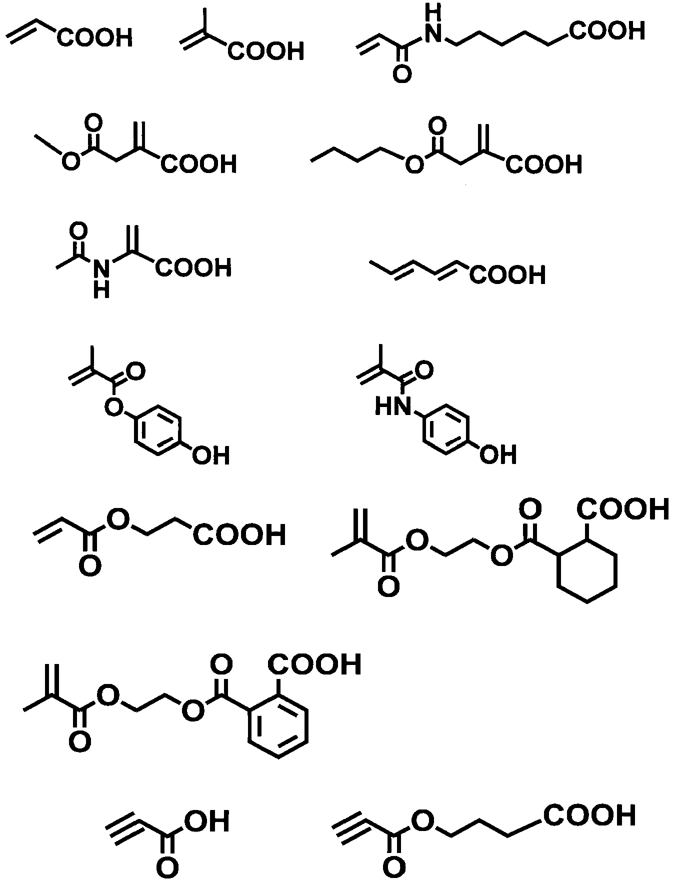

Among them, acrylic acid and methacrylic acid are preferable as the compound (B-2) from the viewpoint of suitably obtaining the effect of the present invention.

The reaction of the reactant containing the compound (B-1) and the compound (B-2) may be performed, for example, in the presence of a catalyst. The catalyst is, for example, a quaternary phosphonium salt such as tetrabutylphosphonium bromide or ethyltriphenylphosphonium bromide, or a quaternary ammonium salt such as benzyltriethylammonium chloride. As the amount of the catalyst used, an appropriate amount can be selected and used from a range of 0.1 to 10 mass% relative to the total mass of a reaction raw material used in the reaction. As the temperature and time for the reaction, for example, optimum conditions can be selected from a range of 50 to 160°C and a range of 2 to 50 hours.

The compounding ratio of the compounds (B-1) and (B-2) in the reaction is preferably such that the compounding ratio of a group reactive with an epoxy group in the compound (B-2) is 1 mol or more, and more preferably 1 mol or more and 1.5 mol or less, relative to 1 mol of an epoxy group in the compound (B-1).

### <<Compound (B-3)>>

The compound having a hydroxy group (B-3) is not particularly limited as long as the compound has a hydroxy group.

The number of hydroxy groups in the compound (B-3) is not particularly limited, and may be 1 or 2 or more, but is preferably 3 or more, and more preferably 3 to 6.

The compound (B-3) having a hydroxy group may have, for example, an epoxy group or may not have an epoxy group.

The compound (B-3) having a hydroxy group may have, for example, an amino group (-NH₂) or may not have an amino group (-NH₂).

Examples of the compound (B-3) include a compound having 3 hydroxy groups, a compound having 4 hydroxy groups, a compound having 5 hydroxy groups, a compound having 6 hydroxy groups, and a compound having 8 hydroxy groups.

Examples of the compound having three hydroxy groups include trimethylolpropane, trimethylolbutane, 2,3-di(2'-hydroxyethyl)-cyclohexan-1-ol, hexane-1,2,6-triol, 1,1,1-tris(hydroxymethyl)ethane, 3-(2'-hydroxyethoxy)propane-1,2-diol, 3-(2'-hydroxypropoxy)-propane-1,2-diol, 2-(2'-hydroxyethoxy)-hexane-1,2-diol, 6-(2'-hydroxypropoxy)-hexane-1,2-diol, 1,1,1-tris-[(2'-hydroxyethoxy)-methyl]ethane, 1,1,1-tris-[(2'-hydroxypropoxy)-methyl]-propane, 1,1,1-tris-(4'-hydroxyphenyl)ethane, 1,1,1-tris-(hydroxyphenyl)-propane, 1,1,5-tris-(hydroxyphenyl)-3-methylpentane, and tris(hydroxymethyl)aminomethane.

Examples of the compound having four hydroxy groups include: diglycerol, di(trimethylolpropane), pentaerythritol, and 1,1,4-tris(dihydroxyphenyl)butane.

Examples of the compound having five hydroxy groups include triglycerol.

Examples of the compound having six hydroxy groups include dipentaerythritol.

Examples of the compound having eight hydroxy groups include tripentaerythritol.

The molecular weight of the compound (B-3) is not particularly limited, but is preferably 500 or less.

### <<Compound (B-4)>>

The compound (B-4) has a polymerizable multiple bond.

The compound (B-4) is a compound reactive with a hydroxy group. In other words, the compound (B-4) has a group reactive with a hydroxy group.

When the compound (B-3) has a functional group other than a hydroxy group, the group reactive with a hydroxy group in the compound (B-4) may be reactive with the functional group.

The number of polymerizable multiple bonds in the compound (B-4) may be 1 or 2 or more, but is preferably 1 or 2.

As the group having a polymerizable multiple bond in the compound (B-4), from the viewpoint of more suitably obtaining the effects of the present invention, a group represented by the above-described Formula (B-I) and a group represented by the above-described Formula (B-II) are preferable.

The number of "groups reactive with a hydroxy group" in the compound (B-4) may be 1 or 2 or more, but is preferably 1.

Examples of the group reactive with a hydroxy group include an isocyanate group.

Examples of the compound (B-4) include a compound represented by the following Formula (B-4-1).

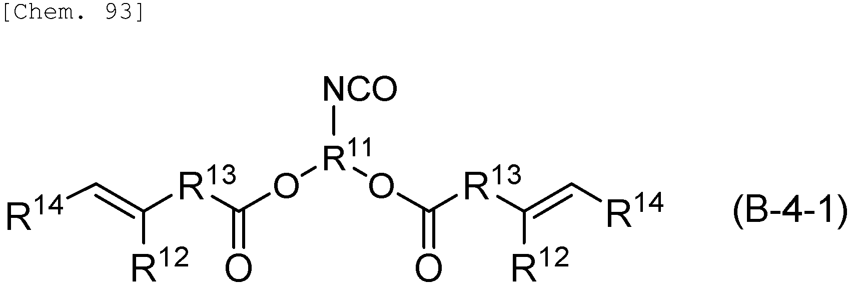

(In Formula (10), R¹¹ represents a linear or branched saturated aliphatic group having 1 to 10 carbon atoms. R¹² represents a hydrogen atom or a methyl group, R¹³ represents a single bond or a linear or branched alkylene group having 1 to 5 carbon atoms, and R¹⁴ represents a hydrogen atom, a linear or branched alkyl group having 1 to 6 carbon atoms, or an aryl group.)

Examples of the compound represented by Formula (B-4-1) include a compound represented by the following Formula (B-4-1-1).

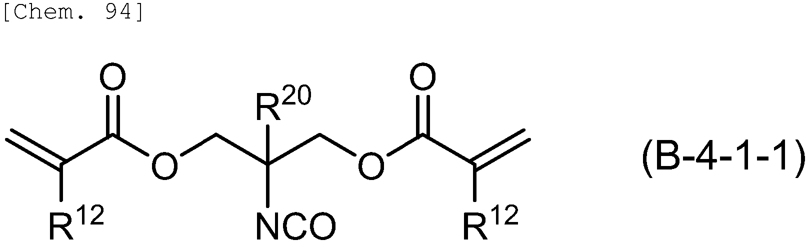

(In Formula (B-4-1-1), R¹² represents a hydrogen atom or a methyl group, and R²⁰ represents a hydrogen atom or an alkyl group having 1 to 10 carbon atoms.)

The compound (B-4) may be a commercially available product. Examples of the commercially available product include Karenz-BEI (manufactured by Resonac Corporation) and the like.

The reaction of the reactant containing the compound (B-3) and the compound (B-4) may be performed, for example, in the presence of a catalyst. The catalyst is, for example, an amine such as triethylamine. As the amount of the catalyst used, an appropriate amount can be selected and used from a range of 0.1 to 10 mass% relative to the total mass of a reaction raw material used in the reaction. As the temperature and time for the reaction, for example, optimum conditions can be selected from a range of 50 to 160°C and a range of 2 to 50 hours.

The compounding ratio of the compounds (B-3) and (B-4) in the reaction is preferably such that the compounding ratio of a group reactive with a hydroxy group in the compound (B-4) is 1 mol or more, and more preferably 1 mol or more and 1.5 mol or less, relative to 1 mol of a hydroxy group in the compound (B-3).

The content of the compound (B) in the resist underlayer film-forming composition is not particularly limited, but from the viewpoint of suitably obtaining the effect of the present invention. The content of the polymer (A) is preferably greater than the content of the compound (B) (less than 100 mass% relative to the polymer (A)). The content of the compound (B) in the resist underlayer film-forming composition is more preferably 3 mass% to 50 mass%, and particularly preferably 10 mass% to 40 mass% relative to the polymer (A).

The content of the compound (B) in the resist underlayer film-forming composition is not particularly limited, but from the viewpoint of suitably obtaining the effect of the present invention, the content is preferably 2 mass% to 40 mass%, and more preferably 5 mass% to 30 mass% relative to the film constituent components.

### <Solvent (C)>

The solvent (C) is not particularly limited, and may be water or an organic solvent.

Examples of the organic solvent include an alkylene glycol monoalkyl ether and a monocarboxylic acid ester of an alkylene glycol monoalkyl ether.

Examples of the alkylene group of the alkylene glycol monoalkyl ether include an alkylene group having 2 to 4 carbon atoms.

Examples of the alkyl group of the alkylene glycol monoalkyl ether include an alkyl group having 1 to 4 carbon atoms.

The number of carbon atoms of the alkylene glycol monoalkyl ether is, for example, 3 to 8.

Examples of the alkylene glycol monoalkyl ether include ethylene glycol monomethyl ether, ethylene glycol monoethyl ether, propylene glycol monomethyl ether, and propylene glycol monoethyl ether.

Examples of the alkylene group of the monocarboxylic acid ester of the alkylene glycol monoalkyl ether include an alkylene group having 2 to 4 carbon atoms.

Examples of the alkyl group of the monocarboxylic acid ester of the alkylene glycol monoalkyl ether include an alkyl group having 1 to 4 carbon atoms.

Examples of the monocarboxylic acid of the monocarboxylic acid ester of the alkylene glycol monoalkyl ether include a saturated monocarboxylic acid having 2 to 4 carbon atoms.

Examples of the saturated monocarboxylic acid having 2 to 4 carbon atoms include acetic acid, propionic acid, and butyric acid.

The number of carbon atoms of the monocarboxylic acid ester of an alkylene glycol monoalkyl ether is, for example, 5 to 10.

Examples of the monocarboxylic acid ester of an alkylene glycol monoalkyl ether include methyl cellosolve acetate, ethyl cellosolve acetate, propylene glycol monomethyl ether acetate, and propylene glycol propyl ether acetate.

Examples of other organic solvents include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide.

Among these solvents (C), an alkylene glycol monoalkyl ether and a monocarboxylic acid ester of an alkylene glycol monoalkyl ether are preferable.

One type of these solvents (C) can be used alone, or two or more types thereof can be used in combination.

The mass ratio of the organic solvent in the solvent (C) is not particularly limited, but is preferably 50 mass% to 100 mass%.

The content of the solvent (C) in the resist underlayer film-forming composition is not particularly limited, but is preferably 50 mass% to 99.99 mass%, more preferably 75 mass% to 99.95 mass%, and particularly preferably 90 mass% to 99.9 mass%.

### <Crosslinking agent (D)>

The crosslinking agent (D) is not particularly limited.

The crosslinking agent (D) has a structure different from those of the polymer (A) and the compound (B).

As the crosslinking agent (D), an aminoplast crosslinking agent and a phenoplast crosslinking agent are preferable.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent (D) include a compound having two or more structures shown below.

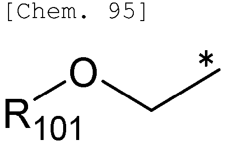

(In the structure, R₁₀₁ represents a hydrogen atom, an alkyl group having 1 to 4 carbon atoms, or an alkoxyalkyl group having 2 to 6 carbon atoms. * represents a bond.)

The bond is bonded to, for example, a nitrogen atom, a carbon atom constituting an aromatic hydrocarbon ring, or the like.

As R₁₀₁, a hydrogen atom, a methyl group, an ethyl group, or a group represented by the following structure is preferable.

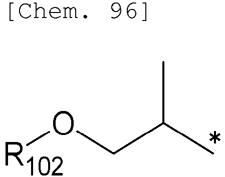

(In the structure, R₁₀₂ represents a hydrogen atom, a methyl group, or an ethyl group. * represents a bond.)

The crosslinking agent (D) is preferably a melamine compound, a guanamine compound, a glycoluril compound, a urea compound, or a compound having a phenolic hydroxy group. One type of these can be used alone, or two or more types thereof can be used in combination.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by the following Formula (1E).

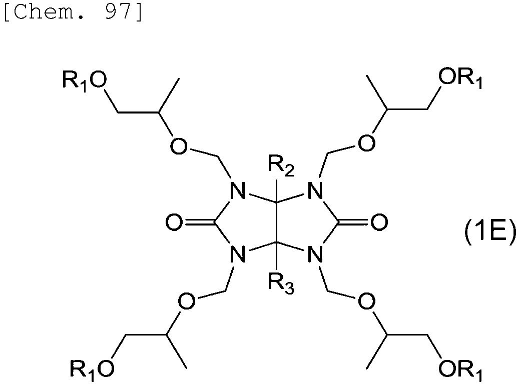

(In Formula (1E), four R₁'s each independently represent a methyl group or an ethyl group, and R₂ and R₃ each independently represent a hydrogen atom, an alkyl group having 1 to 4 carbon atoms, or a phenyl group.)

Examples of the glycoluril derivative represented by the above Formula (1E) include compounds represented by the following Formulae (1E-1) to (1E-6).

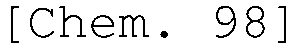

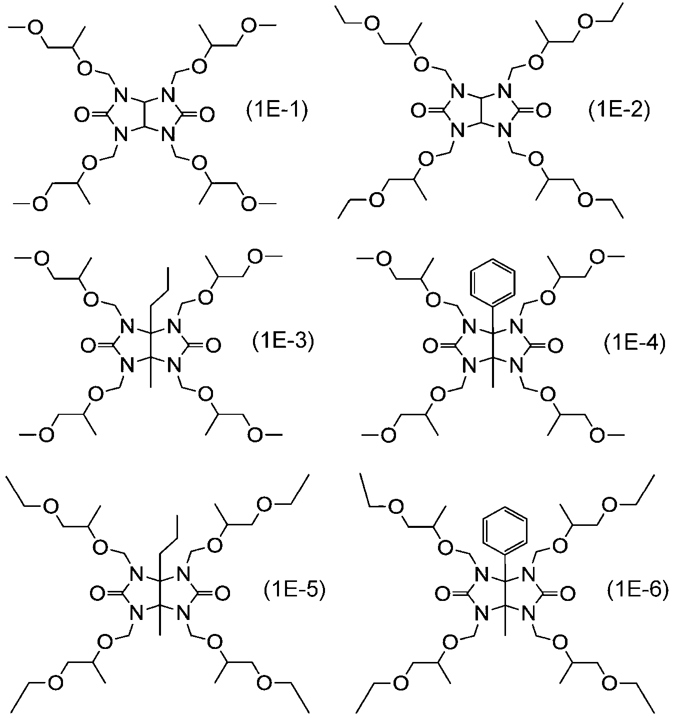

The glycoluril derivative represented by Formula (1E) is obtained by, for example, reacting a glycoluril derivative represented by the following Formula (2E) with at least one type of compound represented by the following Formula (3d).

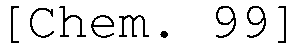

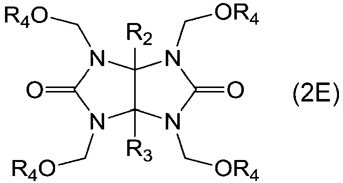

(In Formula (2E), R₂ and R₃ each independently represent a hydrogen atom, an alkyl group having 1 to 4 carbon atoms, or a phenyl group, and R₄'s each independently represent an alkyl group having 1 to 4 carbon atoms.)

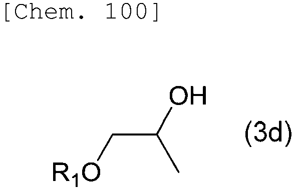

(In Formula (3d), R₁ represents a methyl group or an ethyl group.)

Examples of the glycoluril derivative represented by the above Formula (2E) include compounds represented by the following Formulae (2E-1) to (2E-4). Furthermore, examples of the compound represented by the above Formula (3d) include compounds represented by the following Formulae (3d-1) and (3d-2).

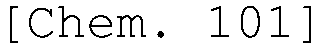

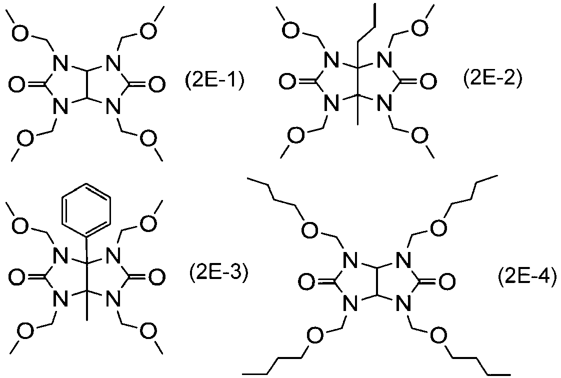

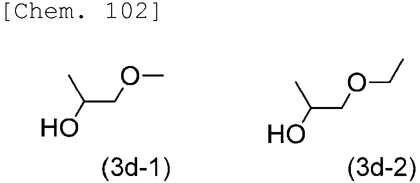

Examples of the urea compound include tetramethylolurea, tetramethoxymethylurea, a compound in which 1 to 4 methylol groups of tetramethylolurea are methoxymethylated or a mixture thereof, and tetramethoxyethylurea.

Examples of the compound having a phenolic hydroxy group include a compound represented by the following Formula (G-1) or (G-2).

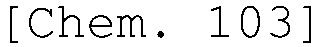

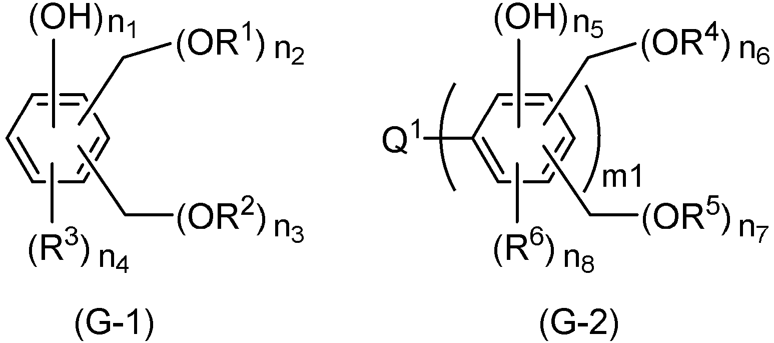

(In Formulae (G-1) and (G-2), Q¹ represents a single bond or an m1-valent organic group.

R¹ and R⁴ each represent an alkyl group having 2 to 10 carbon atoms or an alkyl group having 2 to 10 carbon atoms and having an alkoxy group having 1 to 10 carbon atoms.

R² and R⁵ each represent a hydrogen atom or a methyl group.

R³ and R⁶ each represent an alkyl group having 1 to 10 carbon atoms or an aryl group having 6 to 40 carbon atoms.

n₁ represents an integer that satisfies 1 ≤ n₁ ≤ 3, n₂ represents an integer that satisfies 2 ≤ n₂ ≤ 5, n₃ represents an integer that satisfies 0 ≤ n₃ ≤ 3, n₄ represents an integer that satisfies 0 ≤ n₄ ≤ 3, and represents an integer that satisfies 3 ≤ (n₁ + n₂ + n₃ + n₄) ≤ 6.

n₅ represents an integer that satisfies 1 ≤ n₅ ≤ 3, n₆ represents an integer that satisfies 1 ≤ n₆ ≤ 4, n₇ represents an integer that satisfies 0 ≤ n₇ ≤ 3, n₈ represents an integer that satisfies 0 ≤ n₈ ≤ 3, and represents an integer that satisfies 2 ≤ (n₅ + n₆ + n₇ + n₈) ≤ 5.

m1 represents an integer of 2 to 10.)

Further, examples of the compound having a phenolic hydroxy group include a compound represented by the following Formula (G-3) or (G-4).

The compound represented by Formula (G-1) or (G-2) may be obtained by a reaction of a compound represented by the following Formula (G-3) or (G-4) with a hydroxy groupcontaining ether compound or an alcohol having 2 to 10 carbon atoms.

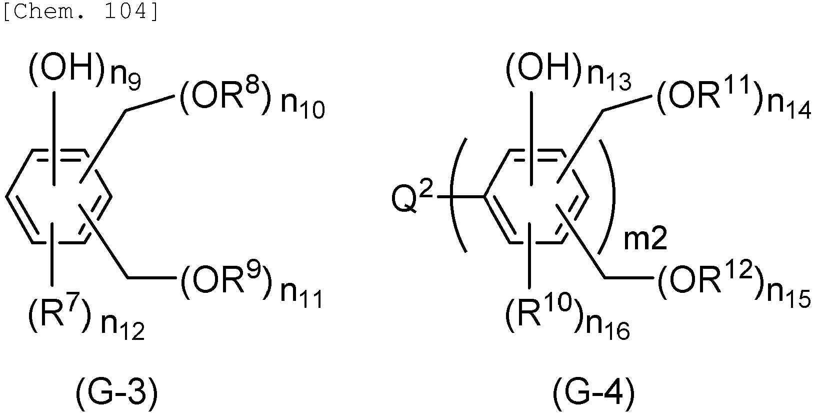

(In Formula (G-3) and Formula (G-4), Q² represents a single bond or an m2-valent organic group.

R⁸, R⁹, R¹¹, and R¹² each represent a hydrogen atom or a methyl group.

R⁷ and R¹⁰ each represent an alkyl group having 1 to 10 carbon atoms or an aryl group having 6 to 40 carbon atoms.

n₉ represents an integer that satisfies 1 ≤ n₉ ≤ 3, n₁₀ represents an integer that satisfies 2 ≤ n₁₀ ≤ 5, n₁₁ represents an integer that satisfies 0 ≤ n₁₁ ≤ 3, n₁₂ represents an integer that satisfies 0 ≤ n₁₂ ≤ 3, and represents an integer that satisfies 3 ≤ (n₉ + n₁₀ + n₁₁ + n₁₂) ≤ 6.

n₁₃ represents an integer that satisfies 1 ≤ n₁₃ ≤ 3, n₁₄ represents an integer that satisfies 1 ≤ n₁₄ ≤ 4, n₁₅ represents an integer that satisfies 0 ≤ n₁₅ ≤ 3, and n₁₆ represents an integer that satisfies 0 ≤ n₁₆ ≤ 3, and an integer that satisfies 2 ≤ (n₁₃ + n₁₄ + n₁₅ + n₁₆) ≤ 5.

### m2 represents an integer of 2 to 10.)

Examples of the m2-valent organic group in Q² include an m2-valent organic group having 1 to 4 carbon atoms.

Examples of the compound represented by Formula (G-1) or (G-2) include the following compounds.

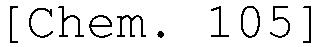

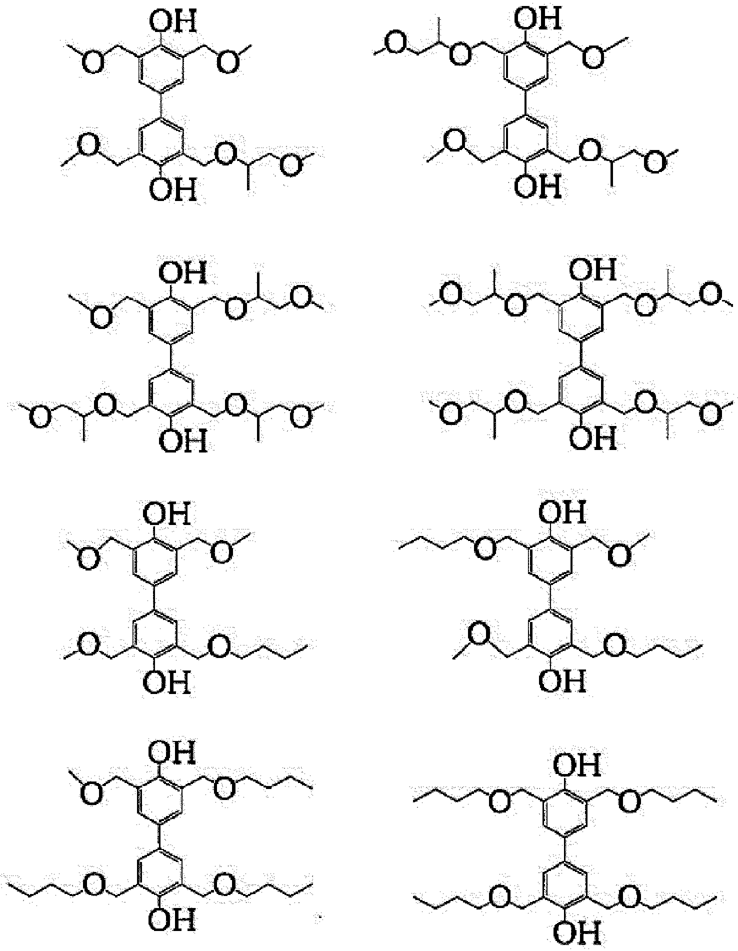

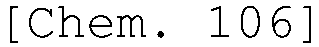

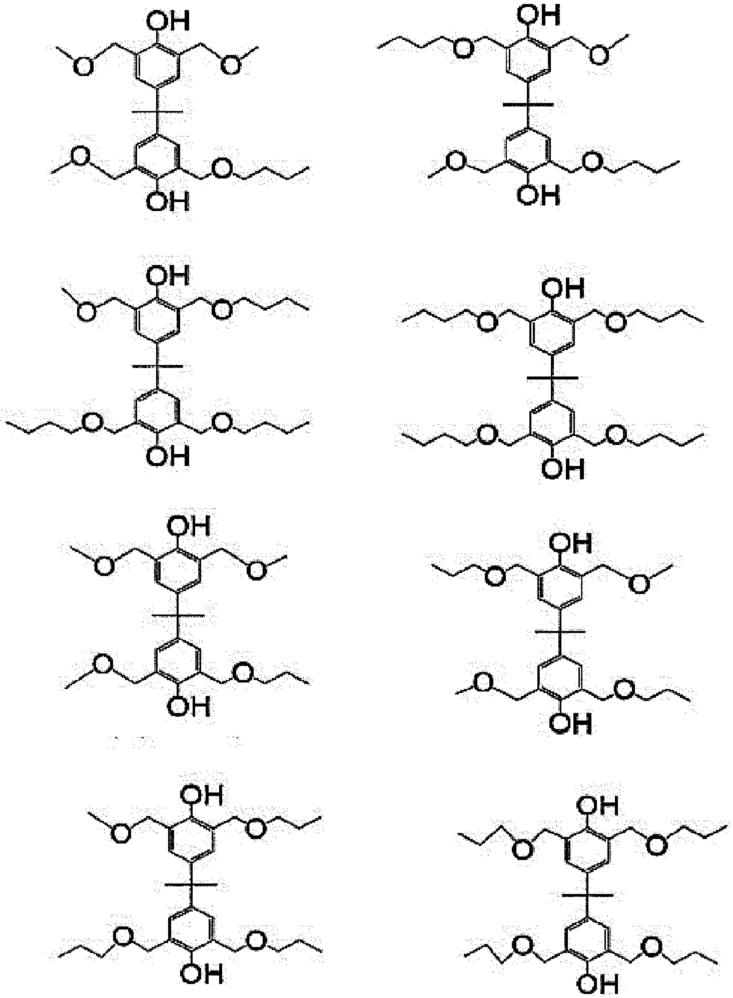

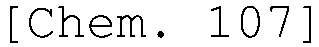

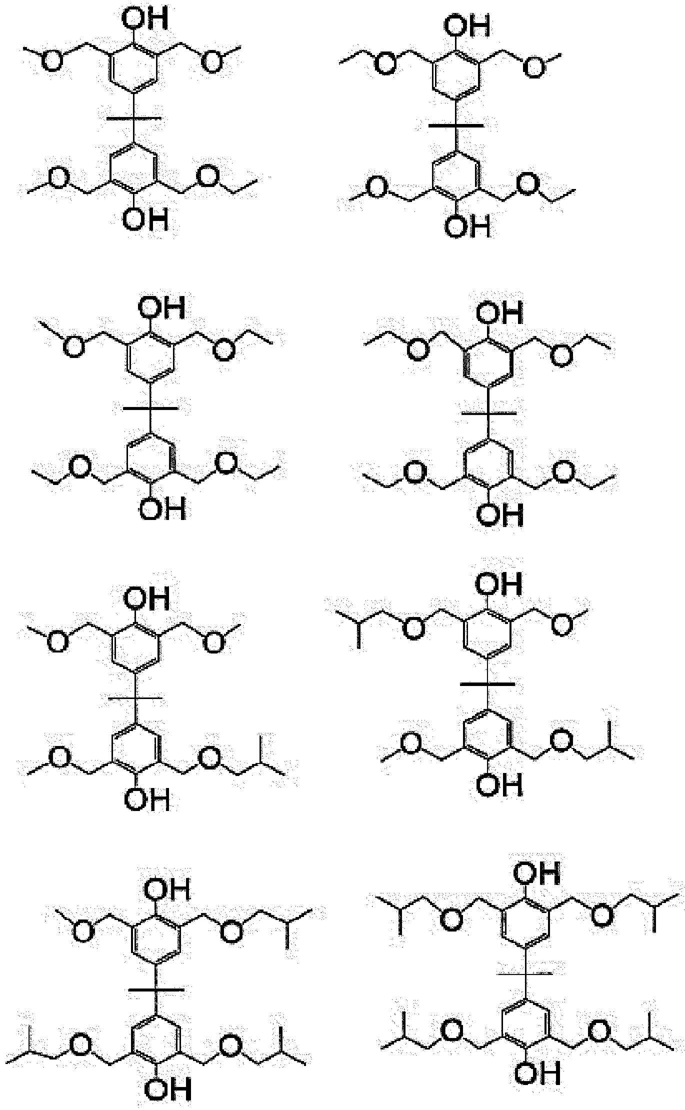

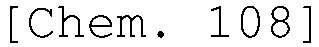

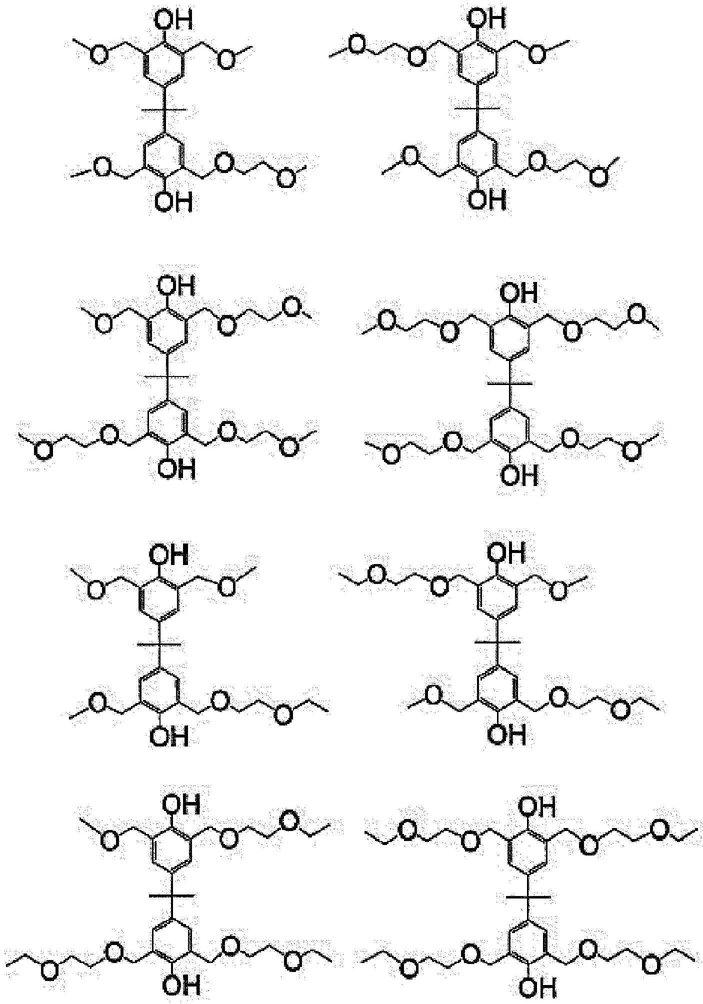

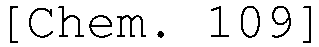

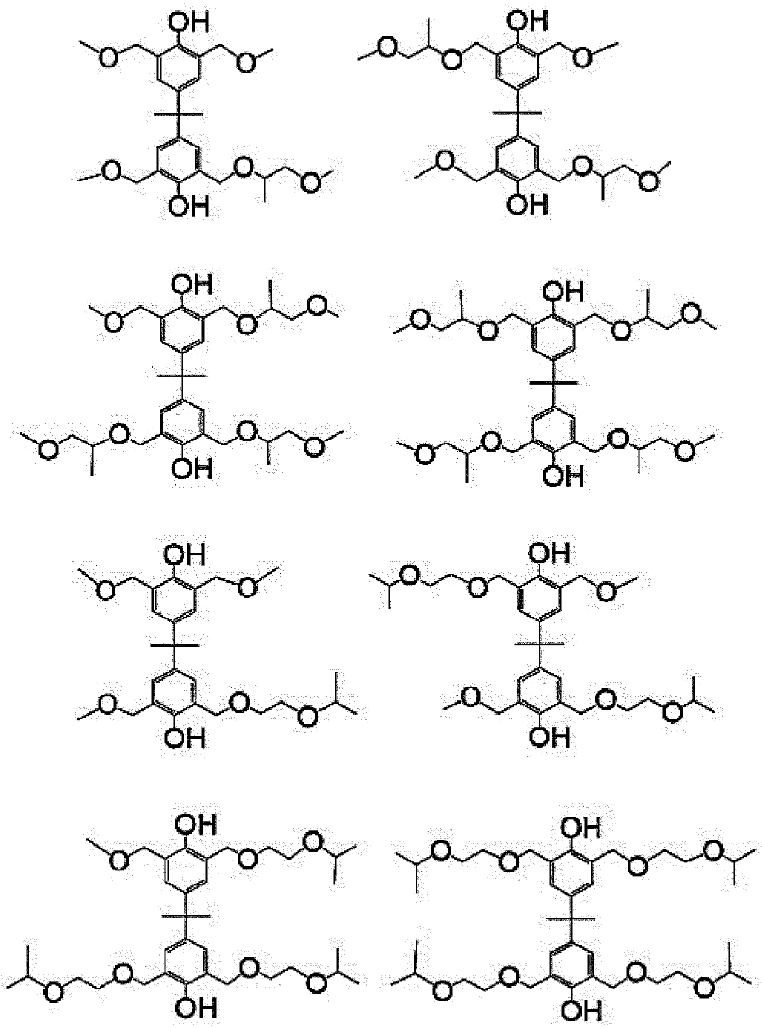

Examples of the compound represented by Formula (G-3) or Formula (G-4) include the following compounds.

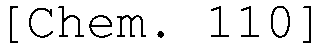

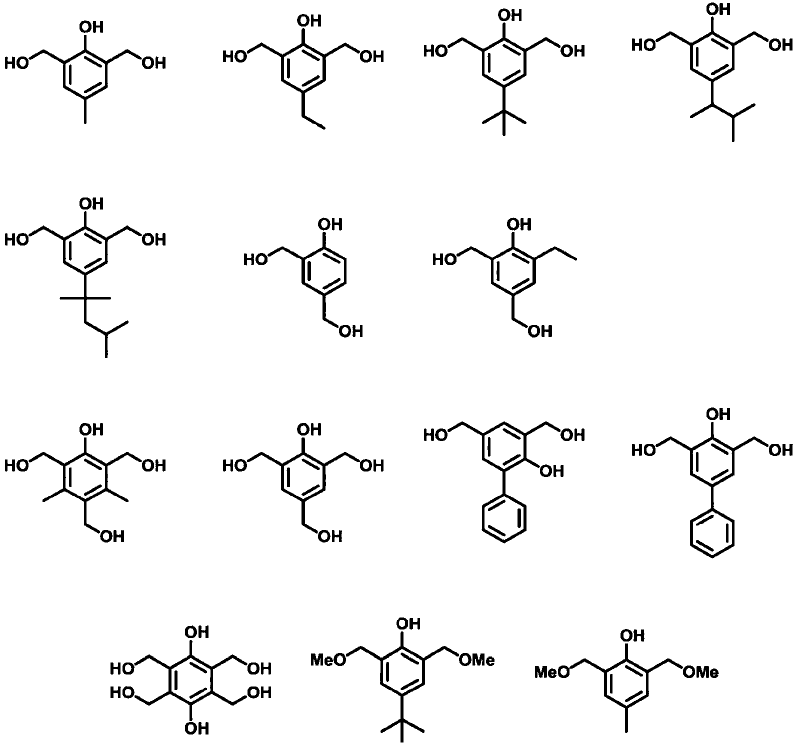

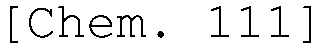

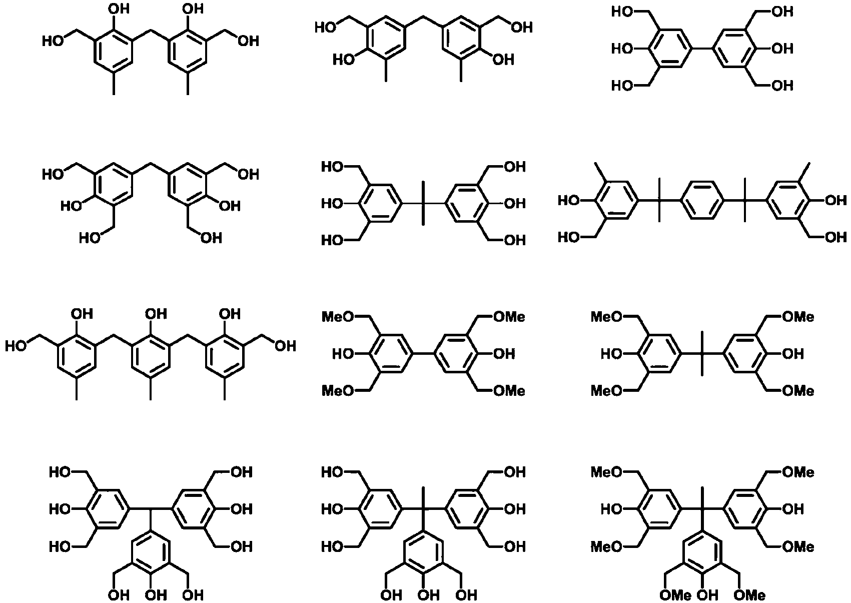

The compounds can be obtained as products of Asahi Yukizai Corporation and Honshu Chemical Industry Co., Ltd. Examples of the product include TMOM-BP (trade name) manufactured by Asahi Yukizai Corporation.

Among the compounds, the glycoluril compound is preferable. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferable, and tetramethoxymethyl glycoluril is more preferable.

The molecular weight of the crosslinking agent (D) is not particularly limited, but is preferably 500 or less.

The content of the crosslinking agent (D) in the resist underlayer film-forming composition is not particularly limited, but is, for example, 1 mass% to 70 mass%, and preferably 5 mass% to 60 mass% relative to the total of the polymer (A) and the compound (B).

### <Curing Catalyst (E)>

As the curing catalyst (E) contained as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenolsulfonate, pyridinium p-hydroxybenzenesulfonate (p-phenolsulfonic acid pyridinium salt), pyridinium-trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine-p-toluenesulfonate, N-methylmorpholine-p-hydroxybenzenesulfonate, and N-methylmorpholine-5-sulfosalicylate.

Examples of the photoacid generator include an onium salt compound, a sulfonimide compound, and a disulfonyldiazomethane compound.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compound include N-(trifluoromethanesulfonyloxy)succinimide, N-(nonafluoro normal butane sulfonyloxy)succinimide, N-(camphorsulfonyloxy)succinimide, and N-(trifluoromethanesulfonyloxy)naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

As the curing catalyst (E), only one type can be used, or two or more types can be used in combination.

In a case where the curing catalyst (E) is used, the content ratio of the curing catalyst (E) is, for example, 0.1 mass% to 50 mass%, and preferably 1 mass% to 30 mass% relative to the crosslinking agent (D).

### <Other Components>

To the resist underlayer film-forming composition, a surfactant can be further added in order to further improve the coatability against surface unevenness without generating a pinhole, a striation, and the like.

Examples of the surfactant include linear or branched alkylbenzenesulfonic acids (such as dodecylbenzenesulfonic acid); polyoxyethylene alkyl ethers such as polyoxyethylene lauryl ether, polyoxyethylene stearyl ether, polyoxyethylene cetyl ether, and polyoxyethylene oleyl ether; polyoxyethylene alkyl aryl ethers such as polyoxyethylene octylphenol ether and polyoxyethylene nonylphenol ether; polyoxyethylene/polyoxypropylene block copolymers; sorbitan fatty acid esters such as sorbitan monolaurate, sorbitan monopalmitate, sorbitan monostearate, sorbitan monooleate, sorbitan trioleate, and sorbitan tristearate; nonionic surfactants of polyoxyethylene sorbitan fatty acid esters and the like such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants such as EFTOP EF301, EF303, and EF352 (manufactured by TOHKEM PRODUCTS Corporation, trade names); MEGAFACE F171, F173, and R-30 (manufactured by DIC Corporation, trade names); Fluorad FC430 and FC431 (manufactured by Sumitomo 3M Limited, trade names); AsahiGuard AG710 and Surflon S-382, SC101, SC102, SC103, SC104, SC105, and SC106 (manufactured by AGC Corporation, trade names); and organosiloxane polymer KP341 (manufactured by Shin-Etsu Chemical Co., Ltd.).

The blending amount of such a surfactant is usually 2.0 mass% or less, and preferably 1.0 mass% or less relative to the total solid content of the resist underlayer film-forming composition.

These surfactants may be added alone, or two or more types thereof can also be added in combination.

The resist underlayer film-forming composition may contain a polymerization inhibitor (radical trapping agent) as necessary. Examples of the polymerization inhibitor include 2,6-diisobutylphenol, 3,5-di-tert-butylphenol, 3,5-di-tert-butylcresol, hydroquinone, hydroquinone monomethyl ether, pyrogallol, tert-butylcatechol, and 4-methoxy-1-naphthol.

The content of the polymerization inhibitor in the resist underlayer film-forming composition is not particularly limited, but is preferably 1 mass% or less relative to the solid content.

The amount of the solid content in the resist underlayer film-forming composition of the present invention, that is, the components excluding the solvent is, for example, 0.01 mass% to 10 mass%.

The resist underlayer film-forming composition is preferably used for EUV lithography.

The resist underlayer film-forming composition is preferably used for forming an underlayer film of a metal-containing resist.

### (Resist Underlayer Film)

The resist underlayer film of the present invention is a cured product of the above-described resist underlayer film-forming composition.

The resist underlayer film can be produced, for example, by applying the above-described resist underlayer film-forming composition onto a semiconductor substrate and baking the composition.

Examples of the semiconductor substrate to which the resist underlayer film-forming composition is applied include a silicon wafer, a germanium wafer, and a semiconductor wafer formed of a compound such as gallium arsenide, indium phosphide, gallium nitride, indium nitride, or aluminum nitride.

In the case of using the semiconductor substrate having a surface on which an inorganic film is formed, the inorganic film is formed by, for example, an atomic layer deposition (ALD) method, a chemical vapor deposition (CVD) method, a reactive sputtering method, an ion plating method, a vacuum deposition method, or a spin coating method (spin-on-glass, SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate with an appropriate application method using a spinner, a coater, or the like. Thereafter, baking is performed using a heating unit such as a hot plate to form a resist underlayer film. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes. More preferably, the baking temperature is 150°C to 300°C and the baking time is 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The method for measuring the film thickness of the resist underlayer film in the present specification is as follows.
- Measurement device name: Ellipsometric film thickness measurement device RE-3100 (SCREEN Holdings Co., Ltd.)
- Single wavelength ellipsometer (SWE) mode
- Arithmetic average of measurements at 8 points (for example, measurement at 8 points at intervals of 1 cm in an X direction of a wafer)

### (Laminate)

A laminate of the present invention includes a semiconductor substrate and the resist underlayer film of the present invention.

Examples of the semiconductor substrate include the semiconductor substrates described above.

The resist underlayer film is disposed, for example, on the semiconductor substrate.

### (Method for Producing Semiconductor Element and Pattern Forming Method)

The method for producing a semiconductor element of the present invention includes at least the following steps.
- a step of forming a resist underlayer film on a semiconductor substrate using the resist underlayer film-forming composition of the present invention; and
- a step of forming a resist film on the resist underlayer film

The pattern forming method of the present invention includes at least the following steps.
- a step of forming a resist underlayer film on a semiconductor substrate using the resist underlayer film-forming composition of the present invention;
- a step of forming a resist film on the resist underlayer film;
- a step of irradiating the resist film with light or an electron beam, and then developing the resist film to obtain a resist pattern; and
- a step of etching the resist underlayer film using the resist pattern as a mask.

The resist film is usually formed on the resist underlayer film.

The film thickness of the resist film is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, or 10 nm.

The resist film formed on the resist underlayer film by a known method (for example, application and baking of a resist composition) is not particularly limited as long as the resist film responds to light or an electron beam (EB) used for irradiation. Both a negative photoresist and a positive photoresist can be used.

In the present specification, a resist that responds to an EB is also referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Further, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

In addition, so-called resist compositions such as resist compositions described in WO 2019/188595, WO 2019/187881, WO 2019/187803, WO 2019/167737, WO 2019/167725, WO 2019/187445, WO 2019/167419, WO 2019/123842, WO 2019/054282, WO 2019/058945, WO 2019/058890, WO 2019/039290, WO 2019/044259, WO 2019/044231, WO 2019/026549, WO 2018/193954, WO 2019/172054, WO 2019/021975, WO 2018/230334, WO 2018/194123, JP 2018-180525 A, WO 2018/190088, JP 2018-070596 A, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO 2018/031896, JP 2019-113855 A, WO 2017/156388, WO 2017/066319, JP 2018-41099 A, WO 2016/065120, WO 2015/026482, JP 2016-29498 A, and JP 2011-253185 A, radiation-sensitive resin compositions, highresolution patterning compositions based on organometallic solutions, and metal-containing resist compositions can be used, but are not limited to these.

Examples of the resist composition include the following compositions.

An actinic ray-sensitive or radiation-sensitive resin composition containing a resin A having a repeating unit having an acid-decomposable group in which a polar group is protected by a protecting group to be removed by an action of an acid, and a compound represented by the following general Formula (121). 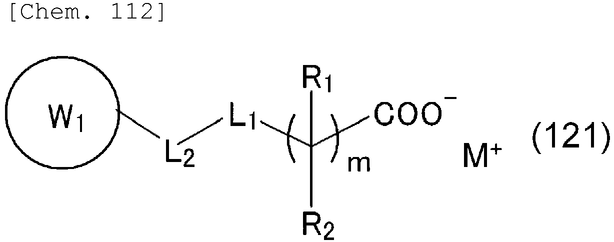 In general Formula (121), m represents an integer of 1 to 6.

R₁ and R₂ each independently represent a fluorine atom or a perfluoroalkyl group.

L₁ represents -O-, -S-, -COO-, -SO₂-, or -SO₃-.

L₂ represents an alkylene group which may have a substituent, or a single bond.

W₁ represents a cyclic organic group which may have a substituent.

M⁺ represents a cation.

A metal-containing film-forming composition for extreme ultraviolet or electron beam lithography, containing a compound having a metal-oxygen covalent bond and a solvent, in which metal elements constituting the compound belong to Periods 3 to 7 of Groups 3 to 15 of the periodic table.

A radiation-sensitive resin composition that contains: a polymer having a first structural unit represented by the following Formula (31) and a second structural unit represented by the following Formula (32) and containing an acid-dissociable group; and an acid generator.

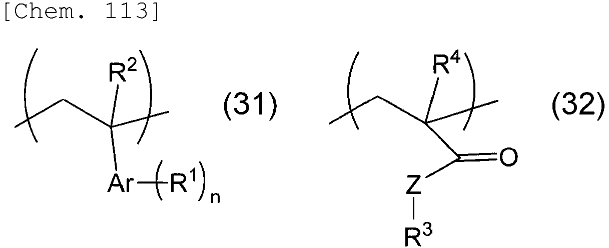

(In Formula (31), Ar represents a group obtained by removing (n + 1) hydrogen atoms from an arene having 6 to 20 carbon atoms. R¹ represents a hydroxy group, a sulfanyl group, or a monovalent organic group having 1 to 20 carbon atoms. n represents an integer of 0 to 11. When n is 2 or more, a plurality of R¹'s are identical to or different from each other. R² represents a hydrogen atom, a fluorine atom, a methyl group, or a trifluoromethyl group. In Formula (32), R³ represents a monovalent group having 1 to 20 carbon atoms and containing the acid-dissociable group. Z represents a single bond, an oxygen atom, or a sulfur atom. R⁴ represents a hydrogen atom, a fluorine atom, a methyl group, or a trifluoromethyl group.)

A resist composition that contains a resin (A1) including a structural unit having a cyclic carbonate structure, a structural unit represented by the following formula, and a structural unit having an acid-unstable group, and that contains an acid generator.

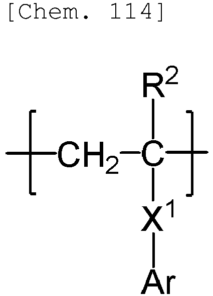

[In the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bond with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxy group.]

Examples of the resist film include the following resist film.

A resist film including a base resin including a repeating unit represented by the following Formula (a1) and/or a repeating unit represented by the following Formula (a2), and a repeating unit that generates an acid bonded to a polymer main chain by exposure.

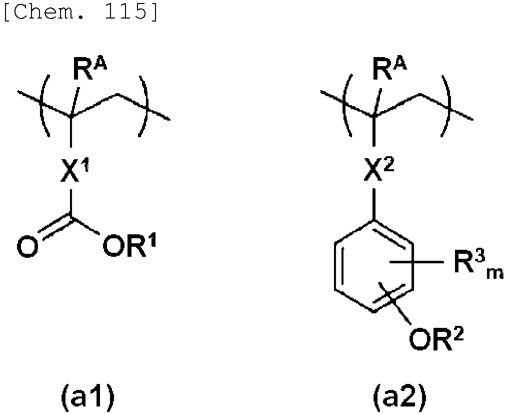

(In Formulae (a1) and (a2), R^{A}'s each independently represent a hydrogen atom or a methyl group. R1 and R² each independently represent a tertiary alkyl group having 4 to 6 carbon atoms. R3^{'}s each independently represent a fluorine atom or a methyl group. m represents an integer of 0 to 4. X1 represents a single bond, a phenylene group, a naphthylene group, or a linking group having 1 to 12 carbon atoms and including at least one type selected from an ester bond, a lactone ring, a phenylene group, and a naphthylene group. X2 represents a single bond, an ester bond, or an amide bond.)

Examples of the resist material include the following.

A resist material containing a polymer having a repeating unit represented by the following Formula (b1) or Formula (b2).

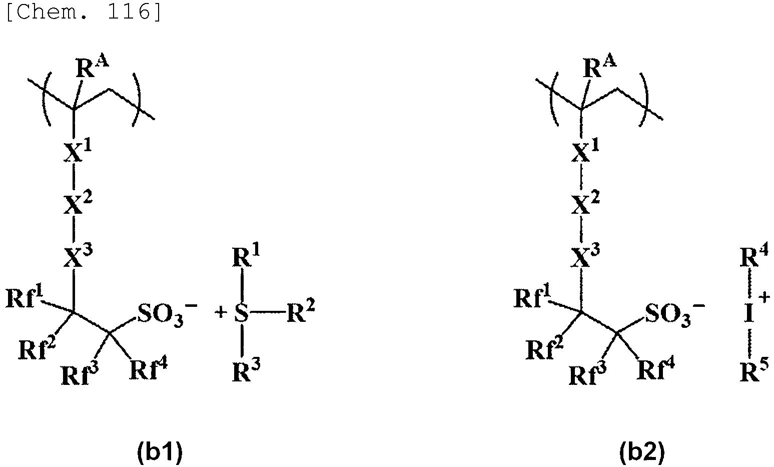

(In Formula (b1) and (b2), R^{A} represents a hydrogen atom or a methyl group. X1 represents a single bond or an ester group. X2 represents a linear, branched, or cyclic alkylene group having 1 to 12 carbon atoms or an arylene group having 6 to 10 carbon atoms, some methylene groups constituting the alkylene group are optionally substituted with an ether group, an ester group, or a lactone ringcontaining group, and at least one hydrogen atom constituting X² is substituted with a bromine atom. X3 represents a single bond, an ether group, an ester group, or a linear, branched, or cyclic alkylene group having 1 to 12 carbon atoms, and some methylene groups constituting the alkylene group are optionally substituted with an ether group or an ester group. Rf¹ to Rf⁴ each independently represent a hydrogen atom, a fluorine atom, or a trifluoromethyl group, and at least one of Rf¹ to Rf⁴ is a fluorine atom or a trifluoromethyl group. Further, Rf¹ and Rf² may be combined to form a carbonyl group. R¹ to R⁵ each independently represent a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, some or all hydrogen atoms of these groups are optionally substituted with a hydroxy group, a carboxy group, a halogen atom, an oxo group, a cyano group, an amide group, a nitro group, a sultone group, a sulfone group, or a sulfonium salt-containing group, and some methylene groups constituting these groups are optionally substituted with an ether group, an ester group, a carbonyl group, a carbonate group, or a sulfonic acid ester group. Further, R¹ and R² may be bonded to form a ring together with a sulfur atom to which R¹ and R² are bonded.)

A resist material containing a base resin including a polymer including a repeating unit represented by the following Formula (a).

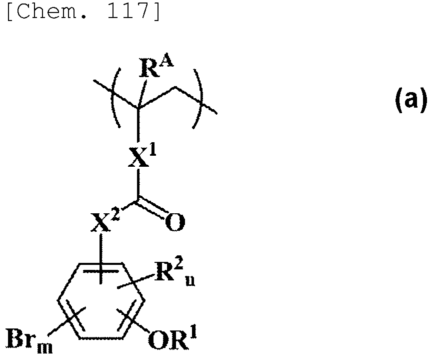

(In Formula (a), R^{A} represents a hydrogen atom or a methyl group. R¹ represents a hydrogen atom or an acid-unstable group. R² represents a linear, branched, or cyclic alkyl group having 1 to 6 carbon atoms or a halogen atom other than bromine. X1 represents a single bond, a phenylene group, or a linear, branched, or cyclic alkylene group which has 1 to 12 carbon atoms and may contain an ester group or a lactone ring. X2 represents -O-, -O-CH₂-, or -NH-. m represents an integer of 1 to 4. u represents an integer of 0 to 3. Here, m + u is an integer of 1 to 4.)

A resist composition which generates an acid by exposure and of which solubility in a developer is changed by an action of the acid, the resist composition including:
a base material component (A) of which solubility in a developer is changed by an action of an acid and a fluorine additive component (F) which exhibits decomposability in an alkaline developer, in which
the fluorine additive component (F) contains a fluororesin component (F1) having a constituent unit (f1) containing a base dissociable group and a constituent unit (f2) containing a group represented by the following general Formula (f2-r-1).

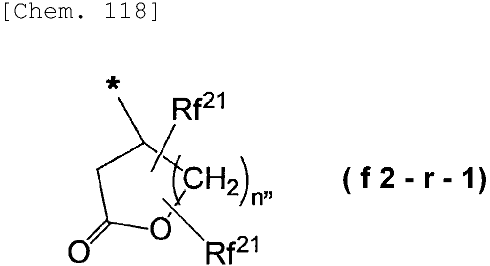

[In Formula (f2-r-1), Rf²¹'s each independently represent a hydrogen atom, an alkyl group, an alkoxy group, a hydroxy group, a hydroxyalkyl group, or a cyano group. n" represents an integer of 0 to 2. * represents a bond.]

The constituent unit (f1) includes a constituent unit represented by the following general Formula (f1-1) or a constituent unit represented by the following general Formula (f1-2).

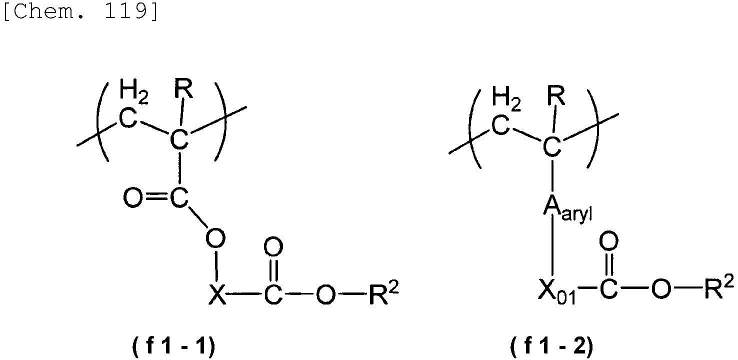

[In Formulae (f1-1) and (f1-2), R's each independently represent a hydrogen atom, an alkyl group having 1 to 5 carbon atoms, or a haloalkyl group having 1 to 5 carbon atoms. X represents a divalent linking group not having an acid-dissociable site. Aa_{ryl} represents a divalent aromatic ring group which may have a substituent. X₀₁ represents a single bond or a divalent linking group. R²'s each independently represent an organic group having a fluorine atom.]

The resist composition may be a metal-containing resist.

The metal-containing resist is also called a metal oxide resist (MOR), and typical examples thereof include a tin oxide-based resist.

Examples of the metal oxide resist material include a coating composition described in JP 2019-113855 A, which contains a metal oxo-hydroxo network having organic ligands via a metal-carbon bond and/or a metal carboxylate bond.

In an example of the metal-containing resist, a peroxo ligand is used as a radiation-sensitive stabilizing ligand. Details of the peroxo based metal oxo-hydroxo compounds are described, for example, in the Patent Literature cited in paragraph [0011] of JP 2019-532489 A. Examples of the Patent Literature include US 9,176,377 B2, US 2013/0224652 A1, US 9,310,684 B2, US 2016/0116839 A1, and US 15/291738 A.

A coating including a metal oxo-hydroxo network having an organic ligand via a metal-carbon bond and/or a metalcarboxylate bond.

An inorganic oxo/hydroxo-based composition.

A coating solution containing: an organic solvent; a first organometallic composition represented by the formula R_{z}SnO_{(2-(z/2)-(x/2))}(OH)ₓ (here, 0 < z ≤ 2 and 0 < (z + x) ≤ 4), the formula R'ₙSnX₄₋ₙ (here, n = 1 or 2), or a mixture thereof, in which R and R' independently represent a hydrocarbyl group having 1 to 31 carbon atoms and X represents a ligand having a hydrolysable bond to Sn or a combination of such ligands; and a hydrolysable metal compound represented by the formula MX'ᵥ (here, M represents a metal selected from Groups 2 to 16 in the periodic table, v is a number of v = 2 to 6, and X' represents a ligand having a hydrolysable M-X bond or a combination of such ligands).

A coating solution containing an organic solvent and a first organometallic compound represented by the formula RSnO_{(3/2-x/2)}(OH)ₓ (in the formula 0 < x < 3), in which the solution contains from about 0.0025 M to about 1.5 M of tin, R is an alkyl group or a cycloalkyl group having 3 to 31 carbon atoms, and the alkyl group or cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

Other examples of the metal-containing resist include compositions described in JP 2011-253185 A, WO 2015/026482 A, WO 2016/065120 A, WO 2017/066319 A, WO 2017/156388 A, WO 2018/031896 A, JP 2020-122959 A, JP 2020-122960 A, WO 2019/099981 A, WO 2019/199467 A, WO 2019/195522 A, WO 2019/195522 A, WO 2020/210660 A, WO 2021/011367 A, and WO 2021/016229 A.

These contents are incorporated herein by reference to the same extent as if fully set forth herein.

The method for forming the metal-containing resist film from the metal-containing resist is not particularly limited, and examples thereof include a method in which a coating-type resist material (metal-containing resist film-forming composition) as the metal-containing resist is applied and baked.

The metal-containing resist film may be formed by vapor deposition. The method for forming the metal-containing resist film by vapor deposition is, for example, a method described in JP 2017-116923 A. The entire contents of Japanese Patent Investigation Publication JP 2017-116923 A are incorporated herein by reference to the same extent as if fully set forth herein. In JP 2017-116923 A, the metal-containing resist film in the present invention is referred to as a metal oxide-containing film.

Irradiation with light or an electron beam is performed, for example, through a mask (reticle) for formation of a predetermined pattern. For example, i-line, KrF excimer laser, ArF excimer laser, extreme ultraviolet (EUV), or electron beam (EB) is used. The resist underlayer film-forming composition of the present invention is preferably applied for electron beam (EB) or extreme ultraviolet (EUV: 13.5 nm) irradiation, and more preferably applied for extreme ultraviolet (EUV) exposure.

The irradiation energy of the electron beam and the exposure amount of light are not particularly limited.

Post exposure bake (PEB) may be performed after irradiation with light or an electron beam and before development.

The baking temperature is not particularly limited, but is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

In the development, for example, an alkaline developer or an organic solvent is used.

The developing temperature is, for example, 5°C to 50°C.

The developing time is, for example, 10 seconds to 300 seconds.

As the alkaline developer, for example, an aqueous solution of an alkali such as an inorganic alkali (for example, sodium hydroxide, potassium hydroxide, sodium carbonate, sodium silicate, sodium metasilicate, or ammonia water), a primary amine (for example, ethylamine or n-propylamine), a secondary amine (for example, diethylamine or di-n-butylamine), a tertiary amine (for example, triethylamine or methyldiethylamine), an alcoholamine (for example, dimethylethanolamine or triethanolamine), a quaternary ammonium salt (for example, tetramethylammonium hydroxide, tetraethylammonium hydroxide, or choline), or a cyclic amine (for example, pyrrole or piperidine) can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferable, and an aqueous solution of tetramethylammonium hydroxide and an aqueous solution of choline are more preferable. Furthermore, a surfactant or the like can also be added to these developers. It is also possible to use a method in which development is performed with an organic solvent such as butyl acetate in place of the alkaline developer and a portion where the alkali dissolution rate of the photoresist is not improved is developed.

An organic solvent can be used as the developer of the metal-containing resist, and development is performed with the developer (solvent) after irradiation with light or an electron beam. As a result, for example, when a metal-containing negative resist film is used, the metal-containing resist film in an unexposed portion is removed, and a pattern of the metal-containing resist film is formed.

Examples of the developer (organic solvent) include methyl acetate, butyl acetate, ethyl acetate, isopropyl acetate, amyl acetate, isoamyl acetate, ethyl methoxyacetate, ethyl ethoxyacetate, propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, and propyl-3-methoxypropionate. Furthermore, a surfactant or the like can also be added to these developers.

Subsequently, the resist underlayer film is etched using the formed resist pattern as a mask. The etching may be dry etching or wet etching, but is preferably dry etching.

When the inorganic film is formed on the surface of a semiconductor substrate used, the surface of the inorganic film is exposed, and when the inorganic film is not formed on the surface of a semiconductor substrate used, the surface of the semiconductor substrate is exposed. Then, a semiconductor element can be produced through a step of processing the semiconductor substrate with a known method (dry etching method or the like).

### Examples

Next, the contents of the present invention will be specifically described with reference to Examples, but the present invention is not limited thereto.

The weight-average molecular weights of the polymers shown in Synthesis Examples 1 to 8 below are measurement results by gel permeation chromatography (hereinafter abbreviated as GPC). In the measurement, a GPC apparatus manufactured by Tosoh Corporation was used, and measurement conditions and the like are as follows.
GPC column: Shodex KF803L, Shodex KF802, Shodex KF801 [registered trademark] (Showa Denko K.K.)
Column temperature: 40°C
Solvent: N,N-dimethylformamide (DMF)
Flow amount: 0.6 ml/min
Standard sample: Polystyrene (manufactured by Tosoh Corporation)

### <Synthesis Example 1>

8.00 g of monoallyl diglycidyl isocyanuric acid (manufactured by Shikoku Chemicals Corporation), 5.45 g of diethylbarbituric acid (manufactured by Tokyo Chemical Industry Co., Ltd.), and 0.48 g of tetrabutylphosphonium bromide (manufactured by Tokyo Chemical Industry Co., Ltd.) were added to 56.00 g of propylene glycol monomethyl ether in a reaction vessel and dissolved. After replacing the atmosphere in the reaction vessel with nitrogen, the mixture was reacted under heating at reflux for 10 hours to obtain a solution containing Polymer 1. The polymer solution does not cause cloudiness or the like even when cooled to room temperature, and has good solubility in propylene glycol monomethyl ether. As a result of GPC analysis, the obtained Polymer 1 had a weight-average molecular weight of 10,000 in terms of standard polystyrene. The polymer obtained in this Synthesis Example has structural units represented by the following Formulae (1a) and (1b).

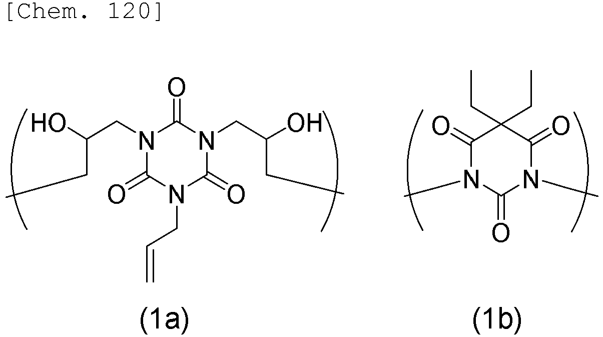

### <Synthesis Example 2>

5.00 g of methyl methacrylate (manufactured by Tokyo Chemical Industry Co., Ltd.), 7.33 g of 2-hydroxypropyl methacrylate (manufactured by FUJIFILM Wako Pure Chemical Corporation), and 0.50 g of azobisisobutyronitrile (manufactured by Tokyo Chemical Industry Co., Ltd.) were dissolved in 29.94 g of propylene glycol monomethyl ether (hereinafter sometimes referred to as "PGME") in a reaction vessel, and then the resulting mixture was added to 21.39 g of PGME maintained at 130°C by heating and reacted for 16 hours to obtain a solution containing a polymer 2. The polymer solution does not cause cloudiness or the like even when cooled to room temperature, and has good solubility in propylene glycol monomethyl ether. As a result of GPC analysis, the obtained polymer 2 had a weight-average molecular weight of 7,900 in terms of standard polystyrene. The polymer obtained in this Synthesis Example has a structural unit represented by the following Formulae (1c) and (1d).

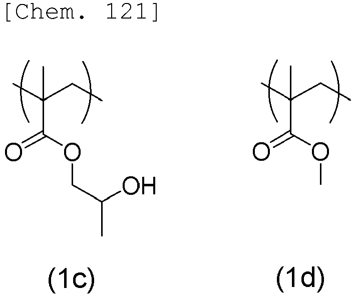

### <Synthesis Example 3>

3.00 g of Denacol Ex622 (manufactured by Nagase ChemteX Corporation), 1.20 g of acrylic acid (manufactured by Tokyo Chemical Industry Co., Ltd.), 0.18 g of tetrabutylphosphonium bromide (manufactured by Tokyo Chemical Industry Co., Ltd.), and 0.03 g of hydroquinone (manufactured by Tokyo Chemical Industry Co., Ltd.) were added to 10.30 g of propylene glycol monomethyl ether in a reaction vessel and dissolved. After replacing the atmosphere in the reaction vessel with nitrogen, the mixture was reacted under heating at 100°C for 48 hours to obtain a solution containing Polymer 3. The polymer solution does not cause cloudiness or the like even when cooled to room temperature, and has good solubility in propylene glycol monomethyl ether. As a result of GPC analysis, the obtained polymer 3 had a weight-average molecular weight of 3,000 in terms of standard polystyrene. The polymer obtained in this Synthesis Example has a structural unit represented by the following Formulae (1e) and (1f).

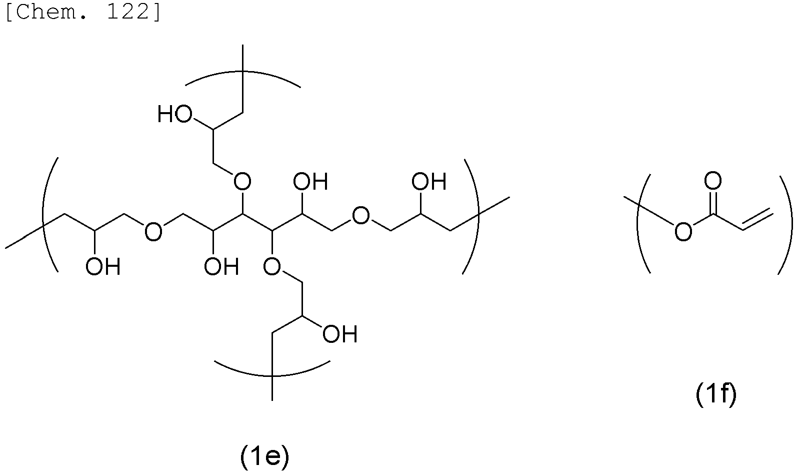

### <Synthesis Example 4>

3.00 g of Denacol Ex622 (manufactured by Nagase ChemteX Corporation), 1.44 g of methacrylic acid (manufactured by Tokyo Chemical Industry Co., Ltd.), 0.18 g of tetrabutylphosphonium bromide (manufactured by Tokyo Chemical Industry Co., Ltd.), and 0.03 g of hydroquinone (manufactured by Tokyo Chemical Industry Co., Ltd.) were added to 10.85 g of propylene glycol monomethyl ether in a reaction vessel and dissolved. After replacing the atmosphere in the reaction vessel with nitrogen, the mixture was reacted under heating at 100°C for 48 hours to obtain a solution containing Polymer 4. The polymer solution does not cause cloudiness or the like even when cooled to room temperature, and has good solubility in propylene glycol monomethyl ether. As a result of GPC analysis, the obtained polymer 4 had a weight-average molecular weight of 3,200 in terms of standard polystyrene. The polymer prepared in this Synthesis Example has a structural unit represented by the following Formulae (1e) and (1g).

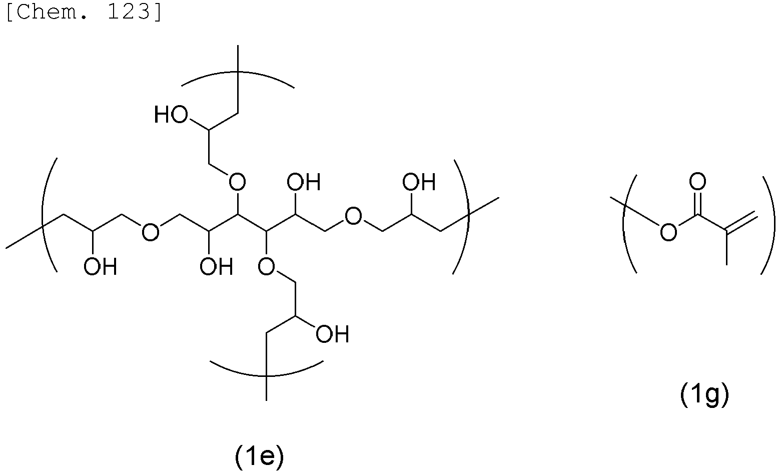

### <Synthesis Example 5>

3.00 g of TEPIC-SS (manufactured by Nissan Chemical Corporation), 2.39 g of acrylic acid (manufactured by Tokyo Chemical Industry Co., Ltd.), 0.35 g of tetrabutylphosphonium bromide (manufactured by Tokyo Chemical Industry Co., Ltd.), and 0.01 g of hydroquinone (manufactured by Tokyo Chemical Industry Co., Ltd.) were added to 8.78 g of propylene glycol monomethyl ether in a reaction vessel and dissolved. After replacing the atmosphere in the reaction vessel with nitrogen, the mixture was reacted under heating at 100°C for 24 hours to obtain a solution containing Polymer 5. The polymer solution does not cause cloudiness or the like even when cooled to room temperature, and has good solubility in propylene glycol monomethyl ether. As a result of GPC analysis, the obtained polymer 5 had a weight-average molecular weight of 730 in terms of standard polystyrene. The polymer prepared in this Synthesis Example has a structural unit represented by the following Formulae (1h) and (1f).

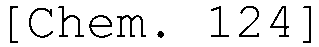

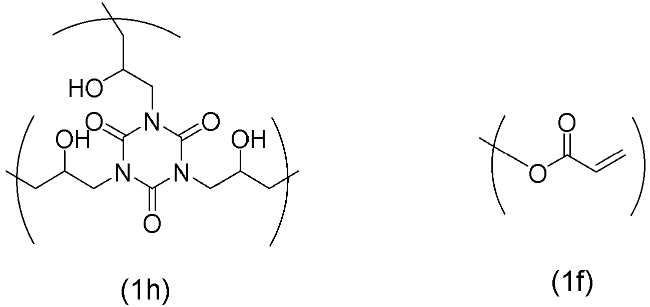

### <Synthesis Example 6>

3.00 g of TEPIC-SS (manufactured by Nissan Chemical Corporation), 2.85 g of methacrylic acid (manufactured by Tokyo Chemical Industry Co., Ltd.), 0.35 g of tetrabutylphosphonium bromide (manufactured by Tokyo Chemical Industry Co., Ltd.), and 0.02 g of hydroquinone (manufactured by Tokyo Chemical Industry Co., Ltd.) were added to 9.47 g of propylene glycol monomethyl ether in a reaction vessel and dissolved. After replacing the atmosphere in the reaction vessel with nitrogen, the mixture was reacted under heating at 100°C for 24 hours to obtain a solution containing Polymer 6. The polymer solution does not cause cloudiness or the like even when cooled to room temperature, and has good solubility in propylene glycol monomethyl ether. As a result of GPC analysis, the obtained polymer 6 had a weight-average molecular weight of 770 in terms of standard polystyrene. The polymer prepared in this Synthesis Example has a structural unit represented by the following Formulae (1h) and (1g).

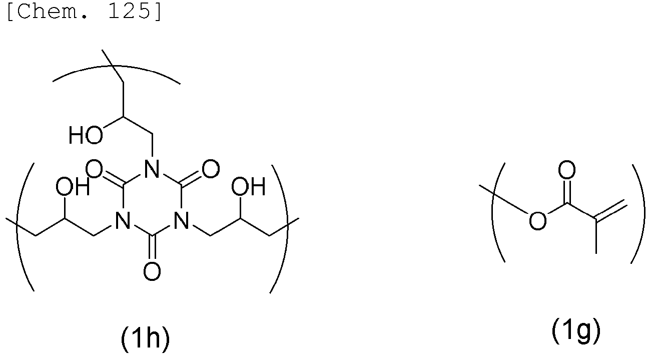

### <Synthesis Example 7>

6.00 g of EPLICON-HP4700 (manufactured by DIC Corporation), 5.50 g of methacrylic acid (manufactured by Tokyo Chemical Industry Co., Ltd.), 0.48 g of tetrabutylphosphonium bromide (manufactured by Tokyo Chemical Industry Co., Ltd.), and 0.02 g of hydroquinone (manufactured by Tokyo Chemical Industry Co., Ltd.) were added to 27.98 g of propylene glycol monomethyl ether acetate in a reaction vessel and dissolved. After replacing the atmosphere in the reaction vessel with nitrogen, the mixture was reacted under heating at 100°C for 24 hours to obtain a solution containing Polymer 7. The polymer solution does not cause cloudiness or the like even when cooled to room temperature, and has good solubility in propylene glycol monomethyl ether acetate. As a result of GPC analysis, the obtained polymer 7 had a weight-average molecular weight of 3,000 in terms of standard polystyrene. The polymer prepared in this Synthesis Example has a structural unit represented by the following Formulae (1i) and (1g).

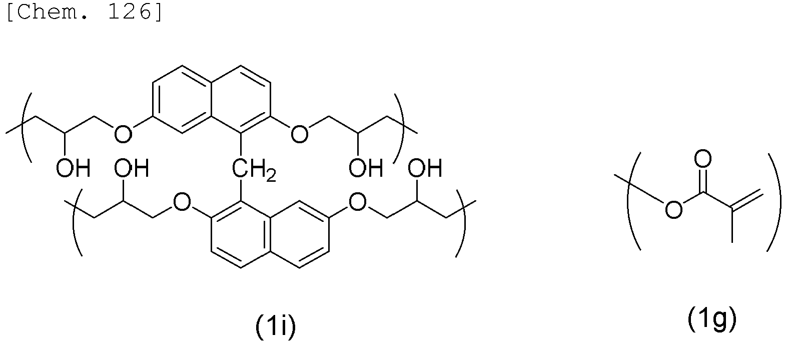

### <Synthesis Example 8>

4.00 g of Karenz BEI (manufactured by Resonac Corporation), 0.51 g of tris(hydroxymethyl)aminomethane (manufactured by Tokyo Chemical Industry Co., Ltd.), 0.17 g of triethylamine (manufactured by Tokyo Chemical Industry Co., Ltd.), and 0.14 g of 4-hydroxy-2,2,6,6-tetramethylpiperidine 1-oxyl free radical (manufactured by Tokyo Chemical Industry Co., Ltd.) were added to 11.25 g of propylene glycol monomethyl ether acetate and dissolved. After replacing the atmosphere in the reaction vessel with nitrogen, the mixture was reacted under heating at 105°C for 18 hours to obtain a solution containing Polymer 8. The polymer solution does not cause cloudiness or the like even when cooled to room temperature, and has good solubility in propylene glycol monomethyl ether acetate. As a result of GPC analysis, the obtained polymer 8 had a weight-average molecular weight of 1,000 in terms of standard polystyrene. The polymer prepared in this Synthesis Example has a structural unit represented by the following Formulae (1j) and (1k).

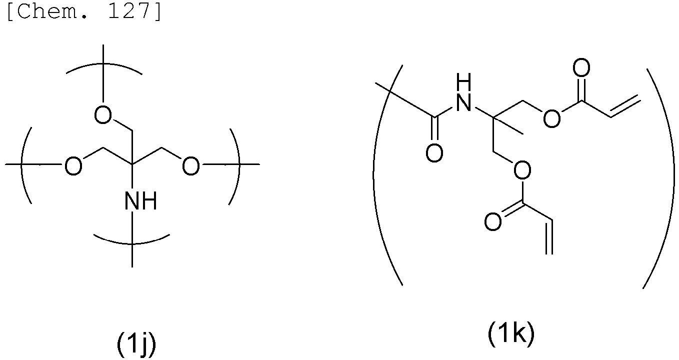

### [Preparation of Resist Underlayer Film-Forming Composition]

### (Examples and Comparative Examples)

The polymer obtained in the above-described Synthesis Examples 1 to 3 and 8, a crosslinking agent, a curing catalyst, and a solvent were mixed in the proportions shown in Table 1, and the mixture was filtered through a fluororesin filter having a pore size of 0.1 µm to prepare resist underlayer film-forming compositions of Example 1 and Comparative Examples 1 and 2, respectively.

Abbreviations in Table 1 are as follows.

### PL-LI: Tetramethoxymethylglycoluril

### PGME-PL: Imidazo[4,5-d]imidazole-2,5(1H,3H)-dione, tetrahydro-1,3,4,6-tetrakis[(2-methoxy-1-methylethoxy)methyl]-(the following structural formula)

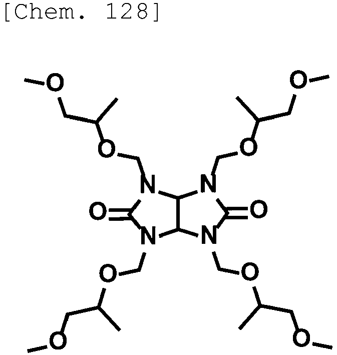

### Py-PSA: Pyridinium p-hydroxybenzenesulfonic acid PGMEA: Propylene glycol monomethyl ether acetate PGME: Propylene glycol monomethyl ether

**[Table 1]**

| | First component | Second component | Crosslinking agent | Curing catalyst | Solvent | |
|---|---|---|---|---|---|---|
| Example 1 | Polymer 2 | Polymer 3 | PGME-PL | Py-PSA | PGME | PGMEA |
| (parts by mass) | 0.127 | 0.025 | 0.035 | 0.003 | 90 | 10 |
| Example 2 | Polymer 2 | Polymer 8 | PGME-PL | Py-PSA | PGME | PGMEA |
| (parts by mass) | 0.127 | 0.025 | 0.035 | 0.003 | 90 | 10 |
| Comparative Example 1 | Polymer 1 | - | PL-LI | Py-PSA | PGME | PGMEA |
| (parts by mass) | 0.149 | | 0.037 | 0.004 | 70 | 30 |
| Comparative Example 2 | Polymer 2 | - | PGME-PL | Py-PSA | PGME | PGMEA |
| (parts by mass) | 0.176 | | 0.037 | 0.004 | 90 | 10 |

### [Elution Test of Photoresist Solvent]

The resist underlayer film-forming compositions of Example 1 and Comparative Examples 1 and 2 were each applied onto silicon wafers as semiconductor substrates with a spinner. The silicon wafer was placed on a hot plate and baked at 205°C for 1 minute to form a resist underlayer film (film thickness: 5 nm). These resist underlayer films were immersed in a mixed solution of propylene glycol monomethyl ether/propylene glycol monomethyl ether acetate = 70/30 (volume ratio), which is a solvent used for the photoresist, and a case where the film thickness change was less than 5 Å was evaluated as "good", and a case where the film thickness change was 5 Å or more was evaluated as "poor", and the results are shown in Table 2.

**[Table 2]**

| | Elution test |
|---|---|
| Example 1 | Good |
| Example 2 | Good |
| Comparative Example 1 | Good |
| Comparative Example 2 | Good |

### [Formation of Negative Resist Pattern by EUV Exposure]

Each of the resist underlayer film-forming compositions of Example 1 and Comparative Examples 1 and 2 was applied onto a silicon wafer using a spinner. The silicon wafer was baked on a hot plate at 205°C for 60 seconds to obtain a resist underlayer film having a film thickness of 5 nm. An EUV resist solution (tin oxide-based resist) was spin-coated onto the resist underlayer film and heated at 130°C for 1 minute to form an EUV resist layer. Thereafter, exposure was performed using an EUV exposure apparatus (NXE3300B, manufactured by ASML) under conditions of NA=0.33, σ=0.67/0.90 (outer/inner), and Dipole. At the time of exposure, exposure was performed through a mask set such that the width between the columnar pattern (hereinafter referred to as a pillar) of the EUV resist and between the pillars was 38 nm (X direction) and 66 nm (Y direction) after the following development.

After the exposure, post-exposure heating (PEB) was performed at 170°C for 1 minute, and the wafer was cooled to room temperature on a cooling plate. Development was then conducted for 60 seconds using an organic solvent (propylene glycol monomethyl ether acetate), followed by a rinsing treatment to form a resist pattern having a CD size of 22 nm.

A scanning electron microscope (CG6100 manufactured by Hitachi High-Technologies Corporation) was used to measure the length of the resist pattern.

The photoresist pattern thus obtained was evaluated by observation from above the pattern. A case where a pillar pattern having a CD size of 22.5 nm was formed was rated as "good", and a case where pattern collapse was observed was rated as "poor". An exposure amount at which a pillar pattern having a CD size of 22 nm is formed is defined as an optimal exposure amount, and an exposure amount (mJ/cm²) at that time is shown in Table 3.

**[Table 3]**

| | Optimal exposure amount (mJ/cm²) | Pillar pattern with CD size of 22.5 nm |
|---|---|---|
| Example 1 | 111 | Good |
| Comparative Example 1 | 113 | Poor |
| Comparative | 115 | Poor |
| Example 2 | | |

As compared with Comparative Examples 1 and 2, in Example 1, the effect of improving the sensitivity and the adhesion in the pillar pattern having a CD size of 22 nm was confirmed. From the present results, it was shown that the resist underlayer film containing a compound having a polymerizable multiple bond can improve sensitivity and adhesion, and has good pattern-forming ability.

## Claims

1. A resist underlayer film-forming composition, comprising a polymer (A), a compound (B) having a polymerizable multiple bond, and a solvent (C).

2. The resist underlayer film-forming composition according to claim 1, wherein the compound (B) is a reaction product of a reactant containing a compound (B-1) having an epoxy group and a compound (B-2) having a polymerizable multiple bond and being reactive with the epoxy group.

3. The resist underlayer film-forming composition according to claim 1, wherein the compound (B) is a reaction product of a reactant containing a compound (B-3) having a hydroxy group and a compound (B-4) having a polymerizable multiple bond and being reactive with the hydroxy group.

4. The resist underlayer film-forming composition according to claim 1, wherein a content of the polymer (A) is greater than a content of the compound (B).

5. The resist underlayer film-forming composition according to claim 1, wherein the solvent (C) contains at least one type selected from a group consisting of an alkylene glycol monoalkyl ether and a monocarboxylic acid ester of an alkylene glycol monoalkyl ether.

6. The resist underlayer film-forming composition according to claim 1, further comprising a crosslinking agent (D).

7. The resist underlayer film-forming composition according to claim 6, wherein the crosslinking agent (D) is at least one type selected from a group consisting of an aminoplast crosslinking agent and a phenoplast crosslinking agent.

8. The resist underlayer film-forming composition according to claim 1, further comprising a curing catalyst (E).

9. The resist underlayer film-forming composition according to claim 1, which is used in EUV lithography.

10. The resist underlayer film-forming composition according to claim 1, which is used for forming an underlayer film of a metal-containing resist.

11. A resist underlayer film, which is a cured product of the resist underlayer film-forming composition according to any one of claims 1 to 10.

12. A laminate, comprising:
a semiconductor substrate; and
the resist underlayer film according to claim 11.

13. A method for producing a semiconductor element, the method comprising:
a step of forming a resist underlayer film on a semiconductor substrate using the resist underlayer film-forming composition according to any one of claims 1 to 10; and
a step of forming a resist film on the resist underlayer film.

14. A pattern forming method, comprising:
a step of forming a resist underlayer film on a semiconductor substrate using the resist underlayer film-forming composition according to any one of claims 1 to 10;
a step of forming a resist film on the resist underlayer film;
a step of irradiating the resist film with light or an electron beam, and then developing the resist film to obtain a resist pattern; and
a step of etching the resist underlayer film using the resist pattern as a mask.
